# EUROPÄISCHE PATENTSCHRIFT

(11) **EP 1 819 717 B1**
(45) Veröffentlichungstag und Bekanntmachung des Hinweises auf die Patenterteilung: **08.07.2009**
(21) Anmeldenummer: 05811689.8
(22) Anmeldetag: 23.11.2005
(51) Int. Cl.: C07F 19/00, C07F 15/00, H05B 33/00

(54) **VERWENDUNG VON ÜBERGANGSMETALL-CARBENKOMPLEXEN IN ORGANISCHEN LICHT-EMITTIERENDEN DIODEN (OLEDS)**
USE OF TRANSITION METAL CARBENE COMPLEXES IN ORGANIC LIGHT-EMITTING DIODES (OLEDS)
UTILISATION DE COMPLEXES METAL DE TRANSITION- CARBENE DANS DES DIODES ELECTROLUMINESCENTES ORGANIQUES (DEL ORGANIQUES)

(30) Priorität: 25.11.2004 DE 102004057072
(43) Veröffentlichungstag der Anmeldung: 22.08.2007
(73) Patentinhaber: BASF SE, 67056 Ludwigshafen (DE)
(72) Erfinder: EGEN, Martina, 69221 Dossenheim (DE); KAHLE, Klaus, 67059 Ludwigshafen (DE); BOLD, Markus, 67246 Dirmstein (DE); GESSNER, Thomas, 69120 Heidelberg (DE); LENNARTZ, Christian, 67105 Schifferstadt (DE); NORD, Simon, 67354 Römerberg (DE); SCHMIDT, Hans-werner, 95444 Bayreuth (DE); THELAKKAT, Mukundan, 95447 Bayreuth (DE); BÄTE, Markus, 95508 Kulmain (DE); NEUBER, Christian, 95445 Bayreuth (DE); KOWALSKY, Wolfgang, 38116 Braunschweig (DE); SCHILDKNECHT, Christian, 38112 Braunschweig (DE); JOHANNES, Hans-Hermann, 38124 Braunschweig (DE)
(86) Internationale Anmeldenummer: PCT/EP2005/012529
(87) Internationale Veröffentlichungsnummer: WO 2006/056418

(56) Entgegenhaltungen:
- WO-A2-20/05019373
- WO-A2-20/05113704
- US-B1- 6 737 531
- JAZZAR, RODOLPHE F. R. ET AL: "C-C and C-H Bond Activation Reactions in N-Heterocyclic Carbene Complexes of Ruthenium" JOURNAL OF THE AMERICAN CHEMICAL SOCIETY , 124(18), 4944-4945 CODEN: JACSAT; ISSN: 0002-7863, 2002, XP002366936
- DANOPOULOS A A ET AL: "C-H activation with N-heterocyclic carbene complexes of iridium and rhodium" JOURNAL OF THE CHEMICAL SOCIETY, DALTON TRANSACTIONS, CHEMICAL SOCIETY. LETCHWORTH, GB, Nr. 16, 2002, Seiten 3090-3091, XP002303856 ISSN: 1472-7773
- DIGGLE, A. R ET AL.: "A theoretical study of the activation of C-C and C-H bonds in Ru-N-Heterocyclic carbene complexes" XXI ST INTERNATIONAL CONFERENCE ON ORGANOMETALLIC CHEMISTRY. BOOK OF ABSTRACTS, 25. Juli 2004 (2004-07-25), - 30. Juli 2004 (2004-07-30) Seite 251, XP002366937

## Beschreibung

Die vorliegende Erfindung betrifft die Verwendung von Übergangsmetall-Carbenkomplexen in organischen Licht-emittlerenden Dioden (OLEDs), eine Licht-emittierende Schicht, Blockschicht für Elektronen oder Excitonen oder Blockschicht für Löcher enthaltend diese Übergangsmetall-Carbenkomplexe, OLEDs enthaltend diese Übergangsmetall-Carbenkomplexe sowie Vorrichtungen, die ein erfindungsgemäßes OLED enthalten.

In organischen Licht-emittierenden Dioden (OLED) wird die Eigenschaft von Materialien ausgenutzt. Ucht zu emittieren, wenn sie durch elektrischen Strom angeregt werden. OLEDs sind insbesondere interessant als Alternative zu Kathodenstrahlröhren und Flüssigkristalldisplays zur Herstellung von Flachbildschirmen. Aufgrund der sehr kompakten Bauweise und des Intrinsisch niedrigeren Stromverbrauchs eignen sich Vorrichtungen, enthaltend OLEDs insbesondere für mobile Anwendungen, zum Beispiel für Anwendungen in Handys, Laptops usw.

Es wurden zahlreiche Materialien vorgeschlagen, die bei der Anregung durch elektrischen Strom Licht emittieren.

WO 02/15645 betrifft OLEDs, die eine Licht-emittierende Schicht aufweisen, die phosphoreszierende Übergangsmetallverbindungen enthält. Die Übergangsmotallverbindungen zeigen Elektrophosphoreszenz, insbesondere im blauen Bereich des sichtbaren elektromagnetischen Spektrums. Die Farbkoordinaten des von den in WO 02/15645 offenbarten Komplexen emittierten Blau sind jedoch verbesserungswürdig.

WO 01/41512 betrifft OLEDs, die eine Licht-emittierende Schicht aufweisen, die ein Molekül der allgemeinen Formel L₂MX enthält, wobei M besonders bevorzugt Iridium ist und L ausgewählt ist aus der Gruppe bestehend aus 2-(1-Naphthyl)benzooxazol, 2-Phenylbenzooxazol, 2-Phenylbenzothiazol, 7,8-Benzochinolin, Cumaren, Thienylpyridin, Phenylpyridin. Benzothienylpyridin, 3-Methoxy-2-phenylpyridin und Tolylpyridin und X ausgewählt ist aus der Gruppe bestehend aus Acetylacetonat, Hexafluoracetylacetonat, Salicyliden, Picolinat und 8-Hydroxychinolinat.

WO 00/70655 betrifft elektrolumineszierende Schichten, die als Licht-emittlerende Substanz eine phosphoreszierende organometallische Iridiumverbindung oder Osmiumverbindung aufweisen. Bevorzugt wird Tris(2-phenylpyridin)iridium als Licht-emittierende Verbindung eingesetzt.

Obwohl bereits Verbindungen bekannt sind, die im blauen, roten und grünen Bereich des elektromagnetischen Spektrums Elektrolumineszenz zeigen, ist die Bereitstellung von effizienteren Verbindungen, die technisch einsetzbar sind, wünschenswert. Unter Elektrolumineszenz ist sowohl Elektrofluoreszenz als auch Elektrophosphoreszenz zu verstehen. Des Weiteren ist die Bereitstellung von weiteren Verbindungen zum Einsatz als Elektronen, Excitonen oder Löcher blockierende Materialien von Interesse.

Aufgabe der vorliegenden Anmeldung ist daher die Bereitstellung einer Verbindungsklasse, die zur Elektrolumineszenz im sichtbaren Bereich des elektromagnetischen Spektrums geeignet ist. Eine weitere Aufgabe der vorliegenden Anmeldung ist die Bereitstellung von Verbindungen zum Einsatz als Elektronen, Excitonen oder Löcher blockierende Materialien.

Diese Aufgaben werden durch die Verwendung von neutralen Übergangsmetallkomplexen der allgemeinen Formel I 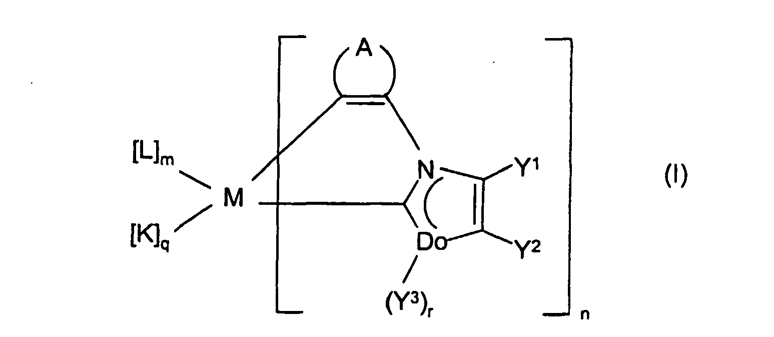 gelöst, worin die Variablen die folgenden Bedeutungen aufweisen:
- M: Metallatom ausgewählt aus der Gruppe bestehend aus Co, Rh, Ir, Nb, Pd, Pt, Fe, Ru, Os, Cr, Mo, W, Mn, Re, Cu, Ag und Au in jeder für das entsprechende Metallatom möglichen Oxidationsstufe;
- L: mono- oder dianionischer Ligand, der mono- oder bidentat sein kann;
- K: neutraler mono- oder bidentater Ligand ausgewählt aus der Gruppe bestehend aus Phosphinen; Phosphonaten und Derivaten davon, Arsenaten und Derivaten davon; Phosphiten; CO; Pyridinen; Nitrilen, Monoolefinen und konjugierten Dienen, die einen π-Komplex mit M bilden;
- n: Zahl der Carbenliganden, wobei n mindestens 1 ist und die Carbenliganden in dem Komplex der Formel I bei n >1 gleich oder verschieden sein können;
- m: Zahl der Liganden L, wobei m 0 oder ≥ 1 sein kann und die Liganden L bei m > 1 gleich oder verschieden sein können;
- q: Zahl der Liganden K, wobei q 0 oder ≥ 1 sein kann und die Liganden K bei q > 1 gleich oder verschieden sein können,
wobei die Summe n + m + q von der Oxidationsstufe und Koordinationszahl des eingesetzten Metallatoms und von der Zähnigkeit sowie der Ladung der Liganden abhängig ist, mit der Bedingung, dass n mindestens 1 ist;
- Do: Donoratom ausgewählt aus der Gruppe bestehend aus N, O und S;
- r: gleich 1, wenn Do N ist, und 0, wenn Do O oder S ist;
- Y¹, Y²: jeweils unabhängig voneinander Wasserstoff, Alkyl, Alkenyl, Alkinyl, Aryl oder Heteroaryl;
oder
Y¹ und Y² bilden zusammen mit den Kohlenstoffatomen, an welche sie gebunden sind, einen sechsgliedrigen aromatischen Ring, welcher ein oder zwei Stickstoffatome enthalten kann, und gegebenenfalls mit einem weiteren, gegebenenfalls anellierten und gegebenenfalls Heteroatome enthaltenden Ring anelliert ist;
- Y³: Wasserstoff oder Alkyl;
oder
Y³ und Y² bilden zusammen mit dem Donoratom Do und dem Kohlenstoffatom, an welches Y² gebunden ist, einen fünf- oder sechsgliedrigen Ring, welcher außer dem Donoratom Do noch ein weiteres Heteroatom ausgewählt aus der Gruppe bestehend aus N, O und S enthalten kann;
- A: eine Brücke mit drei oder vier Atomen, wovon ein oder zwei Atome Heteroatome sein können und die restlichen Atome Kohlenstoffatome sind, so dass die Gruppe 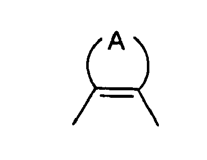 einen fünfgliedrigen heteroaromatischen oder sechsgliedrigen aromatischen oder heteroaromatischen Ring bildet, der gegebenenfalls mit Substituenten ausgewählt aus der Gruppe bestehend aus Alkyl, Alkyloxy, Alkylthio, Aryl, Aryloxy, Arylthio, Halogen, CN, CHO, Alkylcarbonyl, Arylcarbonyl, Carboxyl, Alkyloxycarbonyl, Aryloxycarbonyl, Hydroxysulfonyl, Alkyloxysulfonyl, Aryloxysulfonyl, NO₂ und NO substituiert und gegebenenfalls mit einem weiteren, gegebenenfalls anellierten und gegebenenfalls Heteroatome enthaltenden Ring anelliert ist,
wobei gegebenenfalls Y¹ zusammen mit einer Gruppe ausgewählt aus chemischer Einfachbindung, C(Y⁴)₂, C(O), O, S, S(O), SO₂ und NY⁵ eine zweigliedrige Brücke B zu demjenigen Kohlenstoff- oder Heteroatom der Brücke A ausbildet, welches α-ständig zum Kohlenstoffatom steht, das an das N-Atom der Carbeneinheit des Carbenliganden gebunden ist;
- Y⁴, Y⁵: jeweils unabhängig voneinander Wasserstoff, Alkyl, Aryl oder Heteroaryl, wobei die beiden Y⁴ in der Brücke C(Y⁴)₂ unabhängig voneinander variiert werden können.

Die Übergangsmetallkomplexe der Formel I können in jeder Schicht eines OLEDs eingesetzt werden, wobei das Ligandgerüst oder Zentralmetall zur Anpassung an gewünschte Eigenschaften der Metallkomplexe variiert werden kann. Beispielsweise ist der Einsatz der Übergangsmetallkomplexe der Formel I in einer Blockschicht für Elektronen, einer Blockschicht für Excitonen, einer Blockschicht für Löcher, einer Löchertransportierenden Schicht, einer Elektronen-transportierenden Schicht oder der Licht-emittierenden Schicht des OLEDs möglich. Bevorzugt werden die Verbindungen der Formel I als Emittermoleküle in OLEDs eingesetzt.

Unter einem bidentaten Liganden ist ein Ligand zu verstehen, der an zwei Stellen an das Übergangsmetallatom M koordiniert ist. Im Sinne der vorliegenden Anmeldung wird der Begriff "zweizähnig" synonym mit dem Begriff "bidentat" verwendet. Unter einem monodentaten Liganden ist ein Ligand zu verstehen, der an einer Stelle des Liganden mit dem Übergangsmetallatom M koordiniert.

In Abhängigkeit von der Koordinationszahl des eingesetzten Metalls M und der Natur und Zahl der eingesetzten Liganden L und K sowie der Zahl der Carbenliganden können verschiedene Isomere der entsprechenden Metallkomplexe bei gleichem Metall M und gleicher Natur und Zahl der eingesetzten Liganden K und L sowie der Zahl der Carbenliganden vorliegen. Zum Beispiel sind bei Komplexen mit einem Metall M mit der Koordinationszahl 6 (also oktaedrischen Komplexen), zum Beispiel Ir(III)-Komplexen, sowohl cis/trans-Isomere möglich, wenn es sich um Komplexe der allgemeinen Zusammensetzung MA₂B₄ handelt, als auch fac-mer-Isomere (facial/meri-dional-Isomere), wenn es sich um Komplexe der allgemeinen Zusammensetzung MA₃B₃ handelt. Bei quadratisch planaren Komplexen mit einem Metall M mit der Koordinationszahl 4, zum Beispiel Pt(II)-Komplexen, sind cis/trans-Isomere möglich, wenn es sich um Komplexe der allgemeinen Zusammmensetzung MA₂B₂ handelt. Bei den Variablen A und B handelt es sich jeweils um eine Bindungsstelle eines Liganden, wobei nicht nur monodentate, sondern auch bidentate Liganden vorliegen können. Ein unsymmetrischer bidentater Ligand weist gemäß der vorstehend erwähnten allgemeinen Zusammensetzung eine Gruppe A und eine Gruppe B, ein symmetrischer Ligand zwei Gruppen A oder zwei Gruppen B auf.

Dem Fachmann ist bekannt, was unter cis/trans- bzw. fac-mer-Isomeren zu verstehen ist. Bei oktaedrischen Komplexen bedeutet cis-Isomerie, dass bei Komplexen der Zusammensetzung MA₂B₄ die beiden Gruppen A benachbarte Ecken eines Oktaeders belegen, während die beiden Gruppen A bei der trans-Isomerie einander gegenüber liegende Ecken eines Oktaeders belegen. Bei Komplexen der Zusammensetzung MA₃B₃ können drei Gruppen der gleichen Art entweder die Ecken einer Oktaederfläche besetzen (faciales Isomer) oder einen Meridian, das heißt zwei der drei Ligandenbindungsstellen sind zueinander trans-ständig (meridionales Isomer). Bezüglich der Definition von cis/trans-Isomeren bzw. fac-mer-Isomeren in oktaedrischen Metallkomplexen siehe zum Beispiel J. Huheey, E. Keiter, R. Keiter, Anorganische Chemie: Prinzipien von Struktur und Reaktivität, 2., neu bearbeitete Auflage, übersetzt und erweitert von Ralf Steudel, Berlin; New York: de Gruyter, 1995, Seiten 575, 576.

Bei quadratisch planaren Komplexen bedeutet cis-Isomerie, dass bei Komplexen der Zusammensetzung MA₂B₂ sowohl die beiden Gruppen A als als auch die beiden Gruppen B benachbarte Ecken eines Quadrats belegen, während sowohl die beiden Gruppen A als auch die beiden Gruppen B bei der trans-Isomerie jeweils die beiden einander diagonal gegenüber liegenden Ecken eines Quadrats belegen. Bezüglich der Definition von cis/trans-Isomeren in quadratisch planaren Metallkomplexen siehe zum Beispiel J. Huheey, E. Keiter, R, Keiter, Anorganische Chemie: Prinzipien von Struktur und Reaktivität, 2., neu bearbeitete Auflage, übersetzt und erweitert von Ralf Stendel, Berlin; New York: de Gruyter, 1995, Seiten 557 bis 559.

Desweiteren kann der Carbenligand auch entsprechend der nachfolgend gezeigten Formel 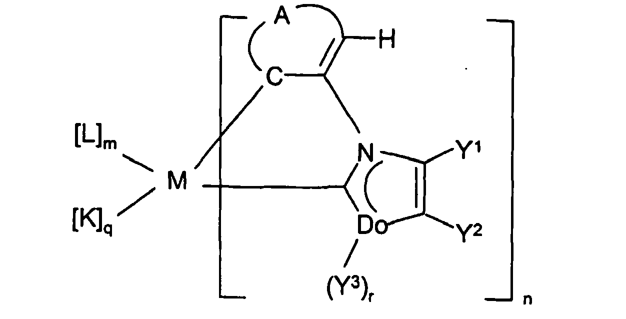 an das Metallzentrum gebunden sein, sofern die Gruppe 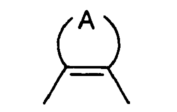 eine zur Cyclometallierung geeignete und zur Doppelbindung benachbarte CH-Bindung enthält. Ferner kann in Komplexen der Formel I für n > 1 ein Carbenligand die zuvor dargestellte und der mindestens eine weitere Carbenligand die in Formel I gezeigte Anbindung an das Metallzentrum M aufweisen.

Im Allgemeinen können die verschiedenen Isomere der Metallkomplexe der Formel I nach dem Fachmann bekannten Verfahren, zum Beispiel durch Chromatographie, Sublimation oder Kristallisation, gereinigt und/oder getrennt werden.

Die vorliegende Erfindung betrifft somit sowohl jeweils einzelne Isomere der Übergangsmetall-Carbenkomplexe der Formel I als auch Gemische verschiedener Isomere in jedem beliebigen Mischungsverhältnis.

Übergangsmetallkomplexe, die Carbenliganden enthalten, sind im Stand der Technik bekannt. So betreffen Gründemann et al., J. Am. Chem. Soc., 2002, 124, 10473 bis 10481 und Danapoulos et al., J. Chem. Soc., Dalton Trans., 2002 3090 bis 3091 Iridumkomplexe, die einen Carbenliganden mit der folgenden Struktureinheit 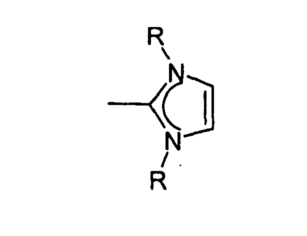 aufweisen. In Hitchcock et al. J. Organomet. Chem., 1982, 239, C 26-C 30 sind Iridium(III)-Komplexe offenbart, die drei monoanionische Carbenliganden aufweisen, und die die folgende Strukturformel besitzen

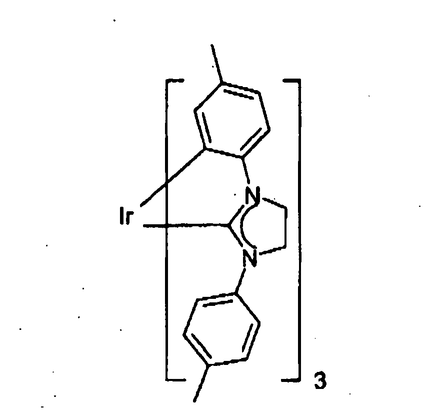

In keinem der genannten Dokumente sind jedoch Lumineszenzeigenschaften, Insbesondere Elektrolumineszenzeigenschaften, der offenbarten Verbindungen bzw. deren Verwendungen in OLEDs offenbart.

In Jazzar et al., J. Am. Chem. Soc. 2002, 124, 4944 - 4945, Yam et al., Chem. Commun. 1989, 2261 bis 2262 und Yarn et al., J. Chem. Soc. Dalton Trans., 2001, 1911 bis 1919 sind Ruthenium-Komplexe offenbart, die einen Carbenliganden aufweisen. Die photophysikalischen Eigenschaften dieser Carbenkomplexe, unter anderem die Photolumineszenz der Komplexe wurde in den letzteren beiden genannten Dokumenten untersucht. Es werden jedoch keine Angaben bezüglich einer Verwendung dieser Komplexe gemacht, noch enthalten die Dokumente Angaben bezüglich der Elektrolumineszenz der untersuchten Verbindungen.

Che et al., Organometallics 1998, 17, 1622 bis 1630 betrifft kationische Re-Komplexe, die einen Carbenliganden mit der folgenden Struktureinheit 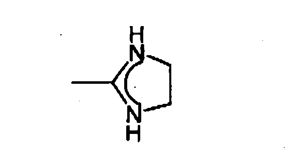 aufweisen.

Diese Komplexe zeigen Photolumineszenz. Eine Verwendung der Re-Komplexe sowie die Untersuchung des Elektrolumineszenzverhaftens der Komplexe ist jedoch nicht offenbart.

US 6,160,267 und US 6,338,977 betreffen eine molekulare Licht-emittierende Diode, die ihre Farbe in Abhängigkeit von sie umgebenden Dämpfen ändert. Diese Elektrode weist eine Sensor-Emitterschicht auf, die einen neutralen Platinkomplex enthält, wobei Platin durch zwei negativ geladene Liganden, ausgewählt aus der Gruppe bestehend aus CN⁻, NO₂⁻, NCO⁻, NCS⁻, Cl⁻, Br⁻, I⁻ und Oxalat, koordiniert ist und die weiteren zwei Liganden ausgewählt sind aus mindestens einer und maximal zwei Arylisonitrilgruppen und einem Fischer-Carben-Komplex, der die Formel =C(Y)-NH-C₆H₄-Alkyl aufweist, worin Y O-Alkyl, NH-Alkyl oder N(Alkyl)₂ ist. Zwingendes Merkmal der in US 6,160,267 und US 6,338,977 offenbarten Pt-Komplexe ist die Anwesenheit mindestens einer Arylisonitrilgruppe.

Die Eignung von Übergangsmetall-Carbenkomplexen der Formel I gemäß der vorliegenden Erfindung in OLEDs, insbesondere als Licht-emittierende Substanzen in OLEDs, wobei die Substanzen dieses Strukturtyps gemäß Formel I zur Elektrolumineszenz im sichtbaren Bereich des elektromagnetischen Spektrums geeignet sind, ist in keinem der vorstehend genannten Dokumente erwähnt.

Es wurde somit gefunden, dass die Übergangsmetallkomplexe der Formel I gemäß der vorliegenden Anmeldung in OLEDs, insbesondere als Licht-emittierende Substanzen in OLEDs zur Herstellung von Displays geeignet sind.

Bevorzugt weisen die erfindungsgemäß verwendeten Übergangsmetall-Carbenkomplexe der allgemeinen Formel I ein Metallatom M ausgewählt aus der Gruppe bestehend aus Rh, Ir, Pd, Pt, Ru und Os auf, wobei Rh(III), Ir(III), Pd(II), Pt(II), Ru(III), Ru(IV) und Os(IV) bevorzugt sind. Besonders bevorzugt eingesetzte Metallatome sind Rh, Ir, Pt und Ru, vorzugsweise als Rh(III), Ir(III), Pt(II), Ru(III) und Ru(IV). Ganz besonders bevorzugt werden als Metallatom M Ir oder Pt eingesetzt, vorzugsweise als Ir(III) oder Pt(II), ganz besonders bevorzugt Ir(III).

Als geeignete mono- oder dianionische Liganden L, bevorzugt monoanionische Liganden L, die mono- oder bidentat sein können, kommen alle üblicherweise als mono- oder bidentate mono- oder dianionische Liganden eingesetzten Liganden in Frage.

Geeignete monoanionische monodentate Liganden sind zum Beispiel Halogenide, insbesondere Cl⁻ und Br⁻, Pseudohalogenide, insbesondere CN⁻, Cyclopentadienyl (Cp⁻), Alkylreste, die mit dem Übergangsmetall M über eine Sigmabindung verknüpft sind, zum Beispiel CH₃, Alkylarylreste, die mit dem Übergangsmetall M über eine Sigmabindung verknüpft sind, zum Beispiel Benzyl.

Geeignete monoanionische bidentate Liganden sind zum Beispiel Acetylacetonat und dessen Derivate, Picolinat, Schiffsche Basen, Aminosäuren und Tetrakis(1-pyrazolyl)-borate sowie die in WO 02/15645 genannten bidentaten monoanionischen Liganden, wobei Acetylacetonat und Picolinat bevorzugt sind.

Geeignete neutrale mono- oder bidentate Liganden sind bereits vorstehend genannt. Bevorzugte neutrale monodentate Liganden sind ausgewählt aus der Gruppe bestehend aus PPh₃, P(OPh)₃, AsPh₃, CO, gegebenenfalls substituierte Pyridine, Nitrilen und deren Derivaten. Geeignete neutrale mono- bzw. bidentate Liganden sind bevorzugt 1,4-Diphenyl-1,3-butadien, 1-Phenyl-1,3-pentadien, 2,4-Hexadien, Cycloocten, η⁴-CyClooctadien und η²-Cyclooctadien (je 1,3 und je 1,5) sowie gegebenenfalls substituierte Phenanthroline.

Vorzugsweise bedeutet in den erfindungsgemäß verwendeten Übergangsmetall-Carbenkomplexen der Formel I n mindestens 2, wobei die Carbenliganden gleich oder verschieden sein können, m und q sind jeweils 0 oder ≥ 1, wobei die Liganden L bzw. K bei m > 1 bzw. q > 1 jeweils gleich oder verschieden sein können. Die Variablen M, L, K, Do, r, Y¹ bis Y⁵ und A besitzen hierbei die bereits zuvor aufgeführte Bedeutung

Vorzugsweise bedeutet weiter in den erfindungsgemäß verwendeten Übergangsmetall-Carbenkomplexen der Formel I n mindestens 2, wobei die Carbenliganden gleich oder verschieden sein können, und m und q sind jeweils 0. Die Variablen M, L, K, Do, r, Y¹ bis Y⁵ und A besitzen auch hier die bereits zuvor aufgeführte Bedeutung.

Desweiteren bedeutet vorzugsweise in den erfindungsgemäß verwendeten Übergangsmetall-Carbenkomplexen der Formel I n mindestens 2, wobei die Carbenliganden gleich und m und q jeweils 0 sind. Die Variablen M, L, K, Do, r, Y¹ bis Y⁵ und A besitzen wiederum die bereits zuvor aufgeführte Bedeutung.

Die Zahl n der Carbenliganden beträgt in neutralen Übergangsmetallkomplexen, worin beispielsweise die Übergangsmetallatome Ir(III), Rh(III) oder Ru(III) eine Koordinationszahl von 6 aufweisen, 1 bis 3, bevorzugt 2 oder 3, besonders bevorzugt 3. Ist n > 1 können die Carbenliganden gleich oder verschieden sein, bevorzugt sind sie gleich.

Sofern keine neutralen Liganden K vorhanden sind beträgt unter Berücksichtigung der Koordinationszahl des Ir(III), Rh(III) bzw. Ru(III) die Zahl m der monoanionischen Liganden L im vorstehend genannten Fall dementsprechend 4, 2 oder 0, bevorzugt 2 oder 0, besonders bevorzugt 0. Ist m > 1 können die Liganden L gleich oder verschieden sein, bevorzugt sind sie gleich.

Die Zahl n der Carbenliganden beträgt in Übergangsmetallkomplexen, worin beispielsweise die Übergangsmetallatome Pt(II) oder Pd(II) eine Koordinationszahl von 4 aufweisen, 1 oder 2, bevorzugt 2. Ist n > 1 können die Carbenliganden gleich oder verschieden sein, bevorzugt sind sie gleich.

Sofern keine neutralen Liganden K vorhanden sind beträgt unter Berücksichtigung der Koordinationszahl des Pt(II) bzw. Pd(II) die Zahl m der monoanionischen Liganden L im vorstehend genannten Fall dementsprechend 2 oder 0, besonders bevorzugt 0. Ist m > 1 können die Liganden L gleich oder verschieden sein, bevorzugt sind sie gleich.

Die Zahl q der neutralen Liganden K ist abhängig davon, ob die Koordinationszahl 6, beispielsweise für Ir(III), Rh(III) oder Ru(III), oder 4, beispielsweise für Pt(II) oder Pd(II), mit Hilfe der Carbenliganden und der Liganden L bereits erreicht wurde. Ist - für den Fall, dass Ir(III), Rh(III) oder Ru(III) eingesetzt werden- n gleich drei, so nimmt q einen Wert von 0 an. Ist - für den Fall, dass Pt(II) oder Pd(II) eingesetzt werden - n gleich zwei, so nimmt q ebenfalls einen Wert von 0 an.

Im Sinne der vorliegenden Anmeldung haben die Begriffe Aryl, Heteroaryl, Alkyl, Alkenyl und Alkinyl die folgenden Bedeutungen:

Unter Aryl ist ein Rest mit einem Grundgerüst von 6 bis 30 Kohlenstoffatomen, bevorzugt 6 bis 18 Kohlenstoffatomen zu verstehen, der aus einem aromatischen Ring oder mehreren kondensierten aromatischen Ringen aufgebaut ist. Geeignete Grundgerüste sind zum Beispiel Phenyl, Naphthyl, Anthracenyl oder Phenanthrenyl. Dieses Grundgerüst kann unsubstituiert sein (d. h., dass alle Kohlenstoffatome, die substituierbar sind, Wasserstoffatome tragen), oder an einer, mehreren oder allen substituierbaren Positionen des Grundgerüsts substituiert sein. Geeignete Substituenten sind zum Beispiel Alkylreste, bevorzugt Alkylreste mit 1 bis 8 Kohlenstoffatomen, besonders bevorzugt Methyl, Ethyl oder i-Propyl, Arylreste, bevorzugt C₆-Arylreste, die wiederum substituiert oder unsubstituiert sein können, Heteroarylreste, bevorzugt Heteroarylreste, die mindestens ein Stickstoffatom enthalten, besonders bevorzugt Pyridylreste, Alkenylreste, bevorzugt Alkenylreste, die eine Doppelbindung tragen, besonders bevorzugt Alkenylreste mit einer Doppelbindung und 1 bis 8 Kohlenstoffatomen, oder Gruppen mit Donor- oder Akzeptorwirkung. Unter Gruppen mit Donorwirkung sind Gruppen zu verstehen, die einen +I- und/oder +M-Effekt aufweisen, und unter Gruppen mit Akzeptorwirkung sind Gruppen zu verstehen, die einen -I- und/oder -M-Effekt aufweisen. Geeignete Gruppen, mit Donor- oder Akzeptorwirkung sind Halogenreste, bevorzugt F, Cl, Br, besonders bevorzugt F, Alkoxyreste, Aryloxyreste, Carbonylreste, Esterreste, Aminreste, wie z.B. Alkyl-, Dialkyl-, Aryl-, Diarylaminreste oder auch Diarylaminreste mit verbrückten Arylresten, wie 1-Carbazolyl, Amidreste, CH₂F-Gruppen, CHF₂-Gruppen, CF₃-Gruppen, CN-Gruppen, Thiogruppen oder SCN-Gruppen. Sofern die Arylreste substituiert sind tragen sie ganz besonders bevorzugt Substituenten ausgewählt aus der Gruppe bestehend aus Methyl, F, Cl, Aryloxy und Alkoxy. Bevorzugt ist Aryl ein C₆-C₁₈-Arylrest, besonders bevorzugt ein C₆-Arylrest, der gegebenenfalls mit mindestens einem der vorstehend genannten Substituenten substituiert ist. Besonders bevorzugt weist der C₆-C₁₈-Arylrest, bevorzugt C₆-Arylrest, keinen, einen oder zwei der vorstehend genannten Substituenten auf, wobei im Falle eines Substituenten dieser in ortho-, meta- oder para-Position zur weiteren Verknüpfungsstelle des Arylrestes angeordnet ist; im Falle von zwei Substituenten können diese jeweils in meta-Position oder ortho-Position zur weiteren Verknüpfungsstelle des Arylrestes angeordnet sein oder ein Rest ist in ortho-Position und ein Rest in meta-Position angeordnet oder ein Rest ist in ortho- oder meta-Position angeordnet und der weitere Rest ist in para-Position angeordnet.

Unter Heteroaryl sind Reste zu verstehen, die sich vom vorstehend genannten Aryl dadurch unterscheiden, dass im Aryl-Grundgerüst mindestens ein Kohlenstoffatom durch ein Heteroatom ersetzt ist. Bevorzugte Heteroatome sind N, O und S. Ganz besonders bevorzugt sind ein oder zwei Kohlenstoffatome des Aryl-Grundgerüsts durch Heteroatome ersetzt. Insbesondere bevorzugt ist das Grundgerüst ausgewählt aus Systemen wie Pyridin und fünfgliedrigen Heteroaromaten wie Pyrrol oder Furan. Das Grundgerüst kann an einer, mehreren oder allen substituierbaren Positionen des Grundgerüsts substituiert sein. Geeignete Substituenten sind dieselben, die bereits unter der Definition von Aryl genannt wurden.

Unter Alkyl ist ein Rest mit 1 bis 20 Kohlenstoffatomen, bevorzugt 1 bis 10 Kohlenstoffatomen, besonders bevorzugt 1 bis 8 Kohlenstoffatomen zu verstehen. Das Alkyl kann verzweigt oder unverzweigt sein und gegebenenfalls mit einem oder mehreren Heteroatomen, bevorzugt Si, N, O oder S, besonders bevorzugt N, O oder S, unterbrochen sein. Des Weiteren kann das Alkyl mit einem oder mehreren der unter der Definition von Aryl genannten Substituenten substituiert sein. Es ist ebenfalls möglich, dass das Alkyl eine oder mehrere Arylgruppen trägt. Dabei sind alle der vorstehend aufgeführten Arylgruppen geeignet. Besonders bevorzugt ist Alkyl ausgewählt aus der Gruppe bestehend aus Methyl, Ethyl, n-Propyl, iso-Propyl und tert.-Butyl.

Unter Alkenyl ist ein Rest zu verstehen, der dem vorstehend genannten Alkyl mit mindestens zwei Kohlenstoffatomen entspricht, mit dem Unterschied, dass mindestens eine C-C-Einfachbindung des Alkyls, sofern möglich, durch eine C-C-Doppelbindung ersetzt ist. Bevorzugt weist das Alkenyl eine oder zwei Doppelbindungen auf.

Unter Alkinyl ist dementsprechend ein Rest zu verstehen, der dem vorstehend genannten Alkyl mit mindestens zwei Kohlenstoffatomen entspricht, mit dem Unterschied, dass mindestens eine C-C-Einfachbindung des Alkyls, sofern möglich, durch eine C-C-Dreifachbindung ersetzt ist. Bevorzugt weist das Alkinyl eine oder zwei Dreifachbindungen auf.

Die Variablen Y¹ und Y² bedeuten jeweils unabhängig voneinander Wasserstoff, Alkyl, Aryl, Heteroaryl oder Alkenyl.

Y¹ ist vorzugsweise Wasserstoff. Y² ist vorzugsweise Wasserstoff oder Alkyl, besonders bevorzugt Wasserstoff, Methyl, Ethyl, n-Propyl, iso-Propyl oder ter.-Butyl.

Im Rahmen einer weiteren Bevorzugung bilden Y¹ und Y² zusammen mit den Kohlenstoffatomen, an welche sie gebunden sind, einen sechsgliedrigen aromatischen Ring, welcher ein oder zwei Stickstoffatome enthalten kann. Dieser kann mit einem weiteren, gegebenenfalls anellierten und gegebenenfalls Heteroatome enthaltenden Ring anelliert sein. Hierbei können die Heteroatome Teil des Ringes oder an den Ring angebunden sein ("exoständig").

Nachfolgend sind beispielhaft entsprechende anellierte Substrukturen der Carbenligenden gezeigt: 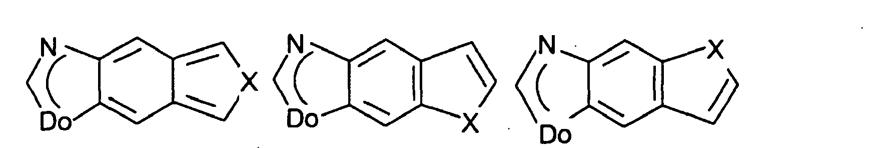 X = CR₂, C(O), O, S, NR; R = Wasserstoff, Alkyl, Aryl

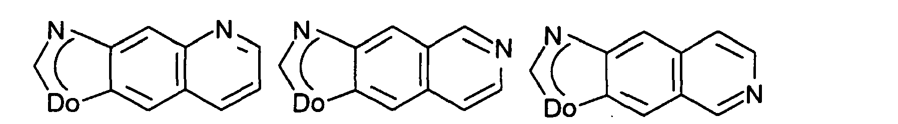

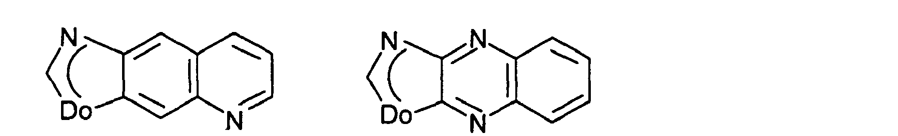

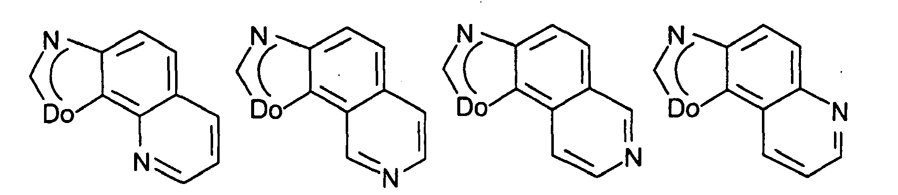

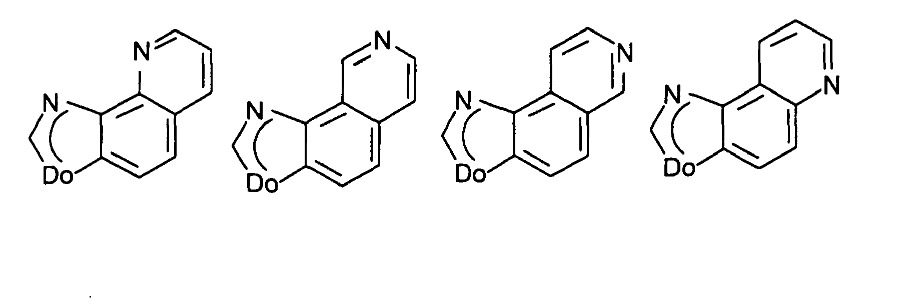

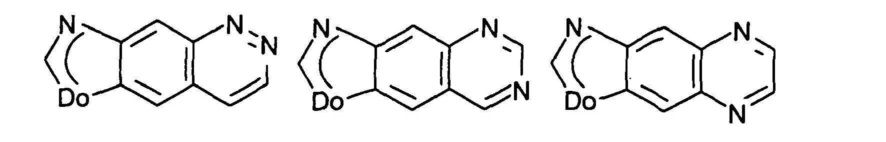

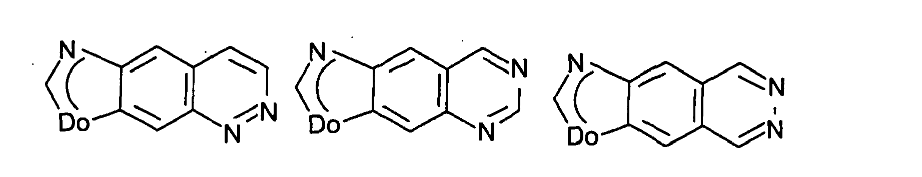

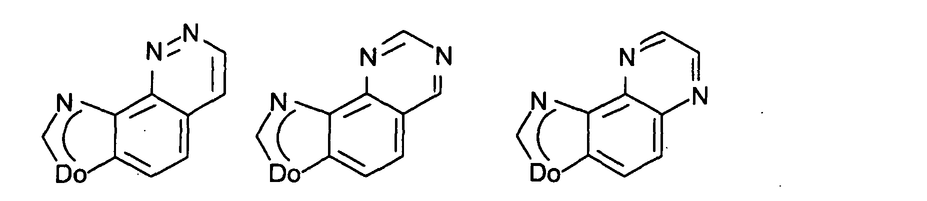

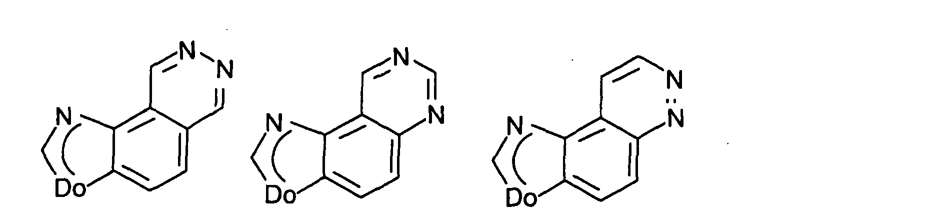

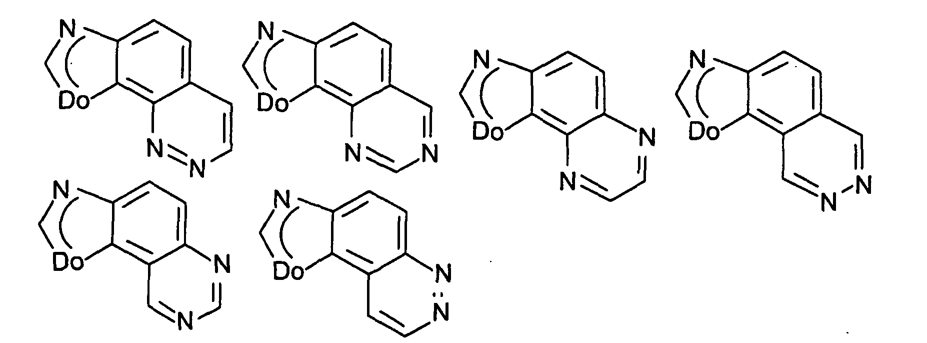

Darüberhinaus sind auch noch höher anellierte Substrukturen, welche sich von den zuvor gezeigten Substrukturen z.B. durch Benzanellierung ableiten, möglich.

Weitere Beispiele für höher anellierte Substrukturen der Carbenliganden sind auch: 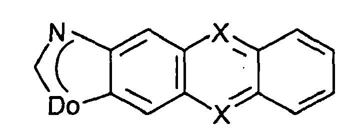 X = CH, N 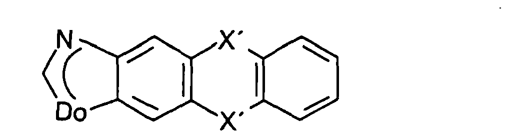 X' = CR₂, C(O), O, S, NR
(R = Wasserstoff, Alkyl, Aryl)

Bevorzugte Substrukturen für die Carbenliganden sind: 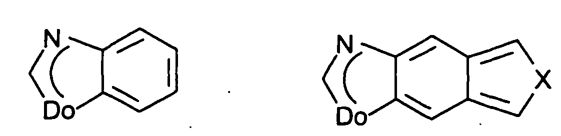 X = O, S 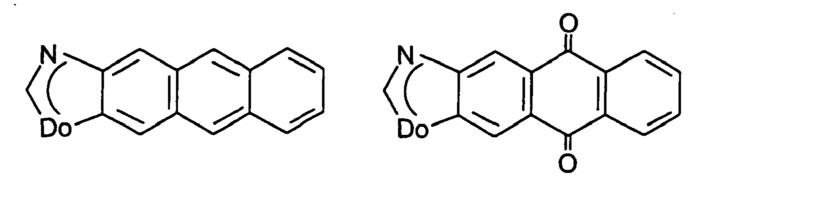 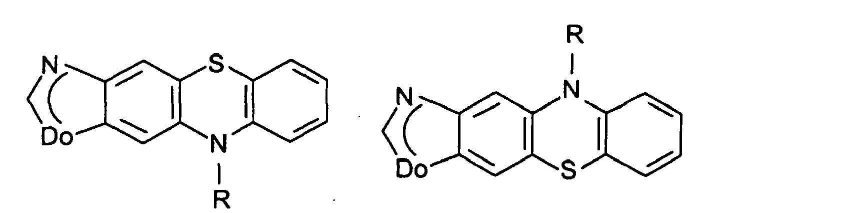 R = Wasserstoff, Alkyl, Aryl

Desweiteren können Y³ und Y² zusammen mit dem Donoratom Do und dem Kohlenstoffatom, an welches Y² gebunden ist, einen fünf- oder sechsgliedrigen Ring bilden, welcher außer dem Donoratom Do noch ein weiteres Heteroatom ausgewählt aus der Gruppe bestehend aus N, O und S enthalten kann. Hierbei kann Y² (zusammen mit Y¹) bereits Bestandteil eines gegebenenfalls (höher) anellierten aromatischen Ringes sein, wie etwa in den zuvor aufgeführten Substrukturen der Carbenliganden, oder Y² ist ein (formal) eigenständiger Rest, welcher mit Y³ eine weitere Substruktur der Carbenliganden bildet.

Da für den vorgenannten Fall (formal) das Vorhandensein des Restes Y³ zwingend ist, kommt als Donoratom nur ein Stickstoffatom in Frage. Beispiele für entsprechende Substrukturen in den Carbenliganden sind: 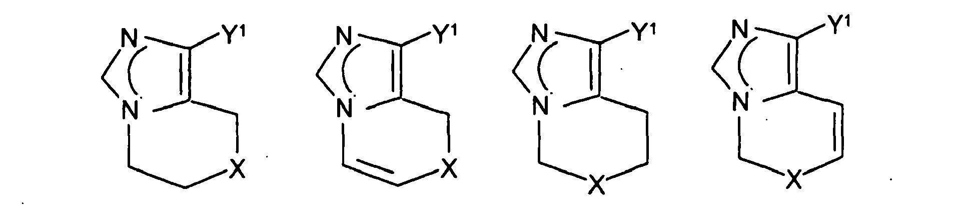 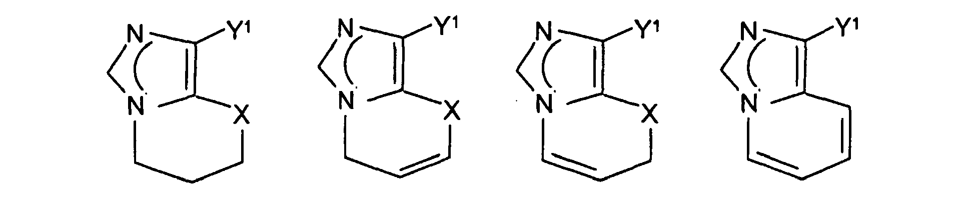 X = CR₂, O, S, NR (R = Wasserstoff, Alkyl, Aryl)

Bevorzugte Substrukturen sind hierbei: 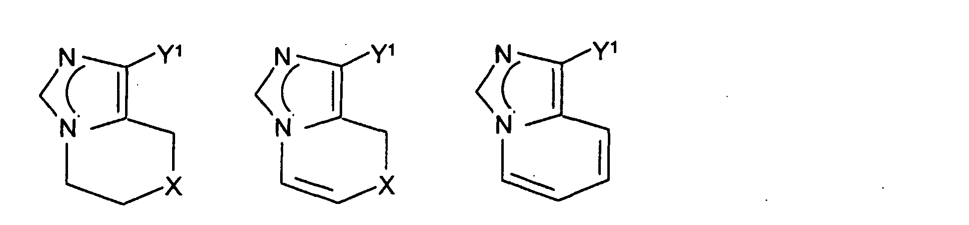 worin X eine CH₂-Gruppe oder ein Sauerstoffatom bedeutet.

Bilden Y¹ und Y² zusätzlich noch -wie zuvor ausgeführt- einen gegebenenfalls höher anellierten aromatischen Ring, so ergeben sich beispielsweise nachfolgend gezeigte Substrukturen der Carbenliganden: 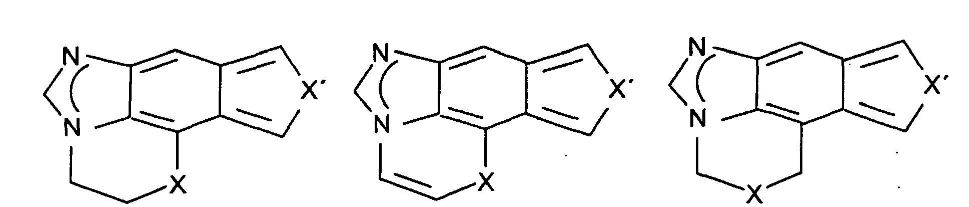 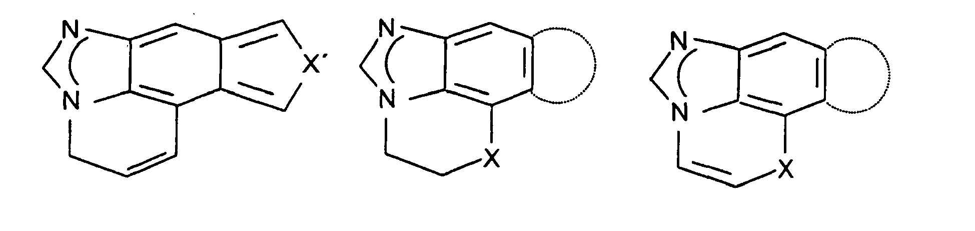 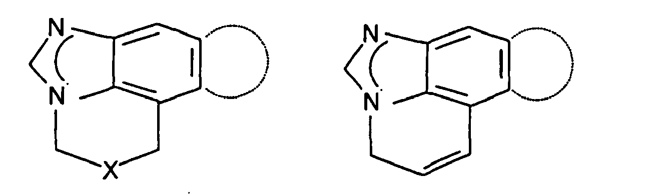 X' = O, S
X = CR₂, O, S, NR (R = Wasserstoff, Alkyl, Aryl)
wobei das Symbol 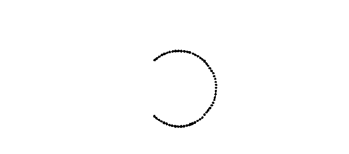 für eine mögliche Anellierung des Benzolringes -wie zuvor aufgeführt- steht. Bevorzugt kommt diesem Symbol die Bedeutung der Fragmente 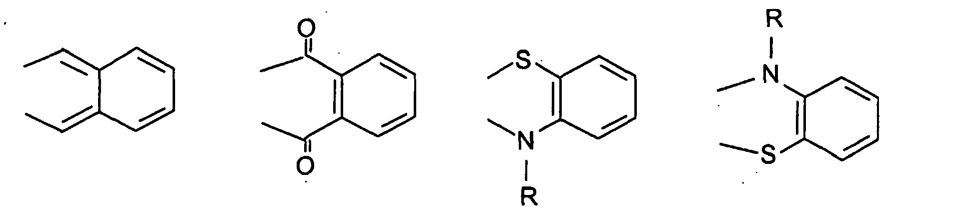 R = Wasserstoff, Alkyl, Aryl
zu.

Bevorzugte Substrukturen sind hierbei: 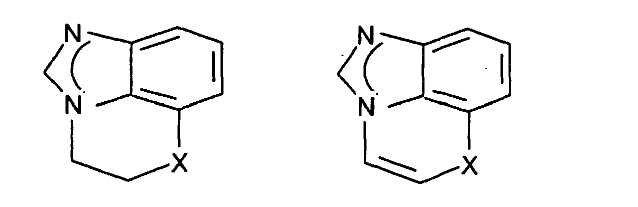 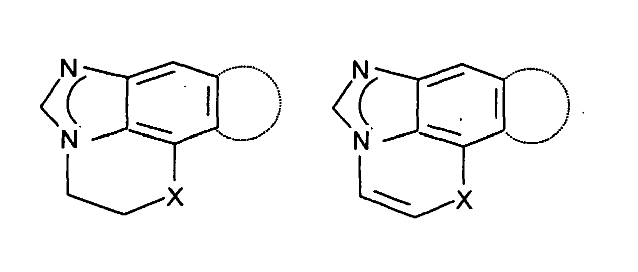 wobei das Symbol 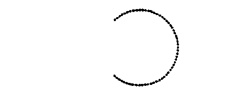 vorzugsweise die zuvor beschriebene Bedeutung besitzt und X für eine CH₂-Gruppe oder ein Sauerstoffatom steht.

Die Variable A in Formel I bedeutet eine Brücke mit drei oder vier Atomen, wovon ein oder zwei Atome Heteroatome sein können und die restlichen Atome Kohlenstoffatome sind, so dass die Gruppe (im Folgenden auch als "G" bezeichnet) 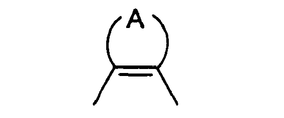 einen fünf- oder sechsgliedrigen heteroaromatischen Ring oder einen Benzolring bildet. Als Heteroatome kommen hierbei insbesondere O, N und S in Betracht.

Nachfolgend sind geeignete fünfgliedrige heteroaromatische Ringe in der Bedeutung der Gruppe G aufgeführt: 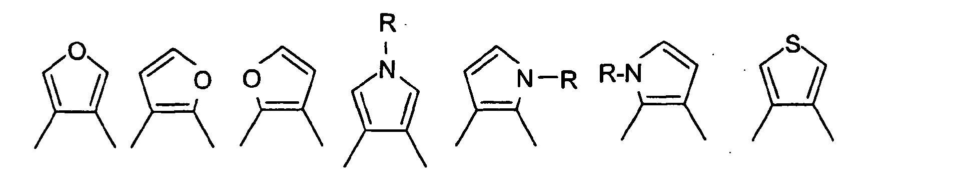 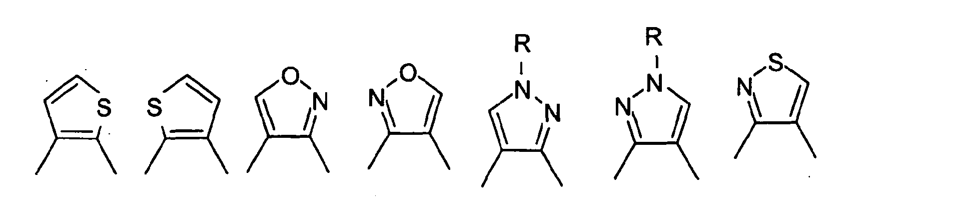 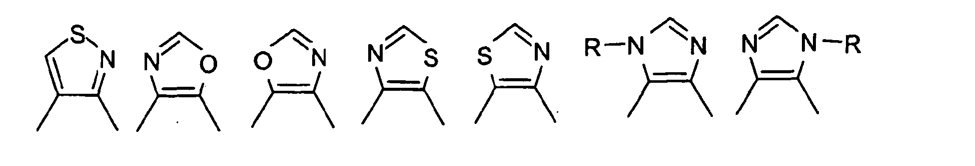 wobei R Wasserstoff, Alkyl, Alkenyl, Alkinyl, Aryl oder Heteroaryl -wie zuvor definiertbezeichnet, wobei die Bindung des Ringstickstoffatoms für R gleich Heteroaryl über ein Kohlenstoffatom oder gegebenenfalls über ein hierzu geeignetes Heteroatom des Heteroaryls erfolgt.

Geeignete sechsgliedrige heteroaromatische Ringe in der Bedeutung der Gruppe G sind:

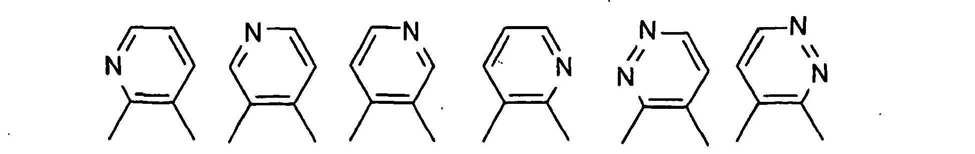

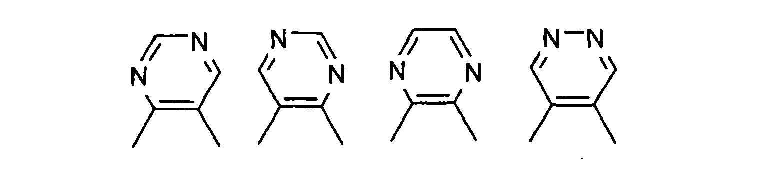

Vorzugsweise kommen für die Gruppe G in Betracht:

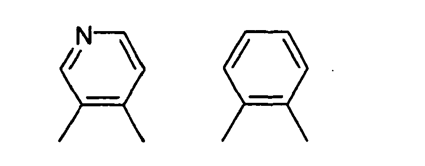

Die Gruppe G kann mit Substituenten ausgewählt aus der Gruppe bestehend aus Alkyl, Alkyloxy, Alkylthio, Aryl, Aryloxy, Arylthio, Halogen, CN, CHO, Alkylcarbonyl, Arylcarbonyl, Carboxyl, Alkyloxycarbonyl, Aryloxycarbonyl, Hydroxysulfonyl, Alkyloxysulfonyl, Aryloxysulfonyl, NO₂ und NO substituiert sein. Sofern die genannten Substituenten Heteroatome enthalten, erfolgt deren Anbindung an die Gruppe G üblicherweise über Kohlenstoffatome der Gruppe G. Die Anbindung kann jedoch auch über geeignete Heteroatome der Gruppe G stattfinden.

Bevorzugte substituierte Gruppen G sind: 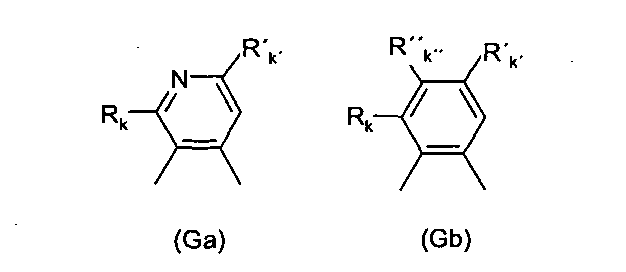 worin R'' für CN, CHO, Alkylcarbonyl, Arylcarbonyl, Carboxyl, Alkyloxycarbonyl, Aryloxycarbonyl, Hydroxysulfonyl, Alkyloxysulfonyl, Aryloxysulfonyl, NO₂ oder NO steht, k" Werte von 0 oder 1 annimmt, R und R' jeweils unabhängig voneinander Alkyl oder Halogen, insbesondere Fluor, bezeichnen und k und k' Werte von 0 oder 1 annehmen, mit der Maßgabe, dass in Gruppe (Ga) die Summe aus k und k' 1 oder 2 beträgt und in Gruppe (Gb) die Summe aus k und k' 1 oder 2 beträgt, wenn k" einen Wert von 0 annimmt, und die Summe aus k und k'' 0, 1 oder 2 beträgt, wenn k'' einen Wert von 1 annimmt. Für den Fall, dass k" einen Wert von 0 annimmt beträgt die Summe aus k und k' vorzugsweise 2; für den Fall, dass k" einen Wert von 1 annimmt, beträgt die Summe aus k und k'' vorzugsweise 0 oder 2. Einem Wert von 0 für k, k' oder k" kommt hierbei die Bedeutung zu, dass sich an der entsprechenden Position des Ringes keiner der genannten Substituenten R, R'oder R" und damit ein Wasserstoffatom befindet. Nehmen k und k' jeweils einen Wert von 1 an, so sind die Substituenten vorzugsweise gleich.

Für R und R' kommen als Alkyl insbesondere Methyl, Ethyl, n-Propyl, iso-Propyl und tert.-Butyl in Betracht. Als Alkyl bzw. Aryl, welches in den entsprechenden Resten der Definition von R" enthalten ist, kommen insbesondere Methyl, Ethyl, n-Propyl, iso-Propyl und tert.-Butyl bzw. Phenyl, Naphthyl, Anthracenyl oder Phenanthrenyl, welche jeweils mit Substituenten ausgewählt aus der Gruppe bestehend aus Methyl, F, Cl, Phenoxy, Methoxy, Ethoxy, n-Propoxy, iso-Propoxy und tert.-Butoxy substituiert sein können, in Betracht, wobei gegebenenfalls substituiertes Phenyl bevorzugt ist.

Insbesondere sind als solche substituierten Gruppen zu nennen:

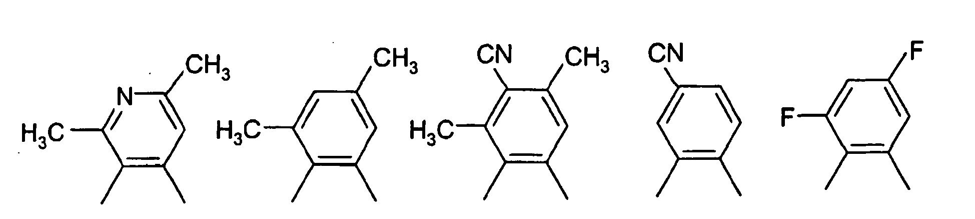

Desweiteren kann die Gruppe G auch mit einem weiteren, gegebenenfalls Heteroatome enthaltenden Ring anelliert sein, wobei letzterer Ring selbst wieder anelliert sein kann.

Beispiele für solche höher anellierten Gruppen G sind: 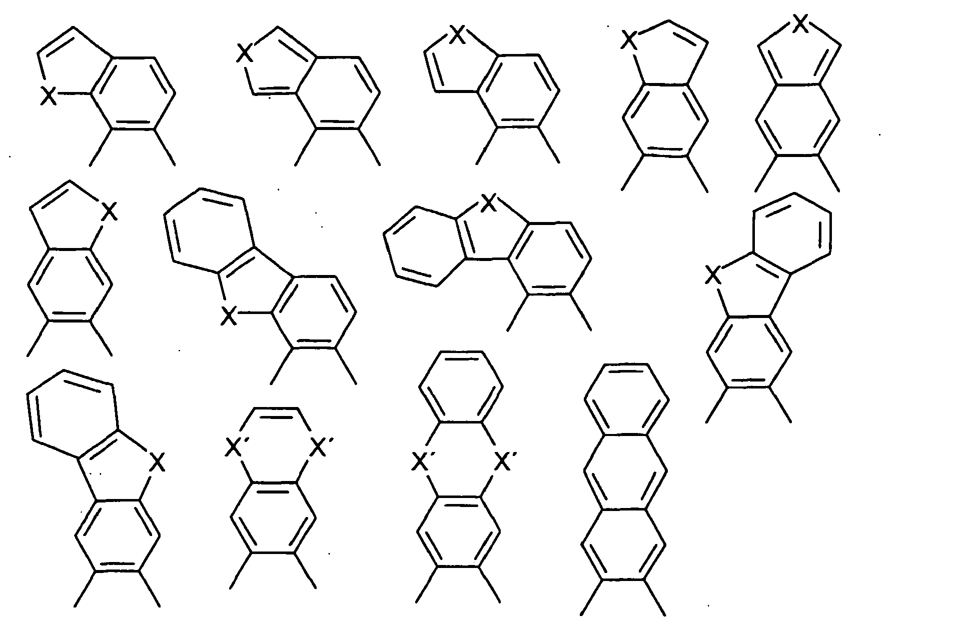 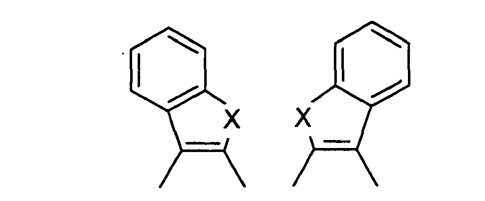 worin X O, S oder NR, mit R gleich Wasserstoff, Alkyl oder Aryl, und die beiden X' unabhängig voneinander eine Carbonylgruppe, CR₂-Gruppe, O, S oder NR, mit R gleich Wasserstoff, Alkyl oder Aryl, bedeuten.

Bevorzugte anellierte Gruppen G sind: 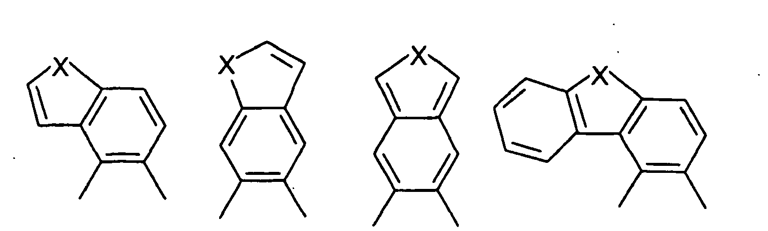 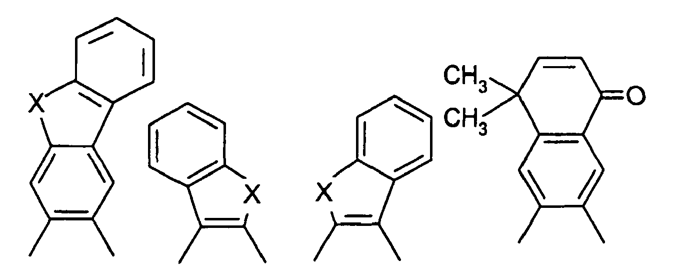 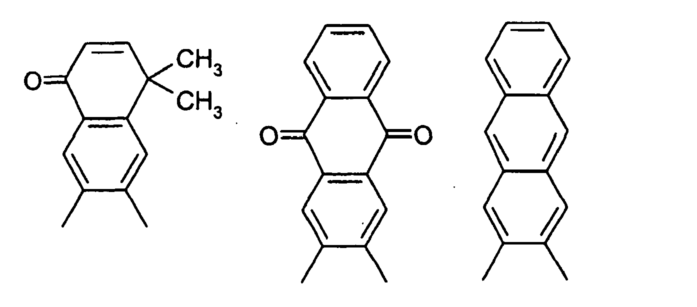 worin X die Bedeutung O, S oder NR, mit R gleich Wasserstoff, Alkyl oder Aryl, bevorzugt Wasserstoff oder Alkyl, zukommt.

Desweiteren kann Y¹ zusammen mit einer Gruppe ausgewählt aus chemischer Einfachbindung, C(Y⁴)₂, C(O), O, S, S(O), SO₂ und NY⁵ eine zweigliedrige Brücke B zu demjenigen Kohlenstoff- oder Heteroatom der Brücke A ausbilden, welches α-ständig zum Kohlenstoffatom steht, das an das N-Atom der Carbeneinheit des Carbenliganden gebunden ist. Y⁴ und Y⁵ bedeuten jeweils unabhängig voneinander Alkyl, Aryl oder Heteroaryl, wie bereits weiter oben definiert, oder Wasserstoff. Die beiden Y⁴ in der Brücke C(Y⁴)₂ können hierbei unabhängig voneinander variiert werden, vorzugsweise sind sie jedoch gleich. Besonders bevorzugt handelt es sich bei den beiden Resten R⁴ um zwei Wasserstoffatome oder zwei Methylgruppen.

Formal lassen sich solche Substrukturen darstellen als: 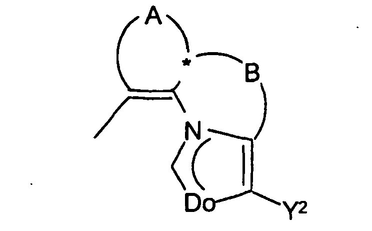 wobei der Stern das zum N-gebundenen vinylischen Kohlenstoffatom α-ständige Kohlenstoff- oder geeignete Heteroatom der Brücke A und B die aus Y¹ und chemischer Einfachbindung, C(Y⁴)₂, C(O), O, S, S(O), SO₂ oder NY⁵ zusammengesetzte Brücke bezeichnet.
Beispiele für solche Substrukturen sind:

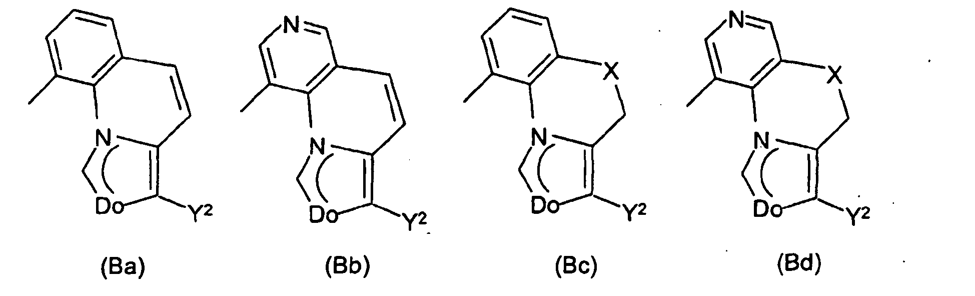

In den Formeln (Ba) und (Bb) besteht die Brücke B jeweils aus einer Ethylen-diyl-Einheit, in den Formeln (Bc) und (Bd) jeweils aus einer Einheit -CH₂-X-, in welcher X die Bedeutung C(Y⁴)₂, C(O), O, S, S(O), SO₂ oder NY⁵ zukommt.

Bilden Y¹ und Y² zusätzlich einen gegebenenfalls anellierten aromatischen Ring, z.B. einen Benzolring, so ergeben sich etwa die nachfolgend gezeigten Substrukturen: 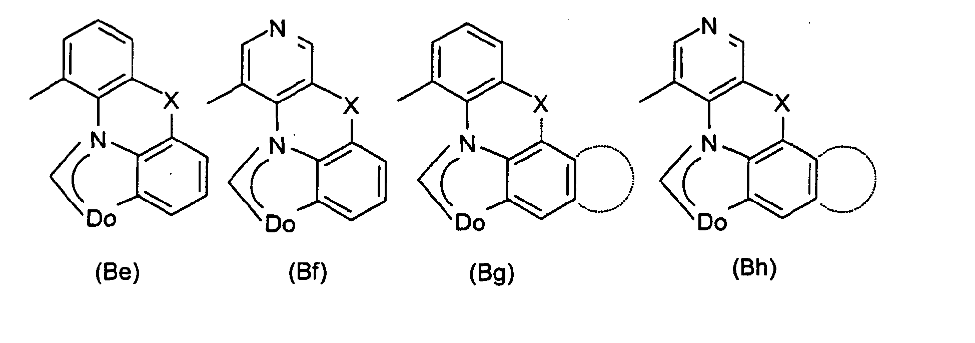 wobei die Brücke B teilweise Bestandteil des Bezolringes ist. X steht wiederum für eine chemische Einfachbindung, C(Y⁴)₂, C(O), O, S, S(O), SO₂ oder NY⁵, das Symbol 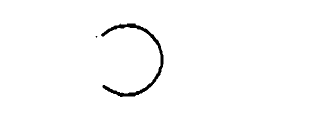 wie auch bereits zuvor, für eine Anellierung des Benzolringes.

Bevorzugt kommt diesem Symbol auch hier die Bedeutung der Fragmente 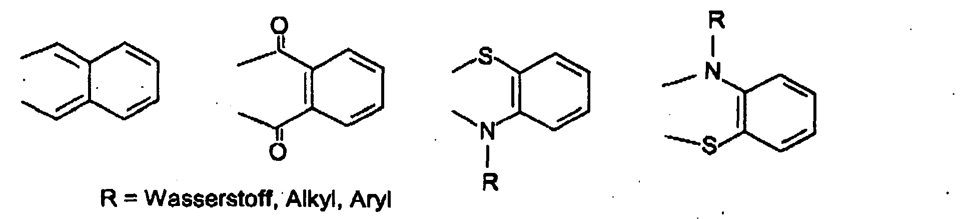 zu.

Bevorzugte Substrukturen sind: 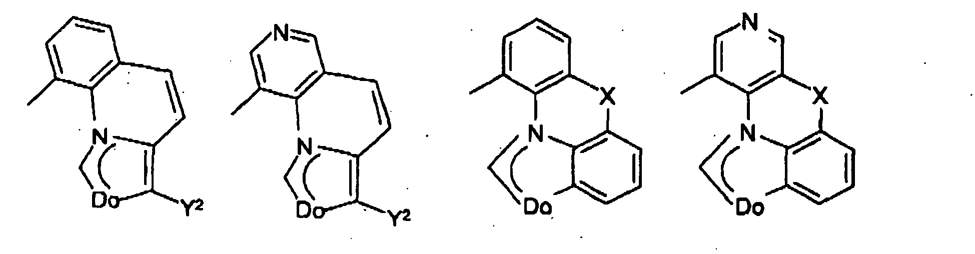 worin X insbesondere für O, S, eine C(CH₃)₂- oder SO₂-Gruppe steht

Bevorzugte Komplexe der Formel I enthalten einen oder mehrere Carbenliganden, welche durch Kombination von Substrukturen ausgewählt aus der Gruppe 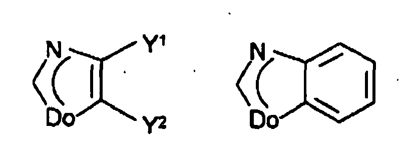 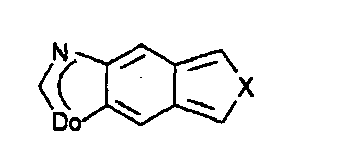 Y¹, Y² = Wasserstoff, Alkyl
X = O, S 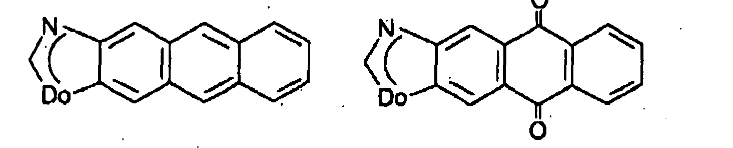 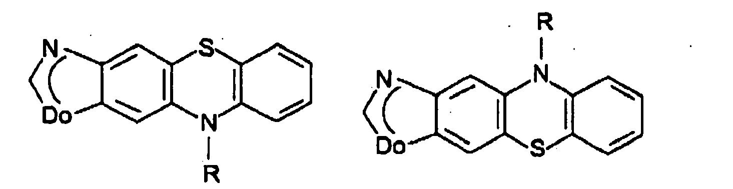 R = Wasserstoff, Alkyl, Aryl
und ausgewählt aus der Gruppe 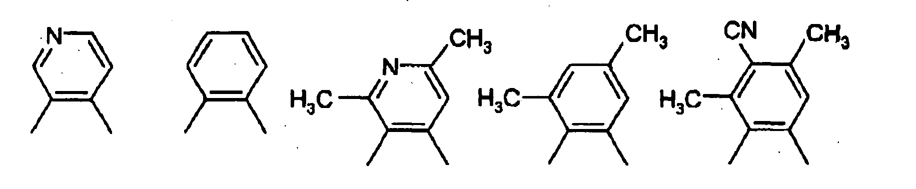 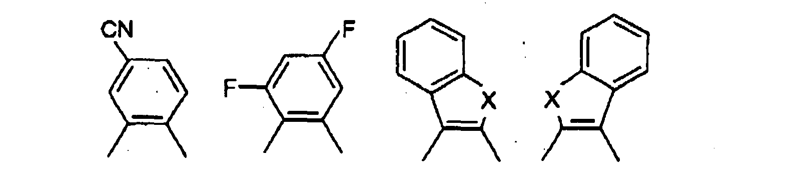 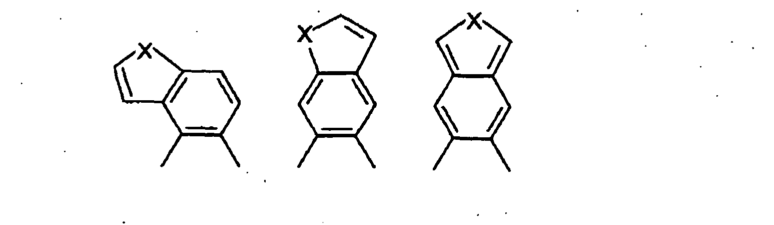 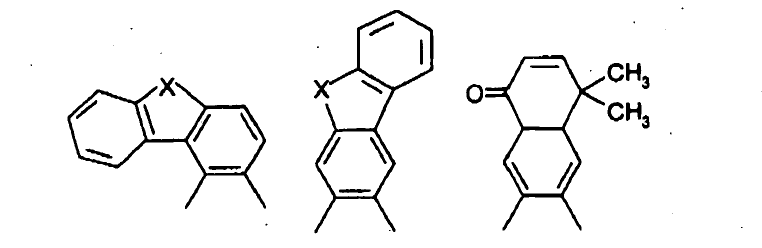 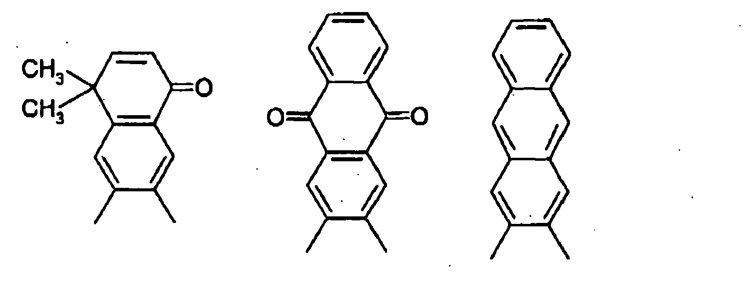 X = O, S, NR; R = Wasserstoff oder Alkyl
erhalten werden, wobei das Donoratom Do bevorzugt S oder N-Y³ und Y³ bevorzugt Methyl, Ethyl, n-Propyl, iso-Propyl oder tert.-Butyl bedeutet.

Besonders bevorzugte Komplexe der Formel I enthalten einen oder mehrere Carbenliganden, welche durch Kombination von Substrukturen ausgewählt aus der Gruppe 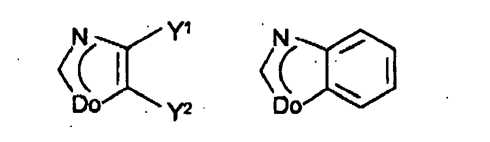 Y¹, Y² = Wasserstoff, Alkyl
und ausgewählt aus der Gruppe 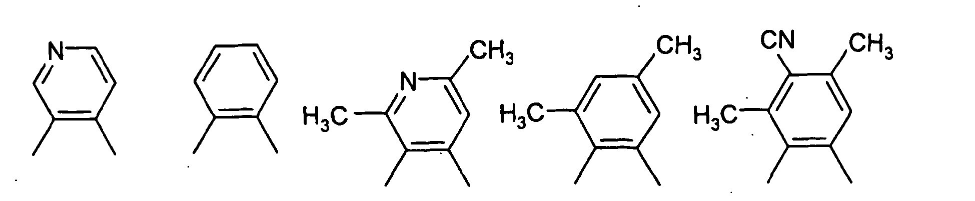 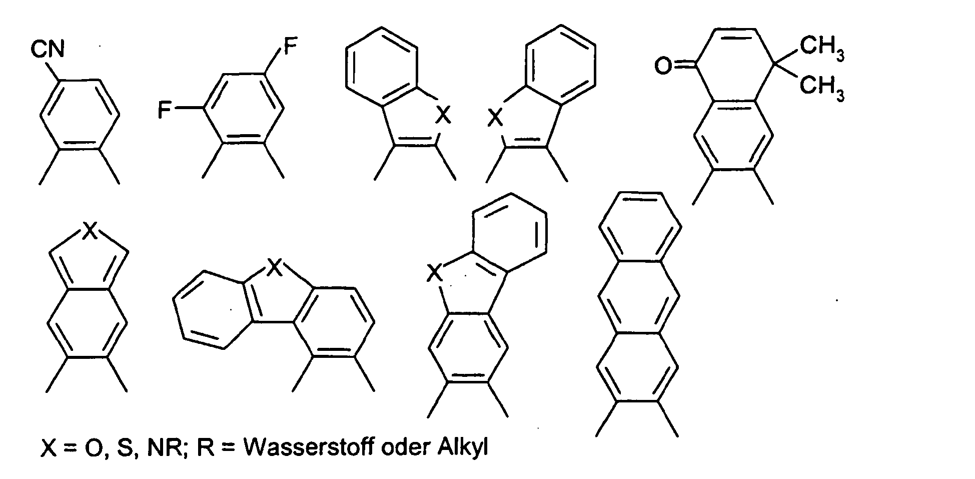 erhalten werden, wobei das Donoratom Do bevorzugt S oder N-Y³ und Y³ bevorzugt Methyl, Ethyl, n-Propyl, iso-Propyl oder tert.-Butyl bedeutet.

Insbesondere sind zu dieser Kombination die folgenden Komplexe zu nennen, welche nur Carbenliganden besitzen: 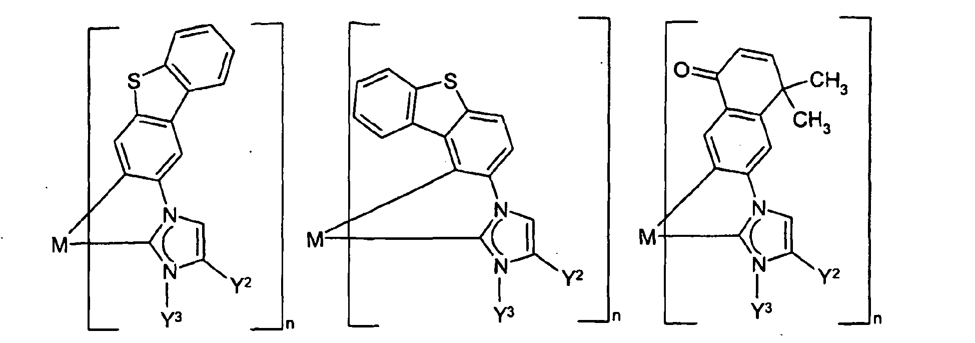 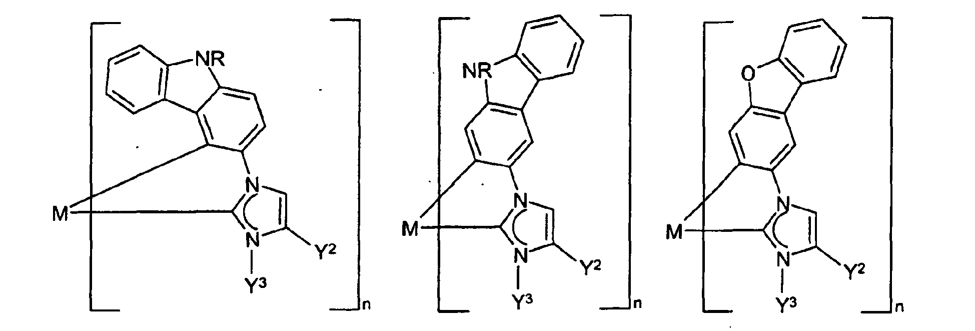 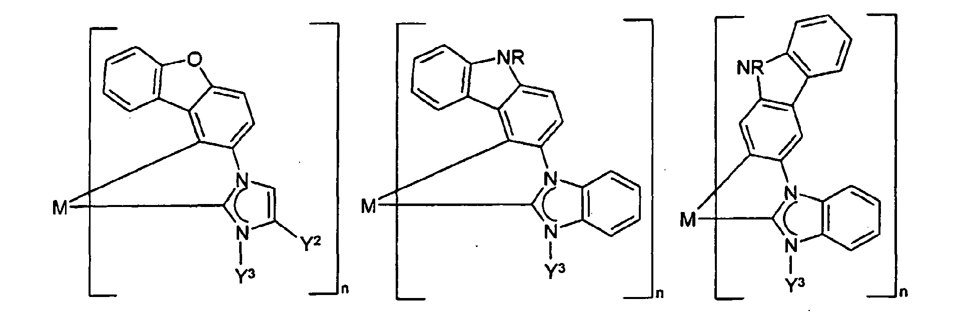 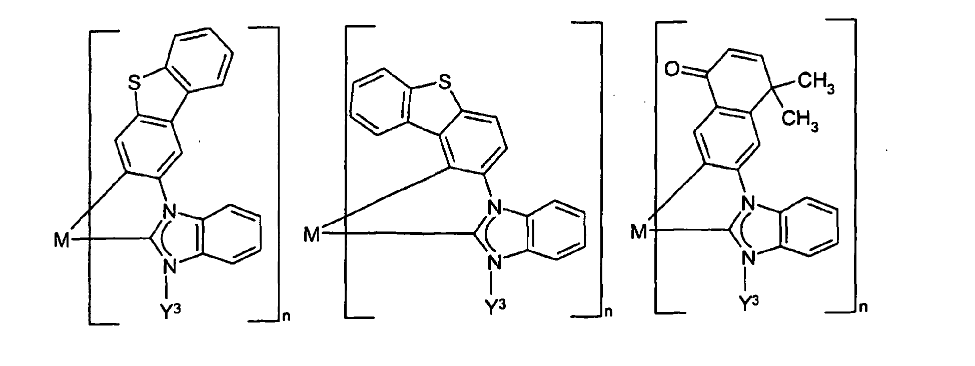 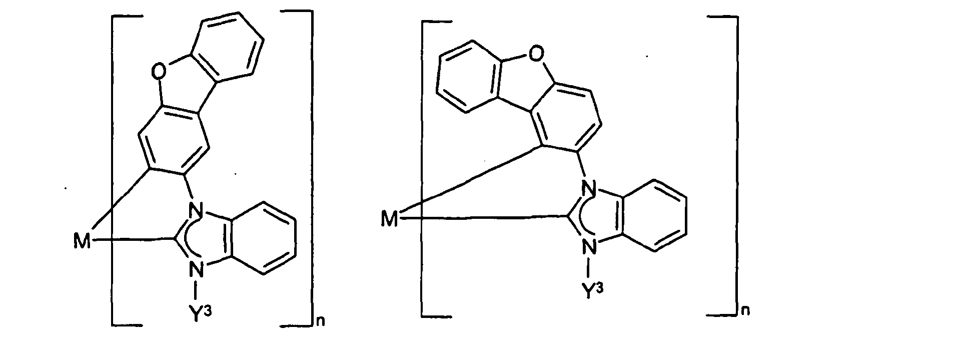 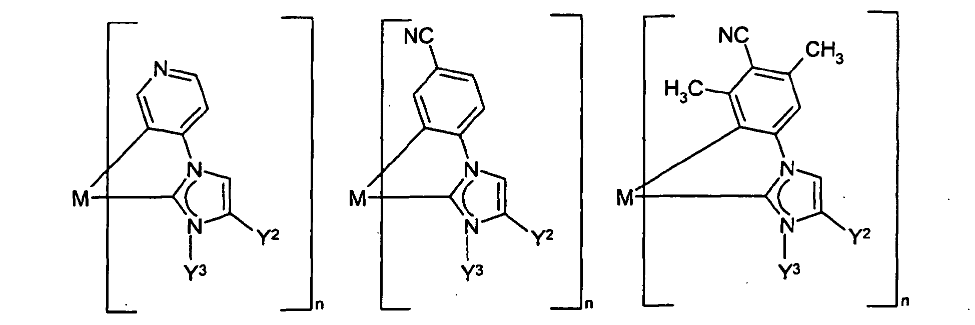 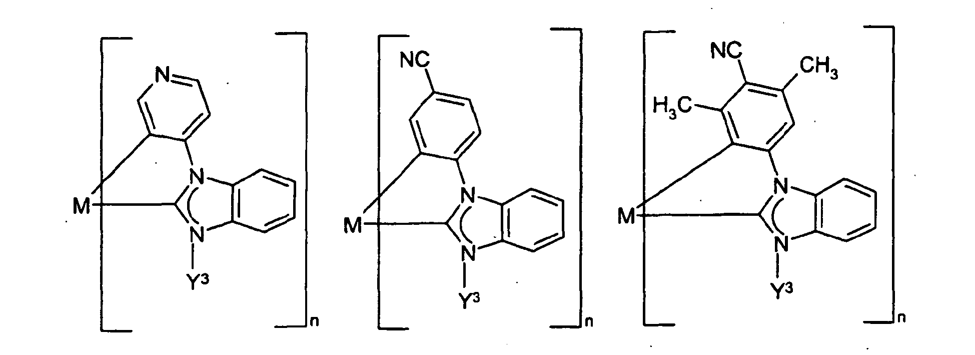 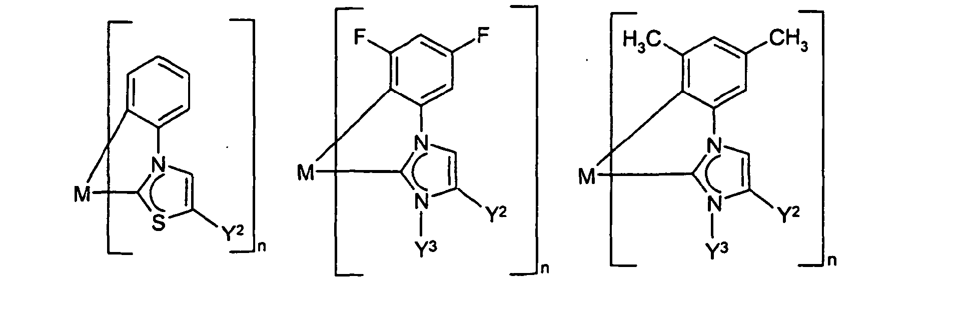 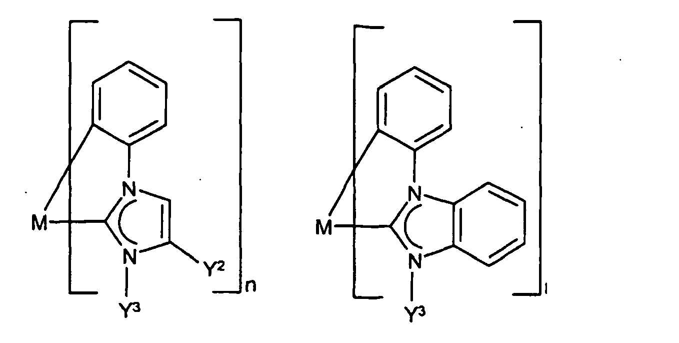 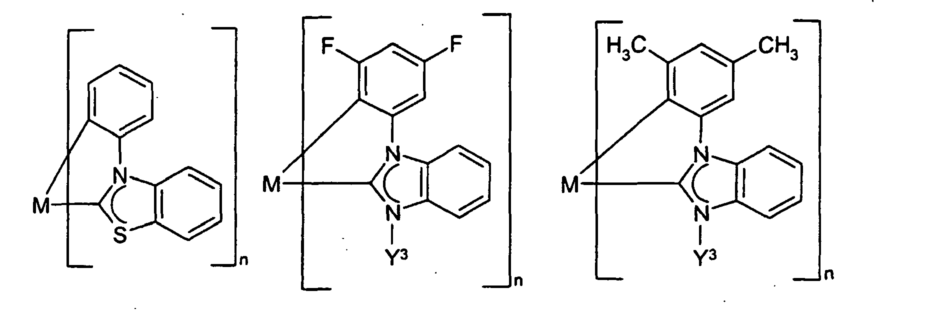 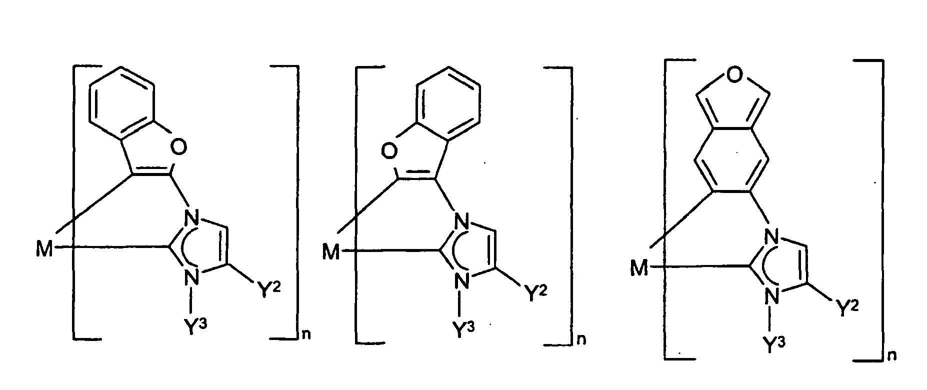 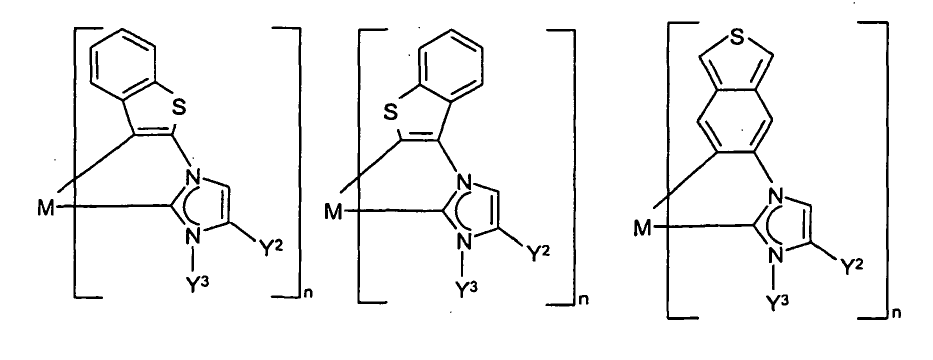 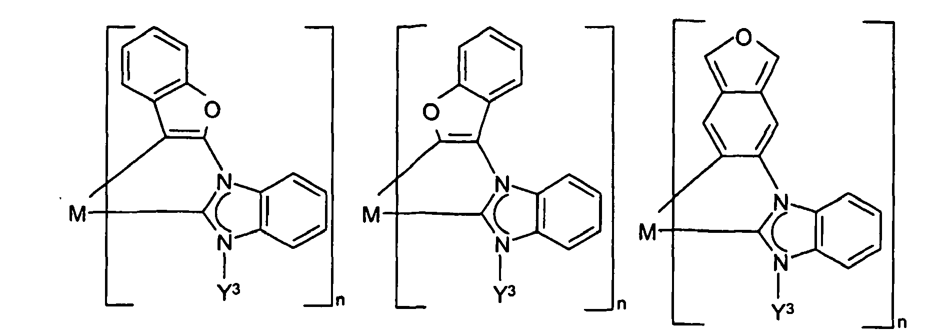 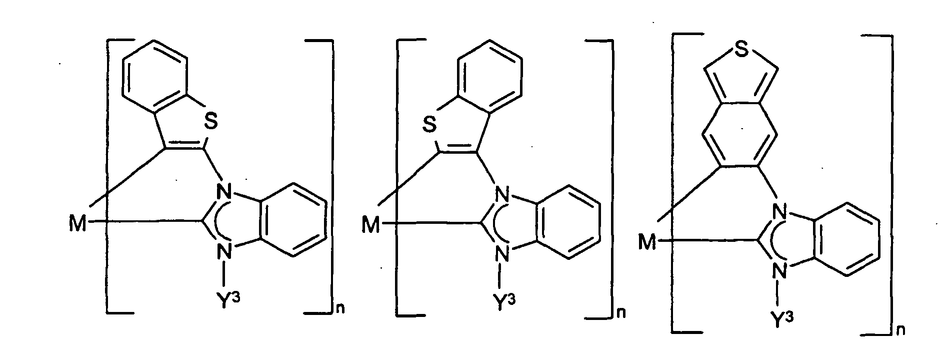 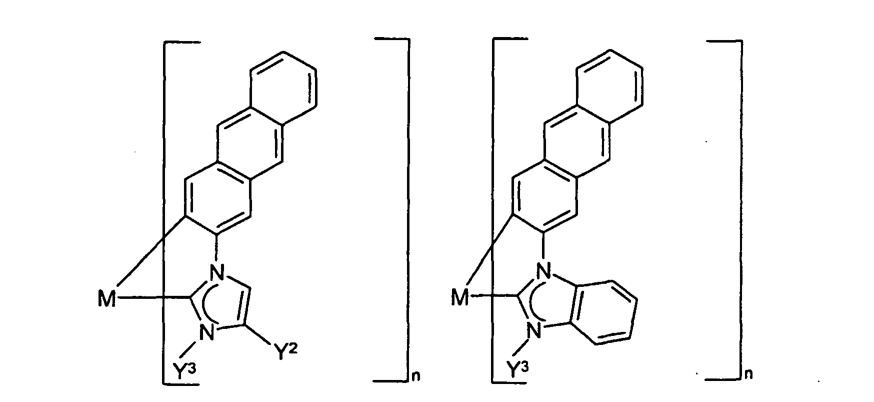 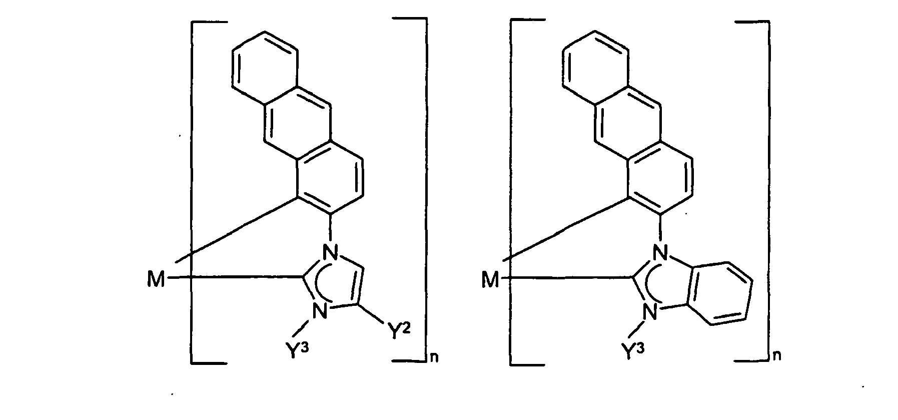 worin M für Ru(III), Rh(III), Ir(III), Pd(II) oder Pt(II) steht, n für Ru(III), Rh(III) und Ir(III) den Wert 3, für Pd(II) und Pt(II) den Wert 2 annimmt und Y² und Y³ Wasserstoff, Methyl, Ethyl, n-Propyl, iso-Propyl oder tert.-Butyl bedeuten. Bevorzugt handelt es sich bei M um Ir(III) mit n gleich 3. Y³ bedeutet vorzugsweise Methyl, Ethyl, n-Propyl, iso-Propyl oder tert.-Butyl. Zum Teil sind vorstehend isomere Verbindungen aufgeführt, um das eingangs Gesagte hinsichtlich der Isomerie der Carbenkomplexe der Formel I zu veranschaullchen.

Weitere besonders bevorzugte Komplexe der Formel I enthalten einen oder mehrere Carbenliganden, welche durch Kombination von Substrukturen ausgewählt aus der Gruppe 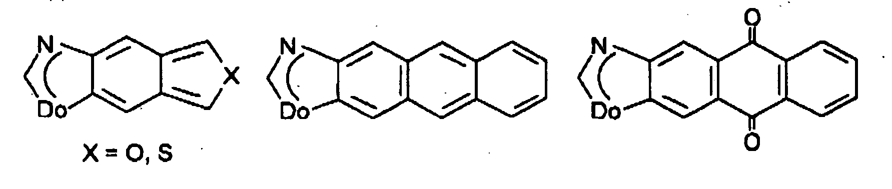 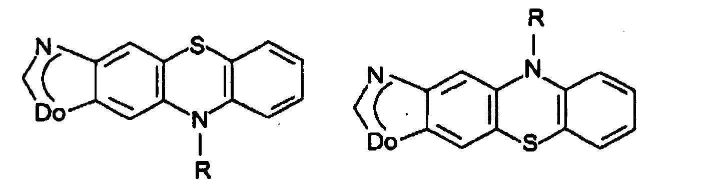 R = Wasserstoff, Alkyl, Aryl
und ausgewählt aus der Gruppe 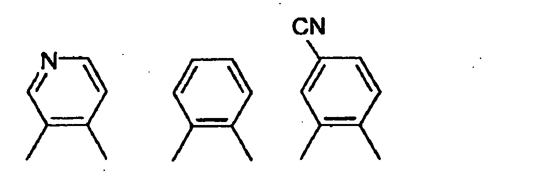 erhalten werden, wobei das Donoratom Do bevorzugt S oder N-Y³ und Y³ bevorzugt Methyl, Ethyl, n-Propyl, iso-Propyl oder tert.-Butyl bedeutet.

Insbesondere sind zu dieser Kombination die folgenden Komplexe zu nennen, welche nur Carbenliganden besitzen: 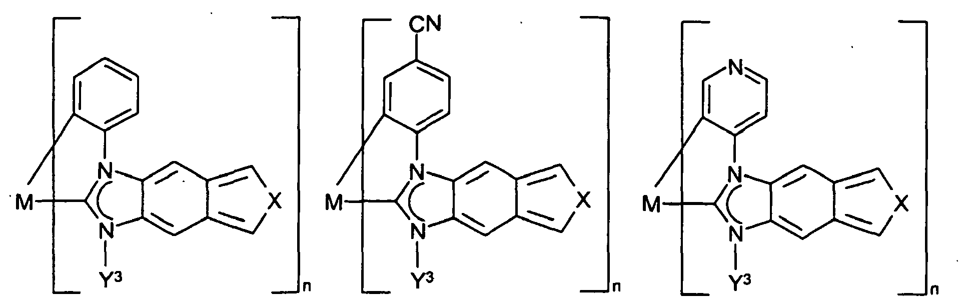 X = O, S 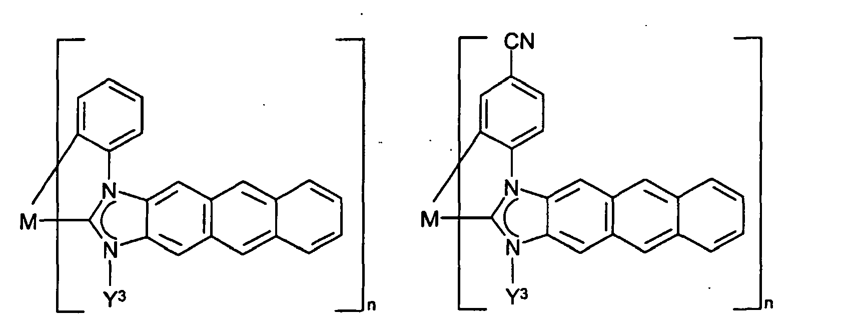 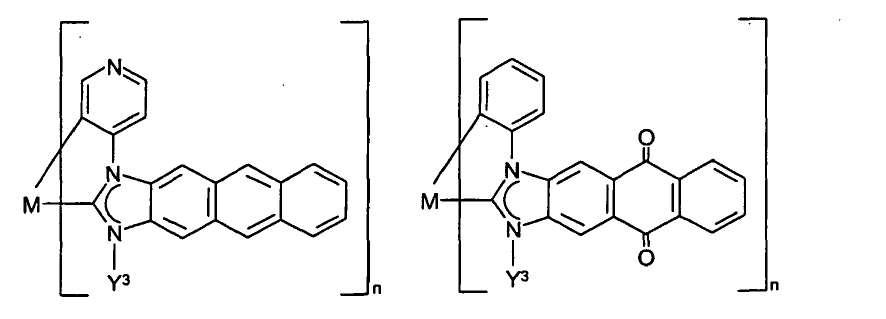 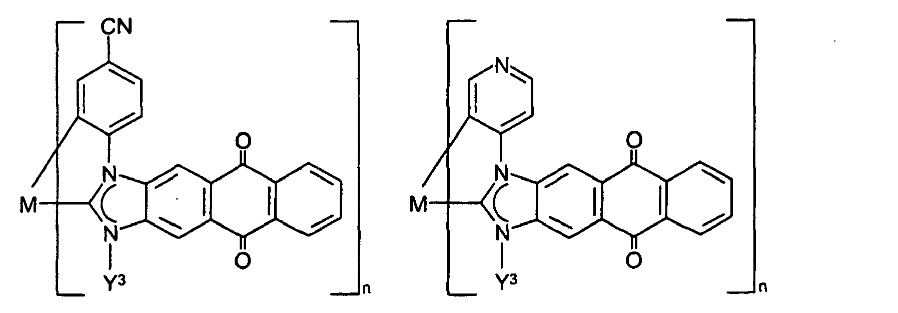 worin M für Ru(III), Rh(III), Ir(III), Pd(II) oder Pt(II) steht, n für Ru(III), Rh(III) und Ir(III) den Wert 3, für Pd(II) und Pt(II) den Wert 2 annimmt und Y³ Wasserstoff, Methyl, Ethyl, n-Propyl, iso-Propyl oder tert.-Butyl bedeuten. Bevorzugt handelt es sich bei M um Ir(III) mit n gleich 3. Y³ bedeutet vorzugsweise Methyl, Ethyl, n-Propyl, iso-Propyl oder tert.-Butyl.

Weitere besonders bevorzugte Komplexe der Formol I enthalten einen oder mehrere Carbenligenden, welche Substrukturen ausgewählt aus der Gruppe: 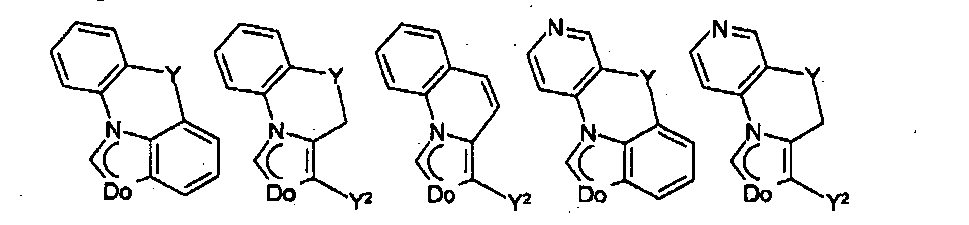 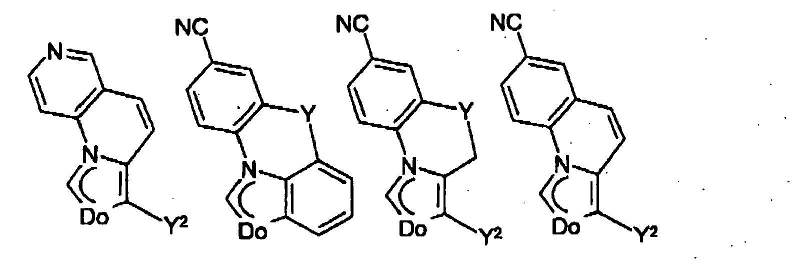 enthalten, wobei Do die Bedeutung S oder N-Y³ und Y die Bedeutung O, S, C(CH₃)₂ oder SO₂ zukommt, Y² die Bedeutung Wasserstoff, Methyl, Ethyl, n-Propyl, iso-Propyl oder tert.-Butyl und Y³ die Bedeutung Methyl, Ethyl, n-Propyl, iso-Propyl oder tert.-Butyl annehmen.

Insbesondere sind als entsprechende Komplexe zu nennen: 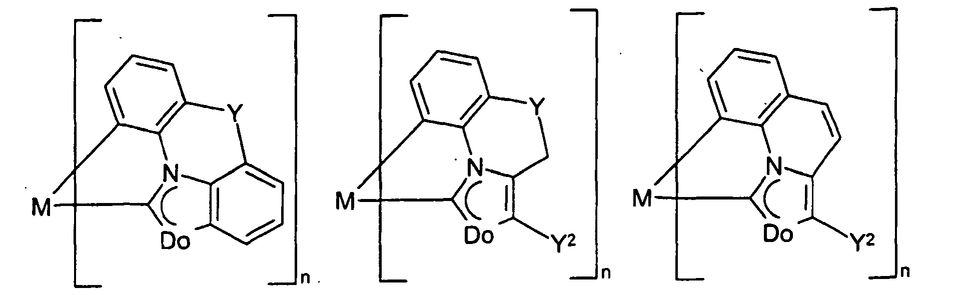 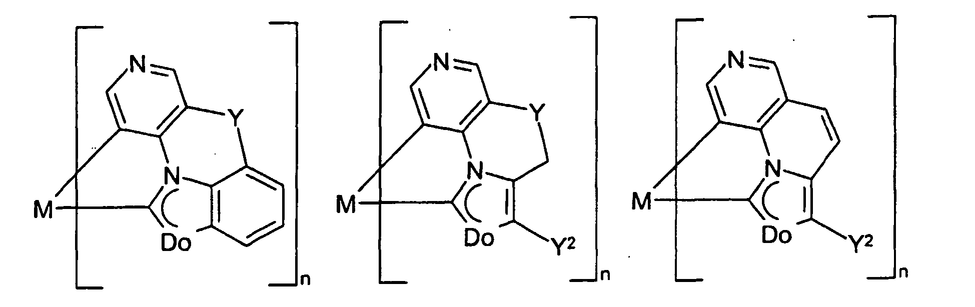 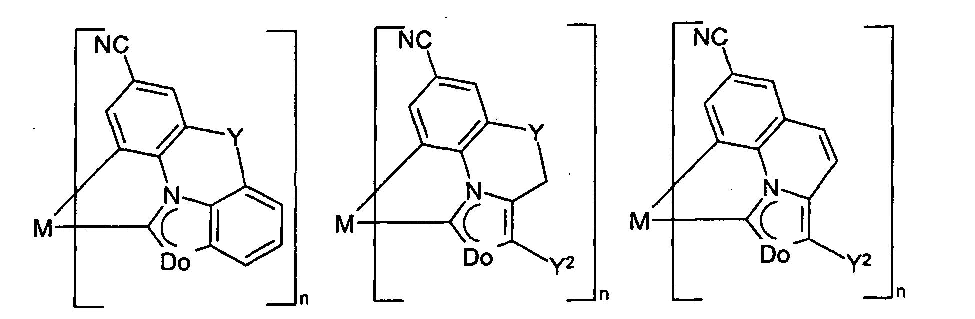 worin M für Ru(III), Rh(III), Ir(III), Pd(II) oder Pt(II) steht, n für Ru(III), Rh(III) und Ir(III) den Wert 3 und für Pd(II) und Pt(II) den Wert 2 annimmt, Y die Bedeutung O, S, C(CH₃)₂ oder SO₂, Do die Bedeutung S oder N-Y³, Y² die Bedeutung Wasserstoff, Methyl, Ethyl, n-Propyl, iso-Propyl oder tert.-Butyl und Y³ die Bedeutung Methyl, Ethyl, n-Propyl, iso-Propyl oder tert.-Butyl annimmt. Bevorzugt handelt es sich bei M um Ir(III) mit n gleich 3.

Beispielhaft seien hier genannt: 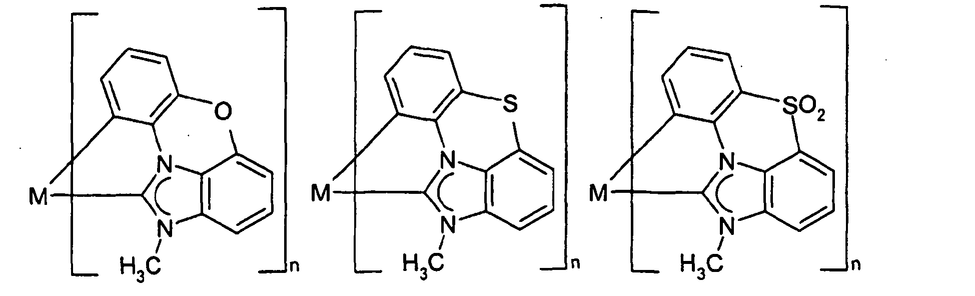 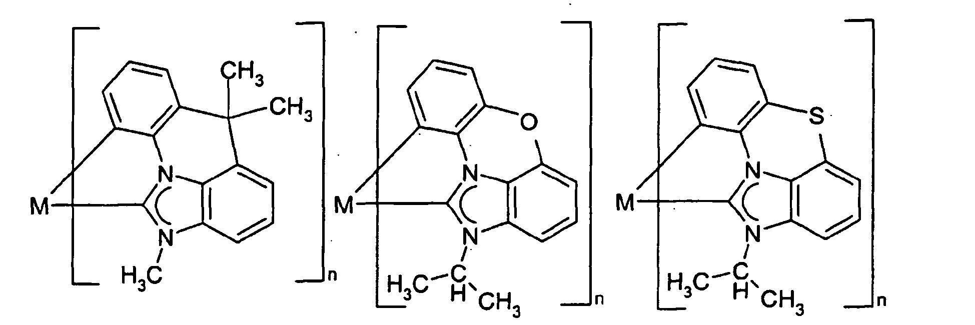 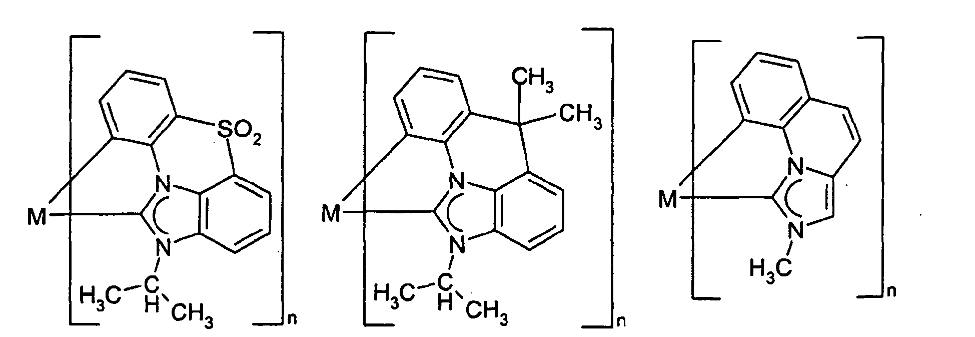 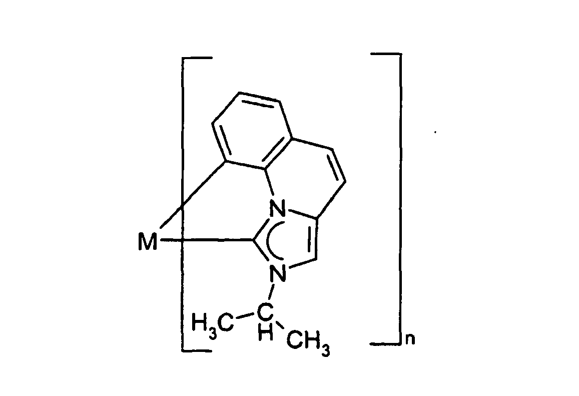 worin M für Ru(III), Rh(III) und insbesondere Ir(III), Pd(II) oder Pt(II) steht, n für Ru(III), Rh(III) und Ir(III) den Wert 3 und für Pd(II) und Pt(II) den Wert 2 annimmt

Weitere bevorzugte Komplexe der Formel I enthalten einen oder mehrere Carbenliganden, welche durch Kombination von Substrukturen ausgewählt aus der Gruppe 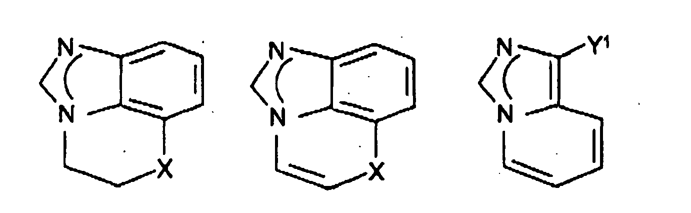 worin X für eine CH₂-Gruppe oder ein Sauerstoffatom steht und Y¹ für Wasserstoff, Methyl, Ethyl, iso-Propyl oder tert.-Butyl,
und ausgewählt aus der Gruppe 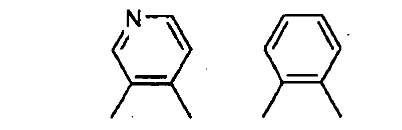 erhalten werden.

Insbesondere sind zu dieser Kombination die folgenden Komplexe zu nennen, welche nur Carbenliganden besitzen: 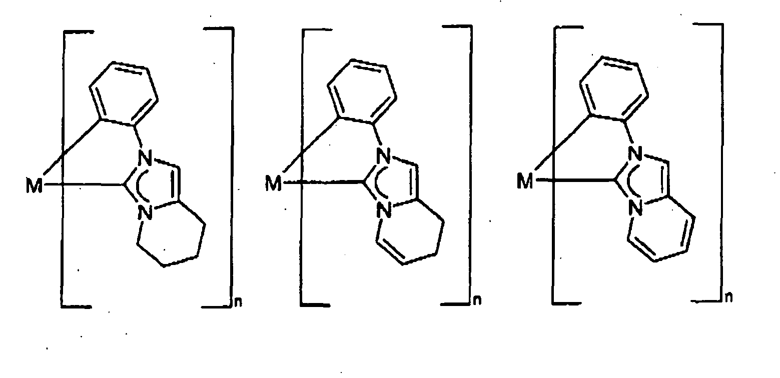 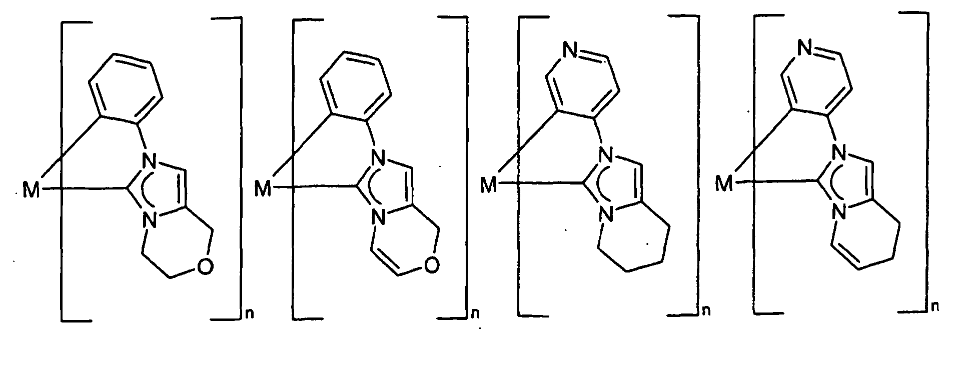 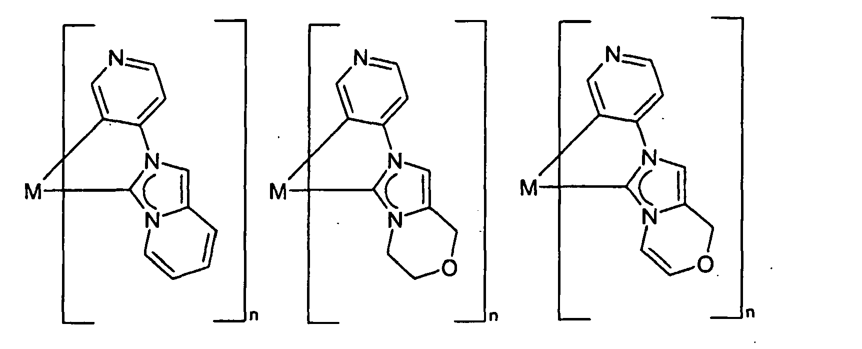 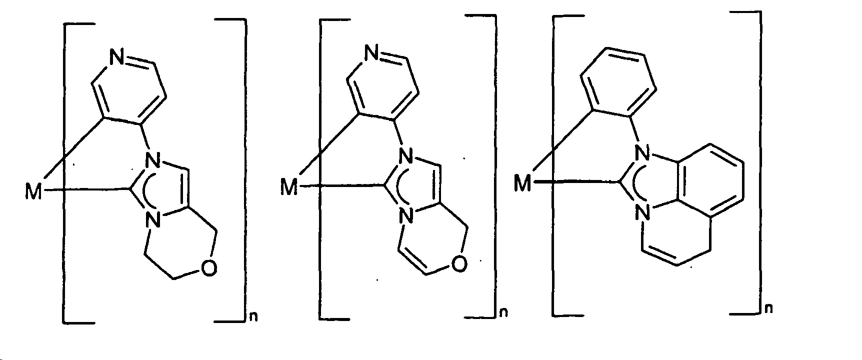 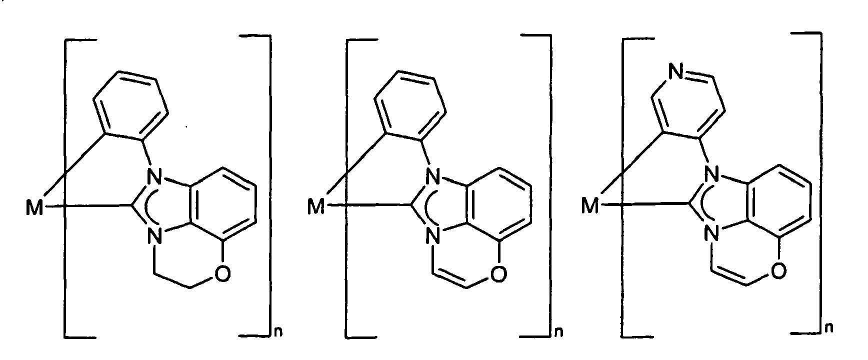 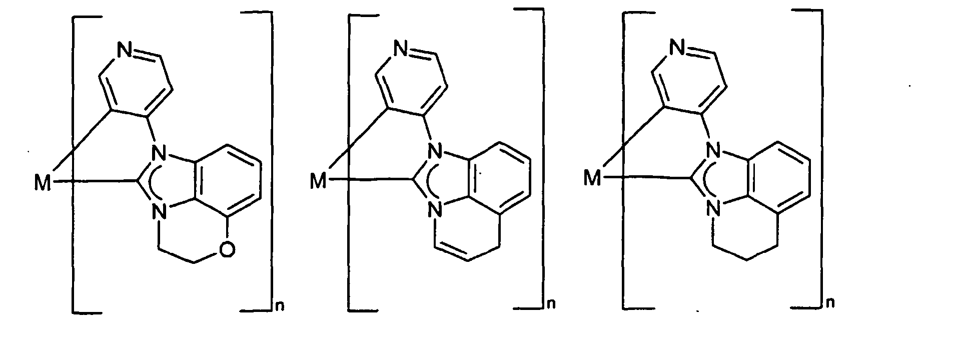 worin M für Ru(III), Rh(III) und insbesondere Ir(III), Pd(II) oder Pt(II) steht, n für Ru(III), Rh(III) und Ir(III) den Wert 3 und für Pd(II) und Pt(II) den Wert 2 annimmt.

Obwohl in den vorherigen Ausführungen das Augenmerk auf Komplexe mit gleichen Carbenliganden gerichtet ist, sei hier angemerkt, dass natürlich auch Komplexe mit verschiedenen Carbenliganden und/oder mit Liganden L und/oder K (entsprechende Liganden L und K wurden bereits eingangs definiert) erfindungsgemäß Verwendung finden können.

Anhand der nachfolgenden Tabelle seien schematisch die Komplexe mit dreiwertigen Metallzentren ML'(L'')₂ mit zwei verschiedenen Carbenliganden L' und L" genannt

| L' | L'' | L' | L'' | L' | L'' | L' | L'' |
|---|---|---|---|---|---|---|---|
| L¹ | L² | L³ | L⁴ | L⁷ | L⁵ | L⁵ | L³ |
| L¹ | L³ | L³ | L⁵ | L⁷ | L⁴ | L⁵ | L² |
| L¹ | L⁴ | L³ | L⁶ | L⁷ | L³ | L⁵ | L¹ |
| L¹ | L⁵ | L³ | L⁷ | L⁷ | L² | L⁴ | L³ |
| L¹ | L⁶ | L⁴ | L⁵ | L⁷ | L¹ | L⁴ | L² |
| L¹ | L⁷ | L⁴ | L⁶ | L⁶ | L⁵ | L⁴ | L¹ |
| L² | L³ | L⁴ | L⁷ | L⁶ | L⁴ | L³ | L² |
| L² | L⁴ | L⁵ | L⁶ | L⁶ | L³ | L³ | L¹ |
| L² | L⁵ | L⁵ | L⁷ | L⁶ | L² | L² | L¹ |
| L² | L⁶ | L⁶ | L⁷ | L⁶ | L¹ | | |
| L² | L⁷ | L⁷ | L⁶ | L⁵ | L⁴ | | |

wobei M beispielsweise für Ru(III), Rh(III) oder Ir(III), insbesondere Ir(III), und L' und L'' beispielsweise für Liganden ausgewählt aus der Gruppe der Liganden L¹ bis L⁷ 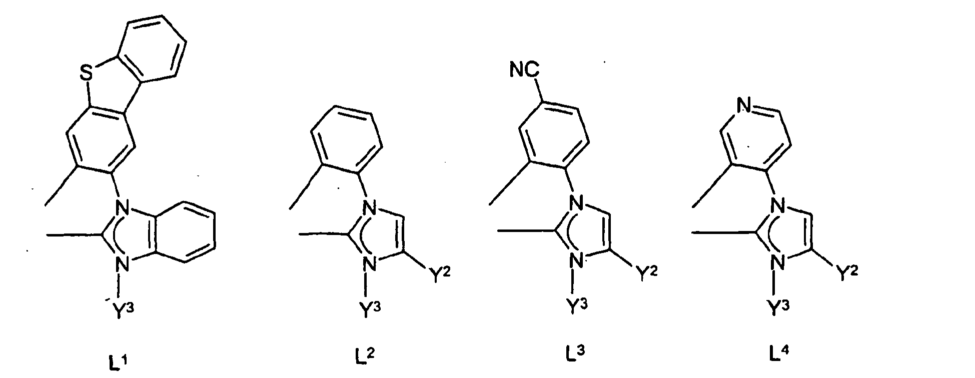 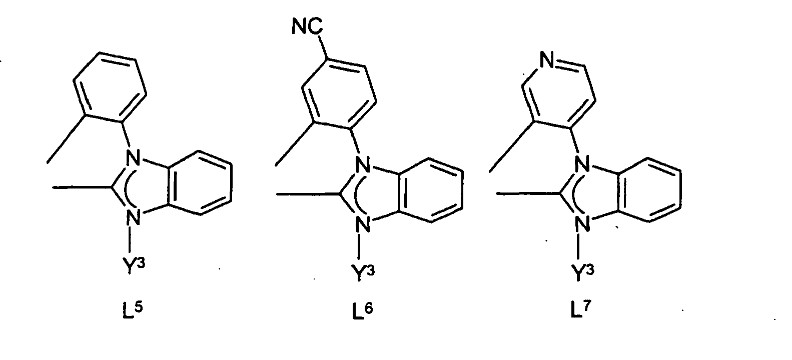 stehen, Y² Wasserstoff, Methyl, Ethyl, n-Propyl, iso-Propyl oder tert.-Butyl und Y³ Methyl, Ethyl, n-Propyl, iso-Propyl oder tert.-Butyl. bezeichnet.
Ein Vertreter dieser Komplexe mit verschiedenen Carbenliganden (L' = L⁴ mit Y² = Wasserstoff und Y³ = Methyl; L'' = L² mit Y² = Wasserstoff und Y³ = Methyl) ist beispielsweise:

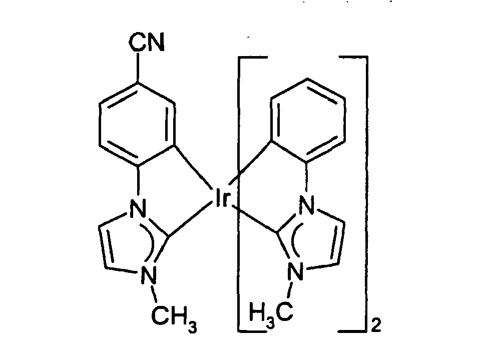

Selbstverständlich können in den erfindungsgemäß verwendeten Komplexen dreiwertiger Metallzentren (etwa im Falle von Ru(III), Rh(III) oder Ir(III)) auch alle drei Carbenliganden verschieden voneinander sein.

Beispiele für Komplexe dreiwertiger Metallzentren M mit Liganden L (hier monoanionischer, bidentater Ligand) als "Zuschauerliganden" sind LML'L", LM(L')₂ und L₂ML', worin M etwa für Ru(III), Rh(III) oder Ir(III), insbesondere Ir(III), steht, und L' und L'' die zuvor aufgeführte Bedeutung besitzen. Für die Kombination von L' und L'' in den Komplexen LML'L" ergibt sich hierbei:

| L' | L'' | L' | L'' |
|---|---|---|---|
| L¹ | L² | L³ | L⁴ |
| L¹ | L³ | L³ | L⁵ |
| L¹ | L⁴ | L³ | L⁶ |
| L¹ | L⁵ | L³ | L⁷ |
| L¹ | L⁶ | L⁴ | L⁵ |
| L¹ | L⁷ | L⁴ | L⁶ |
| L² | L³ | L⁴ | L⁷ |
| L² | L⁴ | L⁵ | L⁶ |
| L² | L⁵ | L⁵ | L⁷ |
| L² | L⁶ | L⁶ | L⁷ |
| L² | L⁷ | | |

Als Liganden L kommen vor allem das Acetylacetonat und dessen Derivate, das Picolinat, Schiffsche Basen, Aminosäuren, Tetrakis(1-pyrazolyl)borate sowie die in WO 02/15645 genannten bidentaten monoanionischen Liganden in Frage; insbesondere sind das Acetylacetonat und Picolinat von Interesse. Im Falle der Komplexe L₂ML' können die Liganden L gleich oder verschieden sein.

Ein Vertreter dieser Komplexe mit verschiedenen Carbenliganden (L' = L⁴ mit Y² = Wasserstoff und Y³ = Methyl; L'' = L² mit Y² = Wasserstoff und Y³ = Methyl) ist beispielsweise: 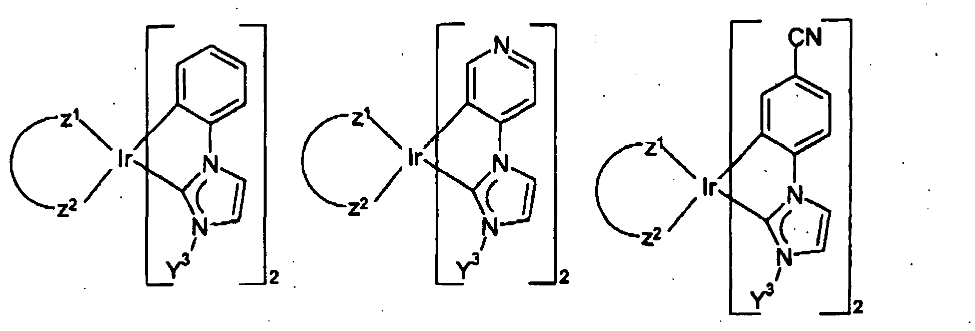 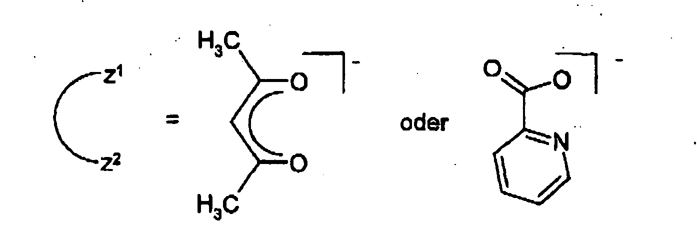 worin z¹ und z² im Symbol 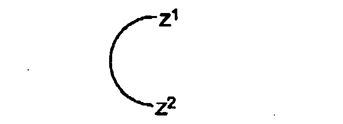 für die beiden Zähne des Liganden L stehen. Y³ bezeichnet Wasserstoff. Methyl, Ethyl, n-Propyl, iso-Propyl oder tert.-Butyl, insbesondere Methyl, Ethyl, n-Propyl oder iso-Propyl.

Die vorstehend genannten neutralen Übergangsmetall-Komplexe sind hervorragend als Emittermoleküle in organischen Licht-emittierenden Dioden (OLEDs) geeignet. Durch einfache Variationen der Liganden oder des Zentralmetalls ist es möglich. Übergangsmetall-Komplexe bereit zu stellen, die Elektrolumineszenz im roten, grünen sowie insbesondere im blauen Bereich des elektromagnetischen Spektrums zeigen. Die erfindungsgemäß verwendeten neutralen Übergangsmetall-Komplexe eignen sich daher für den Einsatz in technisch verwendbaren Vollfarbendlsplays.

Des Weiteren sind die vorstehend genannten neutralen Übergangsmetallkomplexe als Elektronen-, Excitonen- oder Lochblocker in OLEDs geeignet, in Abhängigkeit von den eingesetzten Liganden und dem eingesetzten Zentralmetall.

Die Übergangsmetall-Carbenkomplexe der Formel I können analog zu dem Fachmann bekannten Verfahren hergestellt werden. Geeignete Herstellungsverfahren sind zum Beispiel in den Übersichtsartikeln W. A. Hermann et al., Advances in Organometallic Chemistry. Vol. 48, 1 bis 69, W. A. Hermann et al., Angew. Chem. 1997, 109, 2256 bis 2282 und G. Bertrand et al. Chem. Rev. 2000, 100, 39 bis 91 und der darin zitierten Literatur aufgeführt.

Die erfindungsgemäßen Übergangsmetallkomplexe der Formel I werden durch Deprotonierung von den den entsprechenden Carbenliganden entsprechenden Ligandvorläufem und anschließende oder gleichzeitige Umsetzung mit geeigneten, das gewünschte Metall enthaltenden, Metallkomplexen hergestellt.

Daneben ist die Herstellung der erfindungsgemäßen Übergangsmetallkomplexe durch direkte Verwendung von Wanzlick-Olefinen möglich.

Geeignete Ligandvorläufer sind dem Fachmann bekannt. Bevorzugt handelt es sich um kationische Vorstufen mit negativ geladenen Gegenionen.

In einer Variante werden die kationischen Vorstufen mit einer Base umgesetzt, wobei je nach Vorläufer unterschiedliche Zwischenprodukte entstehen können. Je nach Reaktionsführung entstehen so beispielsweise Alkoxid-Derivate, dimere Wanzlick-Olefine oder die freien N-Heterocyclencarbene. Alkoxid-Derivate und Wanzlick-Olefine werden üblicherweise in Gegenwart einer geeigneten Metallvorstufe thermisch belastet, wobei eine Abspaltung des Alkohols bzw. die Spaltung des Dimeren erfolgt und die Metall-carben-Verbindung in Anwesenheit von geeigneten Metallkomplexen gebildet wird. Die Umsetzungen werden üblicherweise in geeigneten, dem Fachmann bekannten oder durch einfache Vorversuche zu ermittelnden Lösungsmitteln durchgeführt, wobei bei zweistufige Varianten für beide Teilschritte das gleiche oder unterschiedliche Lösungsmittel verwendet werden können. Als mögliche Lösungsmittel stehen zum Beispiel zur Auswahl aromatische und aliphatische Lösungsmittel oder Ether, zum Beispiel Toluol, Tetrahydrofuran, desweiteren Alkohole oder chlorierte Kohlenwasserstoffe, wie Methylenchlorid, flüssiger Ammoniak, gegebenenfalls im Gemisch mit Tetrahydrofuran, sowie polar-aprotische Lösungsmittel, wie etwa Dimethylformamid, N-Methylpymolidon oder Acetonitril. Alkohole und halogenierte Kohlenwasserstoffe werden im Allgemeinen nur dann eingesetzt, wenn in der Umsetzung kein freies Carben gebildet wird.

Die Base zur Umsetzung mit den Ligandvorläufen kann in den Metallverbindungen, welche das gewünschte Metall M der Komplexe der Formel I enthalten, vorliegen. Als mögliche Metallverbindungen kommen in Frage Metallacetate, Metallacetylacetonate, Metallamide oder Metallalkoxylate. Desweiteren kann die Umsetzung mit externen Basen, wie KO^{t}Bu, NaO^{t}Bu, LiO^{t}Bu, NaH, Disilaziden sowie Phosphazenbasen, erfolgen. Weiter ist es möglich, die Umsetzung mit den Ligendvorläufern mit den, die Base enthaltenden Metallverbindungen in Kombination mit externen Basen durchzuführen.

Bevorzugt werden die Übergangsmetall-Carbenkomplexe der Formel I ausgehend von den entsprechenden kationischen Vorstufen ausgewählt aus der Gruppe bestehend aus Azoliumsalzen, insbesondere lmidazoliumsalzen, Benzimidazoliumsalzen; Triazoliumsalzen und Azolidiniumsalzen, insbesondere Imidazolidinlumsalzen, durch Reaktion mit einer externen Base, bevorzugt KO^{t}Bu oder Disilaziden, insbesondere z. B. Kalium-bis(trimethylsilyl)-amid, und anschließender oder in situ Umsetzung des erhaltenen Zwischenprodukts mit einem Komplex des gewünschten Metalls erhalten.

Geeignete Komplexe des gewünschten Metalls sind dem Fachmann bekannt. Das gewünschte Metall in dem eingesetzten Metallkomplex und das entsprechende Metall des daraus hergestellten Übergangsmetall-Carbenkomplexes I müssen nicht dieselbe Oxidationsstufe aufweisen.

Bei der Herstellung von Iridium(III)-Komplexen der allgemeinen Formel I die gemäß der vorliegenden Anmeldung besonders bevorzugt sind, können beispielsweise die folgenden Iridlum(III)-Komplexe eingesetzt werden: [(µ-Cl)Ir(η⁴-1,5-cod)]₂, [(µ-Cl)Ir(η²-1,5-coe)₂]₂, Ir(acac)₃, IrCl₃ x n H₂O, (tht)₃IrCl₃, worin cod Cyclooctadien, coe Cycloocten, acac Acetylacetonat und tht Tetrahydrothiophen bedeuten.

Alkoxid-Derivate oder Wanzlick-Olefine werden üblicherweise bei Raumtemperatur zu den entsprechenden Metallvorstufen gegeben und anschließend thermisch belastet, wobei im Fall der Alkoxid-Derivate der entsprechende Alkohol abgespalten wird, bzw. die dimeren Wanzlick-Olefine gespalten werden und die Metall-Carben-Verbindung gebildet wird. Üblicherweise finden diese Reaktionen bei Temperaturen von 20 bis 160°C statt. Sollen als Zwischenprodukte freie Carbene eingesetzt (z.B. Imidazolin-2-ylidene) werden, so gibt man diese in der Regel unter Kühlung der Metallvorstufe zu, erwärmt anschließend auf Raumtemperatur (20 bis 25°C) und/oder gegebenenfalls auf noch höhere Temperatur. Üblicherweise wird die Umsetzung in einem Temperaturbereich von -78 bis +160°C durchgeführt.

Das Verhältnis von eingesetztem Metallkomplex zu eingesetztem Ligandvorläufer ist abhängig von dem gewünschten Komplex, der mindestens zwei Carbenliganden trägt. Handelt es sich bei dem Metallatom um Ir(III), was besonders bevorzugt ist, und enthält der gewünschte Übergangsmetallkomplex drei Carbenliganden, was ebenfalls besonders bevorzugt ist, so muss die molare Menge an Ligandvorläufern etwa dreimal so groß sein wie die molare Menge an Metall im Metallkomplex, wobei ein geringer Überschuss des Ligandvorläufers eingesetzt werden kann. Das molare Verhältnis von Metall im Metallkomplex zur molaren Menge an Ligandvorläufern beträgt in der Regel 1 : 3 bis 1:6.

Das molare Verhältnis an eingesetzter Base zu eingesetztem Ligandvorläufer liegt üblicherweise bei 3 : 1 bis 1 : 1, bevorzugt bei 2 : 1 bis 1 : 1. Bei Verwendung von starken Basen, wie LiO^{t}Bu, NaO^{t}Bu, KO^{t}Bu oder Kalium-bis-(trimethylsilyl)amid (KHMDS), ist In der Regel ein molares Verhältnis von Base zu Ligandvorläufer von 1 : 1 ausreichend.

Im Folgenden ist beispielhaft die Herstellung von zwei Iridiumkomplexen mit N-heterocyclischen Carbenliganden dargestellt:
Imidazolin-Yliden-Komplex: 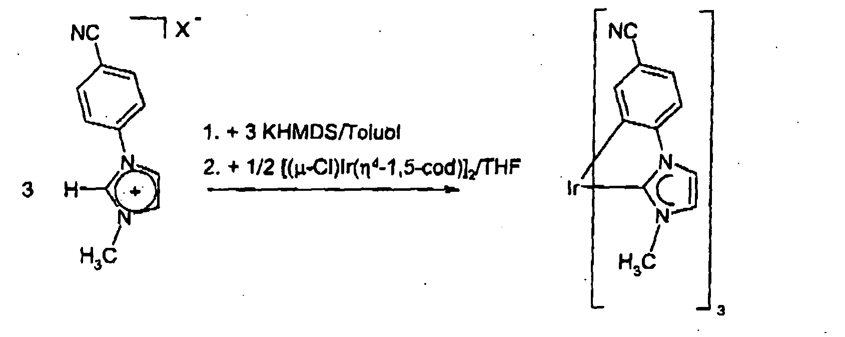 X⁻ bedeutet eine anionische Gruppe, bevorzugt ein Halogenid, Pseudohalogenid oder eine andere monoanionische Gruppe, zum Beispiel Cl⁻, Br⁻, I⁻, BF₄⁻, PF₆⁻, CN⁻, SCN⁻, besonders bevorzugt BF₄⁻, PF₆⁻.
Benzimidazolin-Yliden-Komplex: 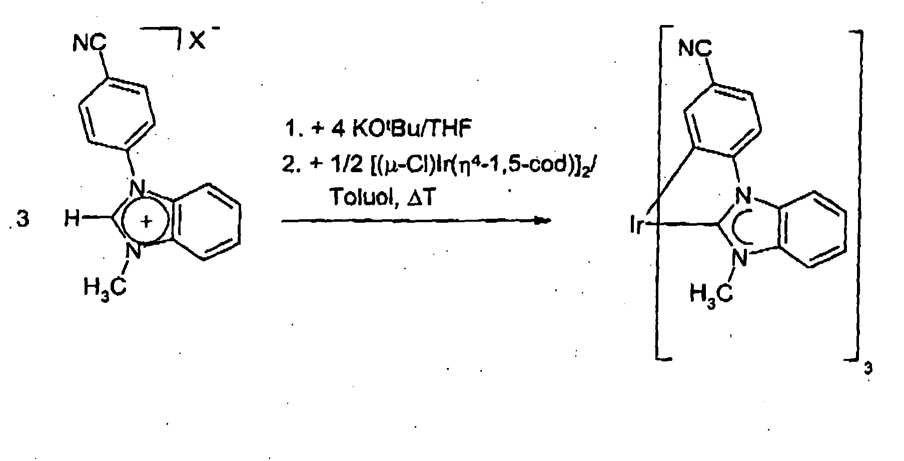
X⁻ wurde bereits vorstehend definiert.

Die erfindungsgemäß verwendeten Übergangsmetallcarbenkomplexe eignen sich hervorragend als Emittersubstanzen, da sie eine Emission (Elektrolumineszenz) im sichtbaren Bereich des elektromagnetischen Spektrums aufweisen. Mit Hilfe der erfindungsgemäß verwendeten Übergangsmetallcarbenkomplexe als Emittersubstanzen ist es möglich, Verbindungen bereit zu stellen, die Elektrolumineszenz im roten, grünen sowie im blauen Bereich des elektromagnetischen Spektrums aufweisen. Somit ist es möglich mit Hilfe der erfindungsgemäß verwendeten Übergangsmetallcarbenkomplexe als Emittersubstanzen technisch einsetzbare Vollfarbendisplays bereit zu stellen.

Durch die Zugänglichkeit von verschieden substituierten Carbenliganden sowie verschiedenen Übergangsmetallen lassen sich Emittersubstanzen herstellen, die in verschiedenen Bereichen des elektromagnetischen Spektrums Licht emittieren. Dabei ist die Quantenausbeute hoch und die Stabilität der Übergangsmetallcarbenkomplexe im Device, insbesondere solcher mit N-heterocyclischen Carbenliganden, hoch.

Des Weiteren sind die vorstehend genannten neutralen Übergangsmetallkomplexe als Elektronen-, Excitonen- oder Lochblocker in OLEDs geeignet, in Abhängigkeit von den eingesetzten Liganden und dem eingesetzten Zentralmetall.

Organische Licht-emittierende Dioden sind grundsätzlich aus mehreren Schichten aufgebaut:
1. Anode
2. Löcher-transportierende Schicht
3. Licht-emittierende Schicht
4. Elektronen-transportierende Schicht
5. Kathode

Es ist jedoch auch möglich, dass das OLED nicht alle der genannten Schichten aufweist, zum Beispiel ist ein OLED mit den Schichten (1) (Anode), (3) (Licht-emittierende Schicht) und (5) (Kathode) ebenfalls geeignet, wobei die Funktionen der Schichten (2) (Löcher-transportierende Schicht) und (4) (Elektronen-transportierende Schicht) durch die angrenzenden Schichten übernommen werden. OLEDs, die die Schichten (1), (2), (3) und (5) bzw. die Schichten (1), (3), (4) und (5) aufweisen, sind ebenfalls geeignet.

Die Übergangsmetallcarbenkomplexe gemäß der vorliegenden Anmeldung können in verschiedenenen Schichten eines OLEDs eingesetzt werden. Ein weiterer Gegenstand der vorliegenden Erfindung ist daher ein OLED enthaltend mindestens einen Übergangsmetallcarbenkomplex gemäß der vorliegenden Anmeldung. Die Übergangsmetallcarbenkomplexe werden bevorzugt in der Licht-emittierenden Schicht als Emittermoleküle eingesetzt. Ein weiterer Gegenstand der vorliegenden Erfindung ist daher eine Licht-emittierende Schicht enthaltend mindestens einen Übergangsmetall-carbenkomplex als Emittermolekül. Bevorzugte Übergangsmetallcarbenkomplexe, insbesondere Übergangsmetallcarbenkomplexe mit N-heterocyclischen Carbenliganden, sind bereits vorstehend genannt.

Die erfindungsgemäß verwendeten Übergangsmetallcarbenkomplexe können in Substanz - ohne weitere Zusätze - in der licht-emittierenden Schicht oder einer anderen Schicht des OLEDs, bevorzugt in der Licht-emittlerenden Schicht, vorliegen. Es ist jedochebenfalls möglich, dass neben den erfindungsgemäß eingesetzten Übergangsmetallcarbenkomplexen weitere Verbindungen in den Schichten enthaltend mindestens einen Übergangsmetallcarbenkomplex gemäß der vorliegenden Anmeldung, bevorzugt in der Licht-emittierenden Schicht, vorliegen. Beispielsweise kann in der Licht-emittierenden Schicht ein fluoreszierender Farbstoff anwesend sein, um die Emissionsfarbe des als Emittermoleküls eingesetzten Übergangsmetallcarbenkomplexes zu verändern. Des Weiteren kann ein Verdünnungsmaterial eingesetzt werden. Dieses Verdünnungsmaterial kann ein Polymer sein, zum Beispiel Poly(N-vinylcarbazol) oder Polysilan. Das Verdünnungsmaterial kann jedoch ebenfalls ein kleines Molekül sein, zum Beispiel 4,4'-N, N'-Dlcarbazolbiphenyl (CDP=CBP) oder tertiäre aromatische Amine. Wenn ein Verdünnungsmaterial eingesetzt wird, beträgt der Anteil der erfindungsgemäß eingesetzten Übergangsmetallcarbenkompiexe in der Licht-emittierenden Schicht im Allgemeinen weniger als 60 Gew.-%, bevorzugt weniger als 50 Gew.-%, besonders bevorzugt 5 bis 40 Ges.-%.

Die einzelnen der vorstehend genannten Schichten des OLEDs können wiederum aus 2 oder mehreren Schichten aufgebaut sein. Beispielsweise kann die Löcher-transportierende Schicht aus einer Schicht aufgebaut sein, in die aus der Elektrode Löcher injiziert werden und einer Schicht, die die Löcher von der Lochinjektionsschicht weg in die Licht-emittierende Schicht transportiert. Die Elektronen-transportierende Schicht kann ebenfalls aus mehreren Schichten bestehen, zum Beispiel einer Schicht, worin Elektronen durch die Elektrode injiziert werden, und einer Schicht, die aus der Elektroneninjektionsschicht Elektronen erhält und in die Licht-emittierende Schicht transportiert. Diese genannten Schichten werden jeweils nach Faktoren wie Energieniveau, Temperaturresistenz und Ladungsträgerbeweglichkeit, sowie Energiedifferenz der genannten Schichten mit den organischen Schichten oder den Metallelektroden ausgewählt. Der Fachmann ist in der Lage, den Aufbau der OLEDs so zu wählen, dass er optimal an die erfindungsgemäß als Emittersubstanzen verwendeten Übergangsmetallcarbenkomplexe angepasst ist.

Um besonders effiziente OLEDs zu erhalten, sollte das HOMO (höchstes besetztes Molekülorbital) der Loch-transportierenden Schicht mit der Arbeitsfunktion der Anode angeglichen sein und das LUMO (niedrigstes unbesetztes Molekülorbital) der elektronentransportierenden Schicht sollte mit der Arbeitsfunktion der Kathode angeglichen sein.

Ein weiterer Gegenstand der vorliegenden Anmeldung ist ein OLED enthaltend mindestens eine erfindungsgemäße Licht-emittierende Schicht. Die weiteren Schichten in dem OLED können aus einem beliebigen Material aufgebaut sein, das üblicherweise in solchen Schichten eingesetzt wird und dem Fachmann bekannt ist.

Die Anode (1) ist eine Elektrode, die positive Ladungsträger bereitstellt. Sie kann zum Beispiel aus Materialien aufgebaut sein, die ein Metall, eine Mischung verschiedener Metalle, eine Metalllegierung, ein Metalloxid oder eine Mischung verschiedener Metalloxide enthält. Alternativ kann die Anode ein leitendes Polymer sein. Geeignete Metalle umfassen die Metalle der Gruppen 11, 4, 5 und 6 des Periodensystems der Elemente sowie die Übergangsmetalle der Gruppen 8 bis 10. Wenn die Anode lichtdurchlässig sein soll, werden im Allgemeinen gemischte Metalloxide der Gruppen 12, 13 und 14 des Periodensystems der Elemente eingesetzt, zum Beispiel Indium-Zinn-Oxid (ITO). Es ist ebenfalls möglich, dass die Anode (1) ein organisches Material, zum Beispiel Polyanilin enthält, wie beispielsweise in Nature, Vol. 357, Seiten 477 bis 479 (11. Juni 1992) beschrieben ist. Zumindest entweder die Anode oder die Kathode sollten mindestens teilweise transparent sein, um das gebildete Licht auskoppeln zu können.

Geeignete Lochtransportmaterialien für die Schicht (2) des erfindungsgemäßen OLEDs sind zum Beispiel in Kirk-Othmer Encyclopedia of Chemical Technologie, 4. Auflage, Vol. 18, Seiten 837 bis 860, 1996 offenbart. Sowohl Löcher transportierende Moleküle als auch Polymere können als Lochtransportmaterial eingesetzt werden. Üblicherweise eingesetzte Löcher transportierende Moleküle sind ausgewählt aus der Gruppe bestehend aus 4,4'-Bis[N-(1-naphthyl)-N-phenyl-amino]biphenyl (α-NPD), N, N'-Diphenyl-N, N'-Bis(3-methylphenyl)-[1,1'-biphenyl]-4,4'-diamin (TPD), 1,1-Bis[(di-4-tolylamino)-phenyl]cyclohexan (TAPC), N, N'-Bis(4-methylphenyl)-N, N'-Bis(4-ethylphenyl)-[1,1'-(3,3'-dimethyl)biphenyl]-4,4'-diamin (ETPD), Tetrakis-(3-methylphenyl)-N,N,N',N'-2,5-phenylendiamin (PDA), α-Phenyl-4-N,N-diphenylaminostyrol (TPS), p-(Diethylamino)-benzaldehyddiphenylhydrazon (DEH), Triphenylamin (TPA), Bis[4-(N,N-diethylamino)-2-methylphenyl)(4-methyl-phenyl)methan (MPMP), 1-Phenyl-3-[p-(diethylamino)styryl]-5-[p-(diethylamino)phenyl]pyrazolin (PPR oder DEASP), 1,2-trans-Bis(9H-carbazol-9-yl)cyclobutan (DCZB), N,N,N',N'-tetrakis(4-methylphenyl)-(1,1'-biphenyl)-4,4'-diamin (TTB) 4,4',4"-tris(N,N-Diphenylamino)triphenylamin (TDTA) und Porphyrinverbindungen sowie Phthalocyaninen wie Kupferphthalocyanine. Üblicherweise eingesetzte Löcher transportierende Polymere sind ausgewählt aus der Gruppe bestehend aus Polyvinylcarbazolen, (Phenylmethyl)polysilanen, PEDOT (Poly(3,4-ethylendioxythiophen), bevorzugt PEDOT dotiert mit PSS (Polystyrolsulfonat), und Polyanilinen. Es ist ebenfalls möglich, Löcher transportierende Polymere durch Dotieren Löcher transportierender Moleküle in Polymere wie Polystyrol und Polycarbonat zu erhalten. Geeignete Löcher transportierende Moleküle sind die bereits vorstehend genannten Moleküle.

Geeignete Elektronentransportmaterialien für die Schicht (4) der erfindungsgemäßen OLEDs umfassen mit oxinoiden Verbindungen chelatisierte Metalle wie Tris(8-hydroxychinolato)aluminium (Alq₃), Verbindungen auf Phenanthrolinbasis wie 2,9-Dimethyl, 4,7-Diphenyl-1, 10-phenanthrolin (DDPA = BCP) oder 4,7-Diphenyl-1, 10-phenanthrolin (DPA) und Azolverbindungen wie 2-(4-Biphenylyl)-5-(4-t-butylphenyl)-1,3,4-oxadiazol (PBD) und 3-(4-Biphenylyl)-4-phenyl-5-(4-t-butylphenyl)-1,2,4-triazol (TAZ). Dabei kann die Schicht (4) sowohl zur Erleichterung des Elektronentransports dienen als auch als Pufferschicht oder als Sperrschicht, um ein Quenchen des Excitons an den Grenzflächen der Schichten des OLEDs zu vermeiden. Vorzugsweise verbessert die Schicht (4) die Beweglichkeit der Elektronen und reduziert ein Quenchen des Excitons.

Von den vorstehend als Lochtransportmaterialien und Elektronen transportierende Materialien genannten Materialien können einige mehrere Funktionen erfüllen. Zum Beispiel sind einige der Elektronen leitenden Materialien gleichzeitig Löcher blockende Materialien, wenn sie ein tief liegendes HOMO aufweisen.

Die Ladungstransportschichten können auch elektronisch dotiert sein, um die Transporteigenschaften der eingesetzten Materialien zu verbessern, um einerseits die Schichtdicken großzügiger zu gestalten (Vermeidung von Pinholes/Kurzschlüssen) und um andererseits die Betriebsspannung des Devices zu minimieren. Beispielsweise können die Lochtransportmaterialien mit Elektronenakzeptoren dotiert werden, zum Beispiel können Phthalocyanine bzw. Arylamine wie TPD oder TDTA mit Tetrafluorotetracyano-chinodimethan (F4-TCNQ) dotiert werden. Die Elektronentransportmaterialien können zum Beispiel mit Alkalimetallen dotiert werden, beispielsweise Alq₃ mit Lithium. Die elektronische Dotierung ist dem Fachmann bekannt und zum Beipsiel in W. Gao, A. Kahn, J. Appl. Phys., Vol. 94, No. 1, 1 July 2003 (p-dotierte organische Schichten); A. G. Werner, F. Li, K. Harada, M. Pfeiffer, T. Fritz, K. Leo, Appl. Phys. Lett., Vol. 82, No. 25, 23 June 2003 und Pfeiffer et al., Organic Electronics 2003, 4, 89 - 103 offenbart.

Die Kathode (5) ist eine Elektrode, die zur Einführung von Elektronen oder negativen Ladungsträgern dient. Geeignete Materialien für die Kathode sind ausgewählt aus der Gruppe bestehend aus Alkalimetallen der Gruppe 1, zum Beispiel Li, Cs, Erdalkalimetallen der Gruppe 2, z.B. Calcium, Barium oder Magnesium, Metallen der Gruppe 12 des Periodensystems der Elemente, umfassend die Lanthaniden und Aktiniden, z.B. Samarium. Des Weiteren können auch Metalle, wie Aluminium oder Indium, sowie Kombinationen aller genannten Metalle eingesetzt werden. Weiterhin können Lithium enthaltende organometallische Verbindungen oder LiF zwischen der organischen Schicht und der Kathode aufgebracht werden, um die Betriebsspannung (Operating Voltage) zu vermindern.

Das OLED gemäß der vorliegenden Erfindung kann zusätzlich weitere Schichten enthalten, die dem Fachmann bekannt sind. Beispielsweise kann zwischen der Schicht (2) und der Licht emittierenden Schicht (3) eine Schicht aufgebracht sein, die den Transport der positiven Ladung erleichtert und/oder die Bänderlücke der Schichten aneinander anpasst. Alternativ kann diese weitere Schicht als Schutzschicht dienen. In analoger Weise können zusätzliche Schichten zwischen der Licht emittierenden Schicht (3) und der Schicht (4) vorhanden sein, um den Transport der negativen Ladung zu erleichtern und/oder die Bänderlücke zwischen den Schichten aneinander anzupassen. Alternativ kann diese Schicht als Schutzschicht dienen.

In einer bevorzugten Ausführungsform enthält das erfindungsgemäße OLED zusätzlich zu den Schichten (1) bis (5) mindestens eine der im Folgenden genannten weiteren Schichten:
- eine Loch-Injektionsschicht zwischen der Anode (1) und der Löchertransportierenden Schicht (2);
- eine Blockschicht für Elektronen und/oder Excitonen zwischen der Löchertransportierenden Schicht (2) und der Licht-emittierenden Schicht (3);
- eine Blockschicht für Löcher und/oder Excitonen zwischen der Licht-emittierenden Schicht (3) und der Elektronen-transportierenden Schicht (4);
- eine Elektronen-Injektionsschicht zwischen der Elektronen-transportierenden Schicht (4) und der Kathode (5).

Es ist jedoch auch möglich, dass das OLED nicht alle der genannten Schichten (1) bis (5) aufweist, zum Beispiel ist ein OLED mit den Schichten (1) (Anode), (3) (Licht-emittierende Schicht) und (5) (Kathode) ebenfalls geeignet, wobei die Funktionen der Schichten (2) (Löcher-transportierende Schicht) und (4) (Elektronen-transportierende Schicht) durch die angrenzenden Schichten übernommen werden. OLEDs, die die Schichten (1), (2), (3) und (5) bzw. die Schichten (1), (3), (4) und (5) aufweisen, sind ebenfalls geeignet.

Dem Fachmann ist bekannt, wie er (zum Beispiel auf Basis von elektrochemischen Untersuchungen) geeignete Materialien auswählen muss. Geeignete Materialien für die einzelnen Schichten sind dem Fachmann bekannt und z.B. in WO 00/70655 offenbart.

Des Weiteren kann jede der genannten Schichten des erfindungsgemäßen OLEDs aus zwei oder mehreren Schichten aufgebaut sein. Des Weiteren ist es möglich, dass einige oder alle der Schichten (1), (2), (3), (4) und (5) oberflächenbehandelt sind, um die Effizienz des Ladungsträgertransports zu erhöhen. Die Auswahl der Materialien für jede der genannten Schichten ist bevorzugt dadurch bestimmt, ein OLED mit einer hohen Effizienz und Lebensdauer zu erhalten.

Die Herstellung des erfindungsgemäßen OLEDs kann nach dem Fachmann bekannten Methoden erfolgen. Im Allgemeinen wird das OLED durch aufeinanderfolgende Dampfabscheidung (Vapor deposition) der einzelnen Schichten auf ein geeignetes Substrat hergestellt. Geeignete Substrate sind zum Beispiel Glas oder Polymerfilme. Zur Dampfabscheidung können übliche Techniken eingesetzt werden wie thermische Verdampfung, Chemical Vapor Deposition und andere. In einem alternativen Verfahren können die organischen Schichten aus Lösungen oder Dispersionen in geeigneten Lösungsmitteln beschichtet werden, wobei dem Fachmann bekannte Beschichtungstechniken angewendet werden. Zusammensetzungen, die neben dem mindestens einen erfindungsgemäßen Übergangsmetallcarbenkomplex ein polymeres Material in einer der Schichten des OLEDs, bevorzugt in der Licht-emittierenden Schicht, aufweisen, werden im Allgemeinen mittels lösungsverarbeitenden Verfahren als Schicht aufgebracht.

Im Allgemeinen haben die verschiedenen Schichten folgende Dicken: Anode (1) 500 bis 5000 Å, bevorzugt 1000 bis 2000 Å; Löcher-transportierende Schicht (2) 50 bis 1000 Å, bevorzugt 200 bis 800 Å, Licht-emittierende Schicht (3) 10 bis 1000 Å, bevorzugt 100 bis 800 Å, Elektronen transportierende Schicht (4) 50 bis 1000 Å, bevorzugt 200 bis 800 Å. Kathode (5) 200 bis 10.000 Å, bevorzugt 300 bis 5000 Å. Die Lage der Rekombinationszone von Löchern und Elektronen in dem erfindungsgemäßen OLED und somit das Emissionsspektrum des OLED können durch die relative Dicke jeder Schicht beeinflusst werden. Das bedeutet, die Dicke der Elektronentransportschicht sollte bevorzugt so gewählt werden, dass die Elektronen/Löcher Rekombinationszone in der Licht-emittierenden Schicht liegt. Das Verhältnis der Schichtdicken der einzelnen Schichten in dem OLED ist von den eingesetzten Materialien abhängig. Die Schichtdicken von gegebenenfalls eingesetzten zusätzlichen Schichten sind dem Fachmann bekannt.

Durch Einsatz der erfindungsgemäß verwendeten Übergangsmetallcarbenkomplexe in mindestens einer Schicht des erfindungsgemäßen OLEDs, bevorzugt als Emittermolekül in der Licht-emittierenden Schicht der erfindungsgemäßen OLEDs, können OLEDs mit hoher Effizienz erhalten werden. Die Effizienz der erfindungsgemäßen OLEDs kann des Weiteren durch Optimierung der anderen Schichten verbessert werden. Beispielsweise können hoch effiziente Kathoden wie Ca oder Ba, gegebenenfalls in Kombination mit einer Zwischenschicht aus LiF, eingesetzt werden. Geformte Substrate und neue Löcher-transportierende Materialien, die eine Reduktion der Operationsspannung oder eine Erhöhung der Quanteneffizienz bewirken, sind ebenfalls in den erfindungsgemäßen OLEDs einsetzbar. Des Weiteren können zusätzliche Schichten in den OLEDs vorhanden sein, um die Energielevel der verschiedenen Schichten einzustellen und um Elektrolumineszenz zu erleichtern.

Die erfindungsgemäßen OLEDs können in allen Vorrichtungen eingesetzt werden, worin Elektrolumineszenz nützlich ist. Geeignete Vorrichtungen sind bevorzugt ausgewählt aus stationären und mobilen Bildschirmen. Stationäre Bildschirme sind z.B. Bildschirme von Computern, Fernsehern. Bildschirme in Druckern, Küchengeräten sowie Reklarnetafeln, Beleuchtungen und Hinweistafeln. Mobile Bildschirme sind z.B. Bildschlrme in Handys, Laptops, Digitalkameras. Fahrzeugen sowie Zielanzeigen an Bussen und Bahnen.

Weiterhin können die erfindungsgemäß eingesetzten Übergangsmetallcarbenkomplexe in OLEDs mit inverser Struktur eingesetzt werden. Bevorzugt werden die Übergangsmetallcarbenkomplexe in diesen inversen OLEDs wiederum in der Licht-emittierenden Schicht eingesetzt. Der Aufbau von inversen OLEDs und die üblicherweise darin eingesetzten Materialien sind dem Fachmann bekannt.

Die nachfolgenden Beispiele erläutern die Erfindung zusätzlich.

### Beispiele:

Sofern nicht anders vermerkt beziehen sich im Folgenden Prozentangaben immer auf Gewichtsprozent.

### Beispiel 1: Herstellung des Übergangsmetall-Carbenkomplexes

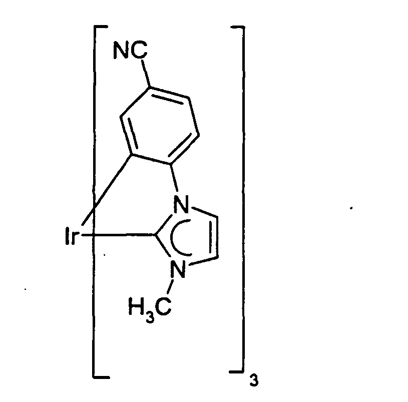

### Herstellung der Carbenvorläuferverbindung:

a) 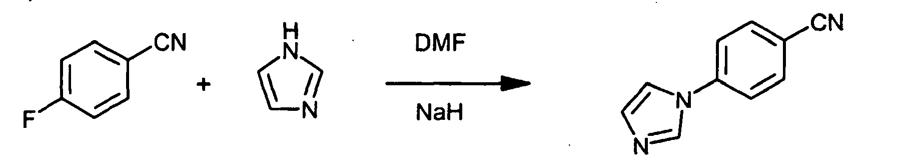 Unter Stickstoff-Überleitung werden 1500 ml trockenes Dimethylformamid (DMF) in einem 1000-ml-Vierhalskolben vorgelegt und 72,67 g (0,6 mol) 4-Fluor-cyanobenzol und 61,2 g (0,9 mol) Imidazol sowie zuletzt 21,6 g (0,9 mol) Natriumhydrid zugegeben. Die Reaktionsmischung wird auf 100°C erhitzt, 4 Stunden bei dieser Temperatur und anschließend über Nacht bei Raumtemperatur gerührt. Das Reaktionsgemisch wird danach auf Wasser gegossen und das resultierende Gemisch mit Dichlormethan mehrfach extrahiert. Die organische Phase wird getrocknet, am Rotationsverdampfer eingeengt und schließlich im Vakuum bei 60 °C nachgetrocknet. Die Ausbeute beträgt 94g (entsprechend 93 % der Theorie).
¹H-NMR (400 MHz, CDCl₃): δ = 7,27 (s, 1 H); 7,35 (s, 1 H); 7,54 (d, J = 8,8 Hz, 2 H); 7,81 (d, J = 8,8 Hz, 2 H); 7,95 (s, 1 H).
b) 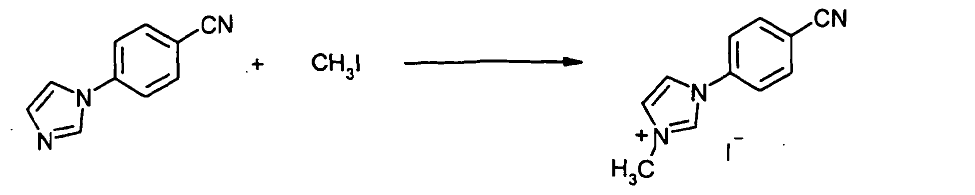 56 g (0,33 mol) des aus a) erhaltenen 4-N-Imidazolyl-benzonitrits werden in einem 2000-ml-Einhalskolben mit Kühler in 560ml wassersfreiem Tetrahydrofuran gelöst, mit 234,2 g (1,65 mol) Methyljodid versetzt, kurz durchgerührt und ohne weiteres Rühren 48 Stunden stehengelassen. Der feste Kolbeninhalt wird anschließend mit Ethanol aufgeschlämmt, abgesaugt und mit Ethanol nachgewaschen bis der Ablauf praktisch farblos ist. Der Rückstand wird bei 70°C im Vakuum getrocknet. Die Ausbeute beträgt 81,54g (entsprechend 79,7 % der Theorie).
¹H-NMR (400 MHz, DMSO): δ = 3,97 (s, 3 H); 8,00-8,04 (m, 3 H); 8,22 (d, J = 9,0 Hz, 2 H); 8,40 (dd, J = 1,8, 1,8 Hz, 1 H); 9,91 (s, 1 H).):

| Elementaranalyse (berechneter Wert für Bruttoformel C₁₁H₁₀IN | | |
|---|---|---|
| | berechnet (Gew.-%) | gefunden (gew.-%) |
| Jod | 40 | 40,9 |
| Kohlenstoff | 42,4 | 42,6 |
| Stickstoff | 13,5 | 13,6 |
| Wasserstoff | 3,3 | 2,93 |

c)

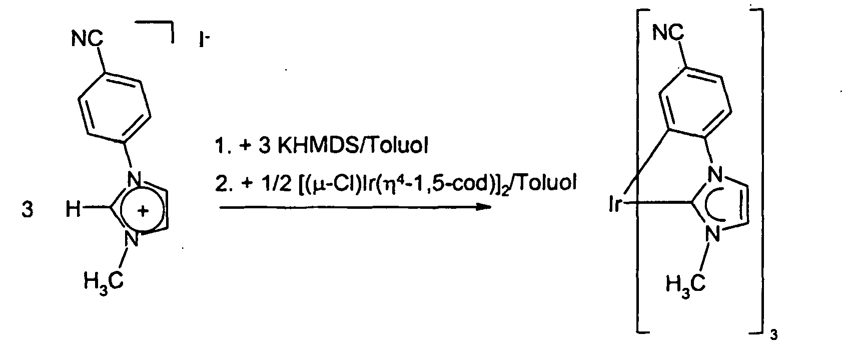

In einem 500-ml-Dreihalskolben werden 10 g (32 mol) des Imidazoliumiodids in 150 ml Toluol vorgelegt und bei Raumtemperatur innerhalb von 30 Minuten 64,3 ml Kalium-bis(trimethylsilyl)amid (0,5 M in Toluol, 32 mmol) zugesetzt. Man lässt den Ansatz 30 Minuten bei Raumtemperatur rühren. Dann werden 2,16 g (3,2 mmol) [(µ-Cl)(η⁴-1,5-cod)Ir]₂ in 200 ml Toluol gelöst und bei Raumtemperatur tropfenweise mit der Salzmischung versetzt. Die Reaktionsmischung wird eine Stunde bei Raumtemperatur gerührt, zwei Stunden bei 70 °C und dann über Nacht unter Rückfluss. Der Ansatz wird anschließend bis zur Trockene eingeengt und der Rückstand mit Methylenchlorid extrahiert. Nach erneutem Einengen bis zur Trockene wird der braune Rückstand einer säulenchromatographischen Reinigung unterzogen. Man erhält 1,15 g eines gelben Pulvers (24 % d. Th.)
¹H-NMR (CD₂Cl₂, 500 MHz): δ = 7,42 (m, 2H), 7,35 (m, 1H), 7,20 - 7,00 (m, 6H), 6,95, 6,90, (je s, 1 H), 6,77, 6,76, 6,74 6,69 (je m, 1 H) (je CH_{Ph} bzw. NCHCHN), 2,94 (m, 6H, CH₃), 2,87 (s, 3H, CH₃).
¹³C-NMR (CD₂Cl₂, 125 MHz): δ = 173,3, 171,8, 170,8 (NCN), 150,8, 150,1, 149,7, 149,4, 148,8, 147,0 (Cq), 141,4, 141,2, 139,5, 125,1, 125,0, 124,8, 121,6, 121,3, 121,1, 114,3, 114,2, 114,1, 110,0, 109,9, 109,5 (CH_{Ph}, NCHCHN), 119,9, 119,8, 119,7, 107,5, 107,1, 106,9 (Cq, CN), 36,5 (Intensität x 2), 35,3 (CH₃).

| | |
|---|---|
| Optische Spektroskopie: | λ = 459 nm, 436 nm (Emissionsmaximum, Schulter in Polymethylmethacrylat (PMMA)) |
| Quantenausbeute: | 57 % (in PMMA) |

| Elementaranalyse (berechneter Wert für Bruttoformel IrC₃₃H₂₄N₉): | | |
|---|---|---|
| | berechnet (Gew.-%) | gefunden (gew.-%) |
| Kohlenstoff | 53,7 | 54,0 |
| Stickstoff | 17,1 | 16,2 |
| Wasserstoff | 3,3 | 3,7 |

Thermogravimetrie/Differentialthermoanalyse (Aufheizrate: 5K/min):
Verlust von Lösungsmittel bei ca. 100 °C bis 160 °C
Beginn der Zersetzung ab ca. 370 °C
HPLC : > 99 Fl% (Säule: Purospher Si 80, Eluent: Heptan/iPropanol=70/30(Vol%))

### Beispiel 2: Herstellung eines OLED

### a)

Das als Anode verwendete ITO-Substrat wird zuerst mit kommerziellen Reinigungsmitteln für die LCD-Produktion (Deconex^{®} 20NS und Neutralisationsmittel 25ORGAN-ACID^{®}) und anschließend in einem Aceton/Isopropanol-Gemisch im Ultraschallbad gesäubert. Zur Beseitigung möglicher organischer Rückstände wird das Substrat in einem Ozonofen weitere 25 Minuten einem kontinuierlichen Ozonfluss ausgesetzt. Diese Behandlung verbessert auch die Lochinjektion des ITOs.
Danach werden die nachfolgend genannten organischen Materialien mit einer Rate von ca. 2 nm/min bei etwa 10⁻⁷ mbar auf das gereinigte Substrat aufgedampft. Als Lochleiter wird zuerst 1-TNATA (4,4',4"-tris(N-(naphth-1-yl)-N-phenyl-amino)-triphenylamin) in einer Schichtdicke von 17,5 nm auf das Substrat aufgebracht. Es folgt die Abscheidung einer 9,5 nm dicken Exciton-Blockerschicht aus der Verbindung V1 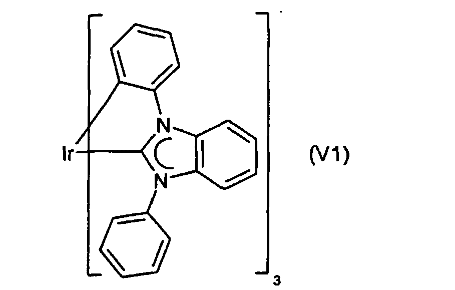 (zur Herstellung siehe Ir-Komplex (7) in der Anmeldung PCT/EP/04/ 09269).
Anschließend wird eine Mischung aus 34 Gew.-% der Verbindung 1 c) 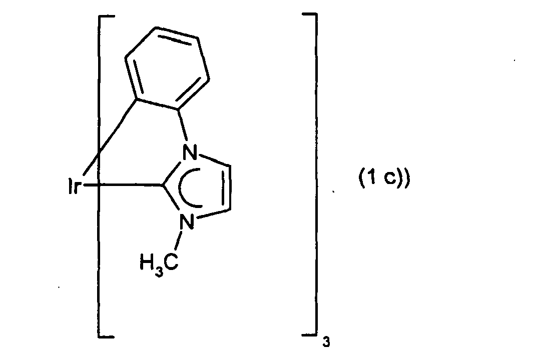 aus Beispiel 1 c) und 66 Gew.-% der Verbindung V2 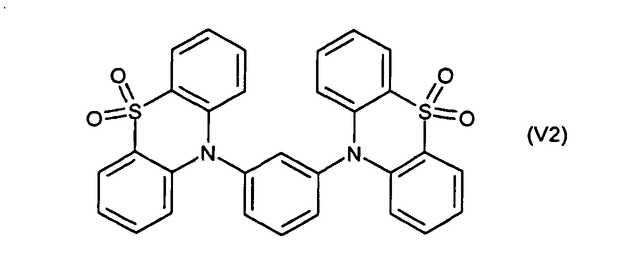 (1,3-Phenylen-10,10'-bis(phenothiazin)-5,5'-dioxid) in einer Dicke von 20 nm aufgedampft, wobei erstere Verbindung als Emitter, letztere als Matrixmaterial fungiert. Danach wird eine Lochblocker- und Elektronenleiterschicht aus 2,9-Dimethyl-4,7-Diphenyl-1,10-phenanthrolin (BCP) in einer Dicke von 47,5 nm, eine 0,75 nm dicke Lithiumftuorid-Schicht und abschliessend eine 110 nm dicke Al-Elektrode aufgedampft.

Zur Charakterisierung des OLEDs werden Elektrolumineszenz-Spektren bei verschiedenen Strömen bzw. Spannungen aufgenommen. Weiterhin wird die Strom-Spannungs-Kennlinie in Kombination mit der abgestrahlten Lichtleistung gemessen. Die Lichtleistung kann durch Kalibration mit einem Luminanzmeter in photometrische Größen umgerechnet werden.

Für das beschriebene OLED ergeben sich die folgenden elektrooptischen Daten:

| | |
|---|---|
| Emissionsmaximum | 466 nm |
| CIE(x, y) | 0,17; 0,21 |
| Photometrischer Wirkungsgrad | 11,7 cd/A |
| Leistungseffizienz | 9,9 lm/W |
| Externe Quantenausbeute | 7,3 % |
| Photometrischer Wirkungsgrad bei einer Leuchtdichte von 100 cd/m² | 10,3 cd/A |
| Maximale Leuchtdichte | 2700 cd/m² |

Die Verbindung V2 wurde folgendermaßen hergestellt:

i) Herstellung von 1,3-Phenylen-10,10'-bis(phenothiazin) nach K. Okada et al., J. Am. Chem. Soc. 1996, 118, 3047 - 3048.

18,5 g (91,9 mmol) Phenothiazin, 15,6 g (46,3 mmol) 98 %iges 1,3-Diiodbenzol, 19,4 g (140 mmol) Kaliumcarbonat und 1,16 g (18,3 mmol) aktiviertes Kupferpulver wurden auf 200 °C erhitzt und 24 h bei dieser Temperatur gerührt. Die Reaktionsmischung wurde auf 140 °C abgekühlt und mit dann mit 200 ml Essigsäureethylester versetzt. Die Suspension wurde eine Stunde lang unter Rückfluss zum Sieden erhitzt und anschließend heiß filtriert. Das Filtrat wurde mit 300 ml Methanol verdünnt, wobei ein Niederschlag ausfiel, der abgesaugt, mit Methanol gewaschen und bei 80 °C im Vakuum getrocknet wurde. Es wurden 8,91 g rosafarbener Feststoff mit einem Schmp. von 186 - 188 °C erhalten.

### ii) Herstellung von 1,3-Phenylen-10,10'-bis(phenothiazin)-5,5'-dioxid (V2)

6,28 g (13,3 mmol) 1,3-Phenylen-10,10'-bis(phenothiazin) wurden in 220 ml Methylenchlorid gelöst. Nach 15 min Rühren bei Raumtemperatur wurden 17,9 g (79,9 mmol) 77 %ige m-Chlorperbenzoesäure portionsweise zugegeben. Die Reaktionslösung wurde 24 h bei Raumtemperatur gerührt, währenddessen ein Niederschlag ausfiel. Die Lösung wurde filtriert, und der Rückstand mit Methylenchlorid gewaschen und trocken gesaugt. Der Feststoff wurde in heißem Wasser suspendiert. Die wässrige Suspension wurde mit 5 %iger Kalilauge auf pH 11 gestellt und anschließend heiß filtriert. Der Rückstand wurde mit heißem Wasser gewaschen und bei 80 °C im Vakuum getrocknet. Der Feststoff (5,07 g) wurde aus Dimethylformamid umkristallisiert. Es wurden 3,72 g farblose Mikrokristalle mit einem Schmp. von 412 °C analysenrein erhalten, deren Lösung in Toluol bei λ = 375 nm (S) fluoreszierte.

### b)

Das ITO-Substrat wird wie unter a) beschrieben vorbehandelt.

Danach werden die nachfolgend genannten organischen Materialien mit einer Rate von ca. 2 nm/min bei etwa 10⁻⁷ mbar auf das gereinigte Substrat aufgedampft. Als Lochleiter wird zuerst 1-TNATA (4,4',4"-tris(N-(naphth-1-yl)-N-phenyl-amino)-triphenylamin) in einer Schichtdicke von 15 nm auf das Substrat aufgebracht. Es folgt die Abscheidung einer 9 nm dicken Exciton-Blockerschicht aus der Verbindung V1.

Anschließend wird eine Mischung aus 55 Gew.-% der Verbindung 1 c) und 45 Gew.-% 1,3-Bis(N-carbazolyl)benzol in einer Dicke von 16 nm aufgedampft, wobei erstere Verbindung als Emitter, letztere als Matrixmaterial fungiert. Danach wird eine Lochblocker- und Elektronenleiterschicht aus BCP in einer Dicke von 45 nm, eine 0,75 nm dicke Lithiumfluorid-Schicht und abschliessend eine 110 nm dicke Al-Elektrode aufgedampft.

Zur Charakterisierung des OLEDs werden Elektrolumineszenz-Spektren bei verschiedenen Strömen bzw. Spannungen aufgenommen. Weiterhin wird die Strom-Spannungs-Kennlinie in Kombination mit der abgestrahlten Lichtleistung gemessen. Die Lichtleistung kann durch Kalibration mit einem Luminanzmeter in photometrische Größen umgerechnet werden.

### Beispiele 3 bis 13

Allgemeine Methode zur Herstellung der Iridium-Carbenkomplexe der Beispiele 3 bis 13 aus den entsprechenden Imidazolium-Salzen und [(µ-Cl)Ir(η⁴-1,5-cod)]₂:

Eine Suspension von einem Äquivalent des entsprechenden lmidazolium-Salzes in Dioxan oder Toluol wird unter Argon langsam mit einem Äquivalent Kalium-bis(trimethylsilyl)amid (0,5 molar in Toluol) versetzt und 30 Minuten bei Raumtemperatur gerührt. Die Mischung wird mit 0,1 Äquivalent [(µ-Cl)Ir(η⁴-1,5-cod)]₂ versetzt und 16 Stunden unter Rückfluß gerührt. Nach Abkühlung auf Raumtemperatur wird der Niederschlag abfiltriert und mit Dioxan gewaschen. Die vereinigten Filtrate werden zur Trockene eingeengt und das Rohprodukt wird säulenchromatographisch gereinigt.

### Beispiel 3: Herstellung von mer-Tris-[1-(4'-cyanophenyl)-3-methylbenzimidazol-2-yliden-C²,C^{2'}]-iridium(III)

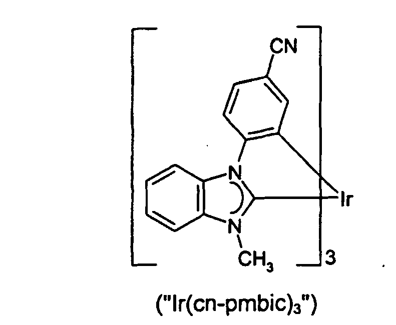

### a) Herstellung von 1-(4-Cyanophenyl)benzimidazol (gemäß K. Nishiura, Y. Urawa, S. Soda, Adv. Synth. Catal. 2004, 346, 1679)

Natriumhydrid (60%ig in Mineralöl; 24,0 g 0,60 mol) wurde in einem Kolben vorgelegt und mit N,N-Dimethylformamid (80 ml) versetzt. Zu dieser Suspension wurde über 1 Stunde eine Lösung aus Benzimidazol (73,3 g, 0,60 mol) in N,N-Dimethylformamid (250 ml) zugetropft. Nach beendeter H₂-Entwicklung wurde 4-Chlorbenzonitril (55,6 g, 0,40 mol) zugegeben und anschließend 10,5 Stunden auf 130 °C erwärmt. Nach Abkühlen auf Raumtemperatur wurde das Reaktionsgemisch auf Wasser (4 I) gegeben und der gebildete Rückstand abgesaugt, mit Wasser gewaschen und im Vakuum getrocknet. Es wurden 90,6 g 1-(4-Cyanophenyl)benzimidazol erhalten, das noch Verunreinigungen an Mineralöl enthielt.

¹H-NMR (400 MHz, CD₂Cl₂): δ = 7,35-7,41 (m, 2 H), 7,59-7,63 (m, 1 H), 7,70 (d, J = 8,5 Hz, 2 H), 7,83-7,86 (m, 1 H), 7,90 (d, J = 8,5 Hz, 2 H), 8,15 (s, 1 H).

### b) Herstellung von 1-(4-Cyanophenyl)-3-methyl-benzimidazoliumiodid

1-(4-Cyanophenyl)benzimidazol (90 g, leicht verunreinigt durch Mineralöl) wurde in Tetrahydrofuran (250 ml) vorgelegt, mit Methyliodid (116 g, 0,82 mol) versetzt und 25,5 Stunden bei 40 °C belassen. Der gebildete Rückstands wurde abfiltriert, mit Ethanol gewaschen und im Vakuum getrocknet. Es wurden 123 g 1-(4-cyano-phenyl)-3-methyl-benzimidazoliumiodid erhalten.

¹H-NMR (400 MHz, DMSO): δ = 4,20 (s, 3 H), 7,74-7,84 (m, 2 H), 7,93 (d, J = 8,4 Hz, 1 H), 8,07 (d, J = 8,8 Hz, 2 H), 8,18 (d, J = 8,4 Hz, 1 H), 8,30 (d, J = 8,8 Hz, 2 H), 10,24 (s, 1 H).

### c) Herstellung von mer-Tris-[1-(4'-cyanophenyl)-3-methylbenzimidazol-2-yliden-C²,C^{2'}]-iridium(III)

Die Herstellung des Carbenkomplexes erfolgte durch Umsetzung des in Schritt b) erhaltenen lmidazolium-Salzes mit [(µ-Cl)(η⁴-1,5-cod)Ir]₂ gemäß der oben genannten allgemeinen Methode. Man erhielt das Produkt nach Eluieren mit Essigsäure-ethylester/Methanol 2:1 in einer Ausbeute von 24% der Theorie als gelbliches Pulver.

¹H-NMR (d₆-DMSO, 500 MHz): δ = 3,18 (s, 3H), 3,22 (s, 3H), 3,29 (s, 3H), 6,81 (d, J 2,0, 1 H), 7,03 (d, J 2,0, 1 H), 7,10 (d, J 2,0, 1 H), 7,30-7,47 (m, 12H), 7,94 (d, J 8,0, 1 H), 7,95 (d, J 3,5, 1 H), 7,97 (d, J 3,5, 1 H), 8,15 (d, J 8,0, 1 H), 8,16 (d, J 3,5, 1 H), 8,17 (d, J 3,5, 1 H).

¹³C-NMR (CD₂Cl₂, 125 MHz): δ = 187,0, 185,0, 183,7 (NCN), 153,4, 152,6, 151,8, 150,5, 149,7, 147,5 (Cq bzw. CN), 141,9, 141,7, 139,9 (CH_{Ph}), 137,10, 137,07, 136,7, 132,63 (2), 132,59 (Cq bzw. CN), 127,1, 127,0, 126,7, 124,3, 124,2 (2), 123,71, 123,66, 123,5, (CH_{Ph}), 120,68, 120,66, 120,65 (Cq bzw. CN), 113,1, 112,9, 112,5, 112,2, 112,1, 111,9, 111,1, 110,9 (2) (CH_{Ph}), 108,6, 108,3, 108,2 (Cq bzw. CN), 34,3, 34,2, 33,5 (NCH₃).

### Beispiel 4: Herstellung von von Tris-[1-phenyl-3-methyl-5-azabenzimidazol -2-yliden-C²,C^{2'}]-iridium(III)

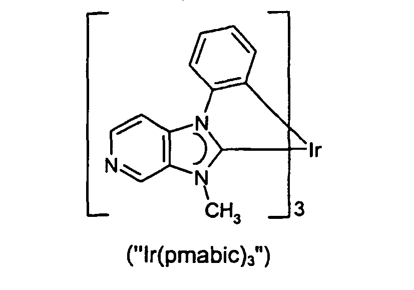

### a) Herstellung von 4-(N-Phenylamino)-3-nitropyridin

Zu einer Suspension von 4-Chlor-3-nitropyridin (3,2 g, 20 mmol, 1 Äquivalent) in Chloroform (12 ml) wird unter Argon bei 0 °C eine Lösung von Anilin (2,2 ml, 24 mmol, 1,2 Äquivalent) und Triethylamin (3,7 ml, 27 mmol, 1,3 Äquivalent) in Chloroform (6 ml) zugetropft. Anschließend wird die Mischung unter Rückfluß 16 Stunden gerührt. Nach Abkühlung auf Raumtemperatur wird die organische Phase mit Wasser gewaschen, über Natriumsulfat getrocknet und zur Trockne eingeengt. Das Rohprodukt wird säulenchromatographisch (Kieselgel, Essigsäure-ethylester/ Cyclohexan 9:1) getrennt. Ausbeute: 3,4 g (16 mmol, 80%).

¹H-NMR (CDCl₃, 400 MHz): δ = 6,95 (d, J 6,0, 1H), 7,29 (d, J 7,5, 2H), 7,35 (t, J 7,5, 1 H), 7,48 (dd, J 8,0, 7,5, 2H), 8,26 (br s, 1 H), 9,31 (br s, 1 H), 9,67 (s, 1 H).

### b) Herstellung von 4-(N-Phenylamino)-3-aminopyridin

Eine Lösung von 4-(N-Phenylamino)-3-nitropyridin (5,6 g, 25 mmol) in Tetrahydrofuran (25 ml) wird bei Raumtemperatur mit Palladium auf Aktivkohle (2,5 g) und Propionsäure (3 Tropfem) versetzt. In die Mischung wird 3 Stunden Wasserstoff eingeleitet. Anschliessend wird die Suspension über Celite filtriert und das Filtrat zur Trockne eigeengt. Ausbeute: 4,3 g (23 mmol, 93%).

¹H-NMR (CDCl₃, 400 MHz): δ = 3,40 (br s, 2H), 6,37 (br s, 1 H), 6,99 (d, J 5,5, 1 H), 7,06-7,19 (m, 3H), 7,34 (dd, J 8,0, 7,5, 2H), 7,88 (d, J 5,5, 1H), 8,07 (s, 1H).

### c) Herstellung von 4-(N-Phenylamino)-3-(N-formylamino)pyridin

Eine Lösung von 4-(N-Phenylamino)-3-aminopyridin (4,0 g, 22 mmol, 1 Äquivalent) in Ameisensäure (9,9 g, 216 mmol, 10 Äquivalent) wird bei 0 °C vorsichtig mit Acetanhydrid (2,6 g, 26 mmol, 1,2 Äquivalent) versetzt. Die Mischung wird 16 Stunden bei Raumtemperatur gerührt, vorsichtig mit Wasser verdünnt und mit Diethylether extrahiert. Die organische Phase wird mit Wasser und gesättigter Natriumhydrogencarbonat-Lösung gewaschen, über Natriumsulfat getrocknet und zur Trockne eingeengt. Das Rohprodukt wird säulenchromatographisch (Kieselgel, Essigsäureethylester/Cyclohexan 9:1) getrennt. Ausbeute: 3,3 g (15 mmol, 71%).

¹H-NMR (CDCl₃, 400 MHz): δ = 6,42 (br s, 1 H), 7,04 (d, J 5,5, 1 H), 7,07-7,21 (m, 3H), 7,36 (dd, J 8,0, 7,5, 2H), 7,91 (d, J 5,5, 1 H), 8,11 (s, 1 H), 8,54 (br s, 1 H), 10,05 (s, 1 H).

### d) Herstellung von 4-(N-Phenylamino)-3-(N-methylamino)pyridin

Eine Lösung von 4-(N-Phenylamino)-3-(N-formylamino)pyridin (3,0 g, 14 mmol, 1 Äquivalent) in absolutem Tetrahydrofuran (20 ml) wird bei 0 °C vorsichtig mit Lithiumaluminiumhydrid (0,5 g, 14 mmol, 1 Äquivalent) versetzt. Die Mischung wird 6 Stunden unter Rückfluß gerührt. Nach Abkühlung auf Raumtemperatur wird die Mischung hydrolysiert, über Celite filtriert und zur Trockne eingeengt. Der Rückstand wird mit Dichlormethan extrahiert und das Lösungsmittel am Rotationsverdampfer entfernt. Das Rohprodukt wird säulenchromatographisch (Kieselgel, Essigsäureethylester/Cyclohexan 9:1) getrennt. Ausbeute: 1,0 g (5 mmol, 35%).

¹H-NMR (CDCl₃, 400 MHz): δ = 2,73 (d, J 5,0, 3H), 5,44 (br d, J 4,0, 1 H), 6,36 (br s, 1 H), 6,97 (d, J 5,5, 1H), 7,06-7,19 (m, 3H), 7,34 (dd, J 8,0, 7,5, 2H), 7,86 (d, J 5,5, 1 H), 8,04 (s, 1 H).

### e) Herstellung von 1-Phenyl-3-methyl-5-azabenzimidazolium-tetrafluoroborat

4-(N-Phenylamino)-3-(N-methylamino)pyridin (0,90 g, 4,5 mmol, 1 Äquivalent) und Ammoniumtetrafluoroborat (0,47 g, 4,5 mmol, 1 Äquivalent) werden mit Triethylorthoformiat (9,37 g, 63,2 mmol, 14 Äquivalent) versetzt und die Mischung wird 8 Stunden unter Rückfluss gerührt. Nach Abkühlung auf Raumtemperatur wird die Mischung einge-engt, mit Ethanol versetzt und das ausgefallene Produkt abfiltriert. Ausbeute: 0,70 g (2,3 mmol, 52%).

¹H-NMR (CD₂Cl₂, 400 MHz): δ = 4,03 (s, 3H), 7,12 (d, J 5,5, 1H), 7,20-7,32 (m, 3H), 7,44 (dd, J 8,0, 7,5, 2H), 7,98 (d, J 5,5, 1 H), 8,12 (s, 1 H), 9,60 (s, 1 H).

### f) Herstellung von Tris-[1-phenyl-3-methyl-5-azabenzimidazol -2-yliden-C²,C^{2'};]-iridium(III)

Die Herstellung des Carbenkomplexes erfolgte durch Umsetzung des in Schritt e) erhaltenen Imidazolium-Salzes mit [(µ-Cl)(η⁴-1,5-cod)Ir]₂ gemäß der oben genannten allgemeinen Methode. Man erhielt das Produkt als Isomerengemisch nach Eluieren mit Essigsäureethylester/Methanol 9:1 in einer Ausbeute von 10% der Theorie. ESI-MS (MeCN/H₂O 8:2): m/z = 817,9552 (M+H⁺, korrektes Isotopenmuster, ber.: 817,9569).

### Beispiel 5: Herstellung von mer-Tris-[1-(4'-cyano-3',5'-dimethylphenyl)-3-methylimidazol-2-yliden-C²,C^{2'}]-iridium(III)

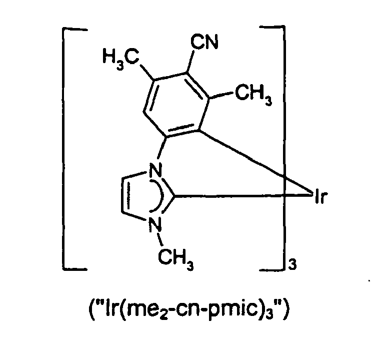

### a) Herstellung von 1-(4-Cyano-3,5-dimethyl-phenyl)-imidazol

4-Chlor-2,6-dimethylbenzonitril (5,15 g, 32 mmol) wurde in N-Methylpyrrolidon (50 ml) gelöst und unter Kühlung mit Imidazol (3,27 g, 48 mmol) sowie Natriumcarbonat (5,09 g, 48 mmol) versetzt und unter Rühren für 14 Stunden auf 133 °C erhitzt. Danach wurde graduell auf 170 °C erwärmt und über insgesamt 14 Stunden noch 3,50 g (32,2 mmol) Natriumcarbonat und 1,3 g (13,6 mmol) Imidazol zugegeben und anschließend noch 7 Stunden bei 170 °C gerührt. Das Reaktionsgemisch wurde anschließend auf Raumtemperatur abgekühlt und in Wasser (400 ml) gegeben. Das feste Produkt wurde abgesaugt und mit Methanol gewaschen. Es wurden 3,12 g 1-(4-Cyano3,5-dimethyl-phenyl)-imidazol erhalten.

¹H-NMR (400 MHz, CD₂Cl₂): δ = 2,63 (s, 6 H), 7,17 (s, 1 H), 7,21 (s, 2 H), 7,35 (dd, J = 1,4, 1,4 Hz, 1 H), 7,90 (s, 1 H).

### b) Herstellung von 1-(4-Cyano-3,5-dimethyl-phenyl)-3-methyl-imidazoliumiodid

1-(4-Cyano-3,5-dimethyl-phenyl)-imidazol (3,10 g, 19,3 mmol) und Methyliodid (13,7 g, 96,7 mmol) wurden in Tetrahydrofuran (50 ml) verrührt und zwei Tage bei Raumtemperatur stehen gelassen. Der gebildete Rückstand wurde abfiltriert, mit Tetrahydrofuran nachgewaschen und im Vakuum getrocknet.

¹H-NMR: (400 MHz, DMSO): δ = 2,58 (s, 6 H), 3,96 (s, 3 H), 7,80 (s, 2 H), 7,99 (dd, J = 1,7, 1,7 Hz, 1 H), 8,36 (dd, J = 1,7, 1,7 Hz, 1 H), 9,89 (s, 1 H).

### c) Herstellung von mer-Tris-[1-(4'-cyano-3',5'-dimethylphenyl)-3-methylimidazol-2-yliden-C²,C^{2'}]-iridium(III)

Die Herstellung des Carbenkomplexes erfolgte durch Umsetzung des in Schritt b) erhaltenen lmidazolium-Salzes mit [(µ-Cl)(η⁴-1,5-cod)Ir]₂ gemäß der oben genannten allgemeinen Methode. Man erhielt das Produkt nach Eluieren mit einem Methyl-tert-butylether-Essigsäureethylester-Gradienten in einer Ausbeute von 9% der Theorie.

¹H-NMR (CD₂Cl₂, 400 MHz): δ = 1,58 (s, 3H), 1,60 (s, 3H), 1,70 (s, 3H), 2,43 (s, 6H), 2,44 (s, 3H), 2,71 (s, 3H), 2,82 (s, 3H), 2,88 (s, 3H), 6,69 (d, J 2,0, 1H), 6,73 (d, J 2,0, 1 H), 6,75 (d, J 2,0, 1 H), 6,94 (s, 1 H), 6,96 (s, 1 H), 6,97 (s, 1H), 7,38 (d, J 2,0, 1 H), 7,42 (d, J 2,0, 1 H), 7,45 (d, J 2,0, 1 H).

ESI-MS (MeCN/H₂O 8:2): m/z = 824,2803 (M+H⁺, korrektes Isotopenmuster, ber.: 824,2796).

### Beispiel 6: Herstellung von Tris-[1-(2'-benzo[b]thiophenyl)-3-methylbenzimidazol-2-yliden-C²,C^{2'}]-iridium(III)

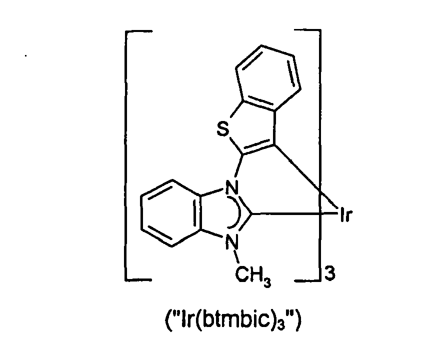

### a) Herstellung von 2-Brombenzo[b]thiophen (gemäß G. W. Stacy et al., J. Org. Chem. 1965, 30, 4074; b) R. M. Acheson, D. R. Harrison, J. Chem. Soc. C 1970, 1764)

Eine Lösung von Benzo[b]thiophen (75,1 g, 0,56 mol, 1 Äquivalent) in absolutem Diethylether (300 ml) wird unter Stickstoff bei -78 °C langsam mit n-Butyllithium (2,5 M in n-Hexan, 271 ml, 0,68 mol, 1,2 Äquivalent) versetzt. Die Lösung wird 30 Minuten bei -78 °C gerührt und anschließend wird bei 0 °C vorsichtig Brom (34,4 ml, 0,68 mol, 1,2 Äquivalent) zugetropft. Die Mischung wird 30 Minuten bei Raumtemperatur gerührt und mit 5%iger Natriumthiosulfat-Lösung versetzt. Nach Zugabe von Wasser wird die organische Phase abgetrennt und mit Wasser, 5%iger Natronlauge, 1 M Salzsäure, gesättigter Natriumhydrogencarbonat-Lösung und Wasser gewaschen. Die organische Phase wird über Natriumsulfat getrocknet und am Rotationsver-dampfer eingeengt. Das Rohprodukt wird durch Vakuumdestillation gereinigt. Ausbeute: 84,7 g (0,40 mol, 71%).

### ¹H-NMR (CD₂Cl₂, 400 MHz): δ = 7,25-7,33 (m, 2H), 7,28 (s, 1H), 7,62-7,72 (m, 2H).

### b) Herstellung von 1-(2'-Benzo[b]thiophenyl)benzimidazol

Eine Mischung von 2-Brombenzo[b]thiophen (50,0 g, 235 mmol, 1 Äquivalent), Benzimidazol (33,3 g, 282 mmol, 1,2 Äquivalent), Kaliumphosphat (96,6 g, 470 mmol, 2 Äquivalent), Kupfer(I)iodid (4,5 g, 24 mmol, 10 mol%) und trans-1,2-Diaminocyclohexan (5,7 ml, 47 mmol, 20 mol%) in absolutem Dioxan (450 ml) wird unter Argon 16 Stunden unter Rückfluss gerührt. Nach Abkühlung auf Raumtem-peratur wird die Mischung filtriert und das Filtrat zur Trockne eingeengt. Das Rohprodukt wird säulenchromatographisch (Kieselgel, Essigsäureethylester) gereinigt. Ausbeute: 4,9 g (20 mmol, 8%).

¹H-NMR (CD₂Cl₂, 400 MHz): δ = 7,33-7,48 (m, 5H), 7,71-7,74 (m, 1 H), 7,80-7,88 (m, 3H), 8,16 (s, 1 H).

### c) Herstellung von 1-(2'-Benzo[b]thiophenyl)-3-methylbenzimidazolium-iodid

Eine Lösung von 1-(2'-Benzo[b]thiophenyl)benzimidazol (4,7 g, 12 mmol, 1 Äquivalent) in Tetrahydrofuran (40 ml) wird unter Stickstoff mit Methyliodid (3,7 ml, 59 mmol, 5 Äquivalent) versetzt und 16 Stunden bei Raumtemperatur stehenge-lassen. Die Mischung wird in wenig Ethanol suspendiert und das Produkt wird abfiltriert. Ausbeute: 4,45 g (11 mmol, 95%).

¹H-NMR (d₆-DMSO, 400 MHz): δ = 4,19 (s, 3H), 7,56-7,61 (m, 2H), 7,76-7,86 (m, 2H), 8,02-8,10 (m, 2H), 8,06 (s, 1H), 8,16-8,22 (m, 2H), 10,27 (s, 1H).

### d) Herstellung von Tris-[1-(2'-benzo[b]thiophenyl)-3-methylbenzimidazol-2-yliden-C²,C^{2'}]-iridium(III)

Die Herstellung des Carbenkomplexes erfolgte durch Umsetzung des in Schritt c) erhaltenen Imidazolium-Salzes mit [(µ-Cl)(η⁴-1,5-cod)Ir]₂ gemäß der oben genannten allgemeinen Methode. Man erhielt das Produkt nach Eluieren mit Essigsäureethylester/Cyclohexan 9:1 in einer Ausbeute von 10% fac-Isomer und 68% Isomerengemisch mit einem fac/mer-Isomerenverhältnis von ca. 1:1.

Analytik fac-Isomer:

¹H-NMR (d₆-DMSO, 400 MHz): δ = 3,22 (s, 9H), 6,28 (d, J 8,0, 3H), 6,53 (ddd, J 7,5, 7,5, 1,0, 3H), 6,91 (ddd, J 7,5, 7,5, 1,0, 3H), 7,32 (ddd, J 8,0, 8,0, 1,0, 3H), 7,40 (ddd, J 8,0, 8,0, 1,0, 3H), 7,57 (d, J 8,0, 3H), 7,82 (d, J 8,0, 3H), 7,94 (d, J 8,0, 3H).

APCI-MS (MeCN): m/z = 981,1556 (M⁺, korrektes Isotopenmuster, ber.: 981,1613).

### Beispiel 7: Herstellung von mer-Tris-[1-(4'-pyridyl)-3-methylimidazol-2-yliden-C²,C^{2'}]-iridium(III)

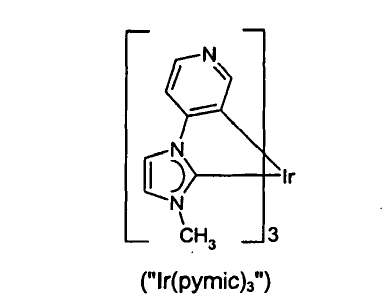

### a) Herstellung von 1-(4'-Pyridyl)-3-methylimidazolium-chlorid

4-Chlorpyridin-hydrochlorid (91,6 g, 0,61 mol) wird mit gesättigter Natriumhydrogencarbonat-Lösung versetzt und viermal mit Dichlormethan extrahiert. Die vereinigten organischen Phasen werden über Natriumsulfat getrocknet, filtriert und zur Trockne eingeengt. Das erhaltene Öl (52,7 g, 0,46 mol) wird mit Methylimidazol (38,1 g, 0,46 mol) versetzt und 6 Stunden bei 130 °C gerührt. Nach Abkühlung auf Raumtemperatur wird die Mischung in Ethanol gelöst und das Produkt durch Zugabe von n-Hexan ausgefällt. Ausbeute: 56,7 g (0,29 mol, 63%).

¹H-NMR (d₆-DMSO, 400 MHz): δ = 4,00 (s, 3H), 7,98 (dd, J 4,5, 1,5, 2H), 8,07 (m, 1H), 8,58 (m, 1 H), 8,86 (dd, J 4,5, 1,5, 2H), 10,42 (s, 1 H).

### b) Herstellung von mer-Tris-[1-(4'-pyridyl)-3-methylimidazol-2-yliden-C²,C^{2'}]-iridium(III)

Die Herstellung des Carbenkomplexes erfolgte durch Umsetzung des in Schritt a) erhaltenen Imidazolium-Salzes mit [(µ-Cl)(η⁴-1,5-cod)Ir]₂ gemäß der oben genannten allgemeinen Methode. Man erhielt das Produkt nach Eluieren mit Isobutanol in einer Ausbeute von 8% der Theorie.

¹H-NMR (CD₂Cl₂, 400 MHz): δ = 3,03 (s, 3H), 3,07 (s, 3H), 3,10 (s, 3H), 6,82-6,86 (m, 3H), 7,02-7,06 (m, 3H), 7,45 (d, J 2,0, 1 H), 7,51 (d, J 2,0, 1H), 7,54 (d, J 2,0, 1 H), 7,66 (d, J 0,5, 1 H), 7,80 (d, J 0,5, 1 H), 7,89 (d, J 0,5, 1 H), 8,04 (d, J 5,0, 1 H), 8,07 (d, J 5,0, 1 H), 8,08 (d, J 5,0, 1 H).

ESI-MS (MeCN/H₂O 8:2): m/z = 666,1844 (M+H⁺, korrektes Isotopenmuster, ber.: 666,1839).

### Beispiel 8: Herstellung von mer-Tris-[1-(4'-chlorphenyl)-3-methylimidazol-2-yliden-C²,C^{2'}]-iridium(III)

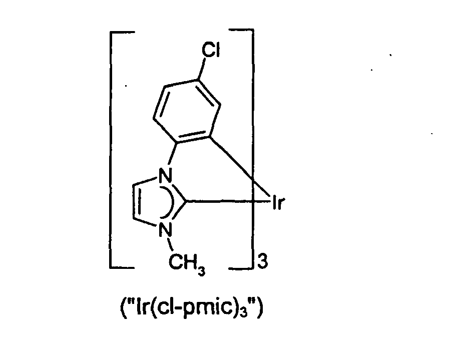

a) Herstellung von 1-(4-Chlorphenyl)imidazol (gemäß S. U. Son, I. K. Park, J. Park, T. Hyeon, Chem. Commun. 2004, 778)

1-Chlor-4-fluorbenzol (16,3 g, 124 mmol) und Imidazol (5,0 g, 73,4 mmol) wurden in N,N-Dimethylformamid (30 ml) gelöst und unter Rühren mit Natriumhydrid (60%ig in Mineralöl; 3,82 g, 95,4 mmol) versetzt und darauf 5 Stunden auf 130 °C erhitzt. Nach dem Abkühlen wurde das Reaktionsgemisch langsam auf Wasser gegeben. Der gebildete Niederschlag wurde anschließend abfiltriert, mit Petrolether gewaschen und anschließend im Vakuum getrocknet. Es wurden 10,3 g 1-(4-Chlorphenyl)imidazol erhalten.

¹H-NMR: (400 MHz, CD₂Cl₂): δ = 7,16 (brs, 1 H), 7,30 (dd, J = 1,2, 1,2 Hz,1 H), 7,38 (d, J = 7,7 Hz, 2 H), 7,48 (d, J = 7,7 Hz, 2 H), 7,82 (brs, 1 H).

### b) Herstellung von 1-(4-Chlorphenyl)-3-methyl-imidazoliumiodid

1-(4-Chlorphenyl)imidazol (0,37 g, 2,07 mmol) wurde in Tetrahydrofuran (5 ml) gelöst und anschließend mit Methyliodid (1,47 g, 10,4 mmol) versetzt und für 20 Stunden stehen gelassen. Der gebildete Niederschlag wurde anschließend abfiltriert und mit Ethanol sowie mit Petrolether gewaschen und anschließend im Vakuum getrocknet. Es wurden 0,46 g 1-(4-Chlorphenyl)-3-methyl-imidazoliumiodid erhalten.

¹H-NMR (400 MHz, DMSO): δ = 3,96 (s, 3 H), 7,76-7,84 (m, 4 H), 7,97 (dd, J = 1,8, 1,8 Hz, 1 H), 8,30 (dd, J = 1,8, 1,8 Hz, 1 H), 9,80 (brs, 1 H).

### c) Herstellung von mer-Tris-[1-(4'-chlorphenyl)-3-methylimidazol-2-yliden-C²,C^{2'}]-iridium(III)

Die Herstellung des Carbenkomplexes erfolgte durch Umsetzung des in Schritt b) erhaltenen Imidazolium-Salzes mit [(µ-Cl)(n⁴-1,5-cod)Ir]₂ gemäß der oben genannten allgemeinen Methode. Man erhielt das Produkt als weißes Pulver nach säulenchromatographischer Aufreinigung unterzogen in einer Ausbeute von 30% der Theorie.

¹H-NMR: (CD₂Cl₂, 500 MHz): δ = 7,43 (m, 2H), 7,38 (m, 1 H), 7,08 (m, 3H), 6,90 - 6,75 (m, 6H), 6,67 (m, 2H), 6,42 (m, 1 H) (je CH_{Ph} bzw. NCHCHN), 3,06 (s, 3H, NCH₃), 3,02 (s, 3H, NCH₃), 2,99 (s, 3H, NCH₃).

¹³C-NMR (CD₂Cl₂, 125 MHz): δ = 173,9, 172,1, 171,3 (NCN), 153,9, 152,7, 151,2, 147,1, 146,4, 145,7 (Cq), 138,5, 138,1, 136,6 (CH_{Ph} bzw. NCHCHN), 130,5, 130,3, 130,2 (Cq), 121,8, 121,6, 121,3, 120,5, 120,3, 120,1, 115,04, 114,99, 114,9, 112,00, 111,97, 111,5 (CH_{Ph} bzw. NCHCHN), 37,4 (doppelte Intensität), 36,2 (NCH₃).

### Beispiel 9: Herstellung von mer-Tris-[1-(4'-cyanophenyl)-3-(2'-propyl)-benzimidazol-2-yliden-C²,C²']-iridium(III)

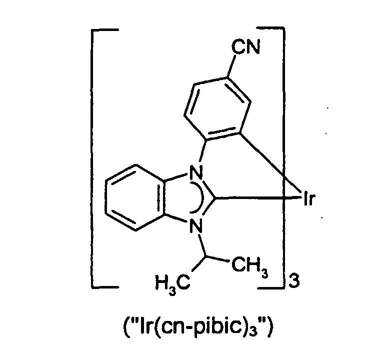

a) Herstellung von N-(2-Propyl)-2-nitroanilin (gemäß H. J. Altenbach et al., Tetrahedron Asymmetry 2002, 13, 137-144)

2-Nitroanilin (10,0 g, 72,4 mmol) wurde in einer Mischung aus Dichlormethan (60 ml) und Eisessig (10 ml) gelöst. Zu der resultierenden Lösung wurde unter Rühren Aceton (16 ml, 218 mmol) getropft und nach beendeter Zugabe noch weitere 5 Minuten gerührt. Darauf wurde bei 0 °C Boran-Dimethylsulfidkomplex (8,6 ml 10 M, 86 mmol) innerhalb von 40 Minuten. unter Rühren zugetropft. Darauf wurde das Eisbad entfernt und eine Stunde nachgerührt. Das Reaktionsgemisch wurde anschließend durch langsame Zugabe von Ammoniaklösung auf pH 8 eingestellt (ca. 16 ml). Die organische Phase wurde abgetrennt und die wässrige Phase mit zwei Portionen Dichlormethan extrahiert. Die organischen Phasen wurden vereinigt, über Natriumsulfat getrocknet und das Lösungsmittel darauf im Vakuum entfernt. Die Zielverbindung N-(2-Propyl)-2-nitroanilin) fiel auf diese Weise in guter Reinheit an und wurde ohne weitere Aufreinigung weiter umgesetzt.

¹H-NMR (400 MHz, CD₂Cl₂): δ = 1,30 (d, J = 6,4 Hz, 6 H), 3,82 (hept, J = 6,4 Hz, 1 H), 6,58 (ddd, J = 8,5, 7,0, 1,5 Hz, 1 H), 6,87 (d, J = 8,5 Hz, 1 H), 7,41 (ddd, J = 8,5, 7,0, 1,5 Hz), 7,97 (brs, 1 H), 8,10 (dd, J = 8,5, 1,8 Hz, 1 H)

b) Herstellung von N-(2-propyl)-1,2-phenylendiamin (gemäß H. J. Altenbach et al., Tetrahedron Asymmetry 2002, 13, 137-144)

2-Nitro-N-isopropylanilin (83,5 g, 463 mmol) wurde in Methanol (675 ml) gelöst und mit Palladium auf Aktivkohle (11,0 g, 5-10% Pd, Wassergehalt 53%) versetzt. Die Hydrierung erfolgte unter 1 bar H₂- Atmosphäre und schnellem Rühren bei 25-38 °C Innentemperatur. Die Reaktionsmischung verfärbte sich innerhalb von 2,5 Stunden von gelb nach farblos und wurde anschließend über Nacht unter Wasserstoffatmos-phäre weitergerührt. Anschließend wurde nach Entfernen des überschüssigen Wasserstoffs der Palladiumkatalysator abfiltriert und das Rohprodukt über eine kurze Säulenfiltration (Kieselgel, Methanol) gereinigt. Nach Entfernen des Lösungsmittels im Vakuum fiel das Produkt (69,55g, 463 mmol) als dunkles Öl an.

¹H-NMR (CDCl₃, 400 MHz): δ = 1,20 (d, J = 6,0 Hz, 6 H), 3,29 (brs, 3 H), 3,57 (hept, J = 6,0 Hz, 1 H), 6,62-6,70 (m, 3 H), 6,78-6,82 (m, 1 H).

### c) Herstellung von N-(4-Cyanophenyl)-N'-(2-propyl)-phenylendiamin

N-(2-propyl)-1,2-phenylendiamin (1,50 g, 10 mmol) und 4-Brombenzonitril (1,82 g, 10 mmol) wurden in Toluol (200 ml) gelöst und bei ca. 70 °C unter Rühren mit Tris(dibenzylidenaceton)dipalladium(0) (92 mg, 1 mol%), 9,9-Dimethyl-4,5-bis-(diphenylphosphino)xanthene (177 mg, 3 mol%), Natrium-tert-butylat (964 mg, 10 mmol) und Wasser (130 µl) versetzt und anschließend 16 Stunden bei 80 °C gerührt. Nach dem Abkühlen wurde das Reaktionsgemisch mit Wasser verdünnt, mit Essigsäureethylester extrahiert und nach Trocknen der organischen Phase vom Lösungsmittel im Vakuum befreit. Nach Chromatographie (Cyclohexan : Essigsäureethylester) erhielt man 1,46 g N-(4-Cyanophenyl)-N'-(2-propyl)-phenylendiamin.

¹H-NMR (400 MHz, CD₂Cl₂): δ = 1,55 (d, 6H, J = 6,4 Hz), 3,64 (sept, 1H, J = 6,3 Hz), 3,86 (s, breit, 1 H), 5,60 (s, breit, 1 H), 6,63-6,67 (m, 3H), 6,74 (d, 1H, J = 8,2 Hz), 7,07 (d, 1H, J = 6,4 Hz), 7,42 (d, 2H, J = 6,7 Hz).

### d) Herstellung von 1-(4-Cyanophenyl)-3-(2-propyl)-benzimidazolium-tetrafluoroborat

N-(4-Cyanophenyl)-N'-(2-propyl)-phenylendiamin (1,07 g, 4,25 mmol) und Ammoniumtetrafluoroborat (0,46 g, 4,25 mmol) wurden mit Triethylorthoformiat (8,83 g, 59,5 mmol) versetzt und das resultierende Gemisch 8 h unter Rückfluss erhitzt. Nach Abkühlen der Reaktionsmischung und Entfernen eines Teils des Lösungsmittels im Vakuum wurde die Lösung mit Ethanol versetzt und der ausgefallene Niederschlag abfiltriert und im Vakuum getrocknet. Es wurden 0,35 g 1-(4-Cyanophenyl)-3-(2-propyl)-benzimidazolium-tetrafluoroborat erhalten.

¹H-NMR (400 MHz, CD₂Cl₂): δ = 1,84 (d, 6H, J = 6,7 Hz), 5,09 (sept, 1 H, J = 6,7 Hz), 7,72-7,81 (m, 3H), 7,92-7,95 (m, 3H), 8,00 (d, 2H, J = 8,1 Hz), 9,60 (s, 1H).

### e) Herstellung von mer-Tris-[1-(4'-cyanophenyl)-3-(2'-propyl)-benzimidazol-2-yliden-C²,C^{2'}]-iridium(III)

Die Herstellung des Carbenkomplexes erfolgte durch Umsetzung des in Schritt d) erhaltenen Imidazolium-Salzes mit [(µ-Cl)(η⁴-1,5-cod)Ir]₂ gemäß der oben genannten allgemeinen Methode. Man erhielt das Produkt als hellgelbes Pulver nach säulenchromatographischer Aufreinigung in einer Ausbeute von 28% der Theorie.

¹H-NMR: (CD₂Cl₂, 500 MHz): δ = 8,16 (m, 3H, CH_{Ph}), 7,96 (m, 2H, CH_{Ph}), 7,90 (d, ³J_{H,H} = 8,3 Hz, 1H, CH_{Ph}), 7,54 (m, 3H, CH_{Ph}), 7,36 (m, 8H, CH_{Ph}), 7,18 (s, 1H, CH_{Ph}), 6,96 (s, 1 H, CH_{Ph}), 6,90 (s, 1 H, CH_{Ph}), 6,85 (s, 1 H, CH_{Ph}), 4,60 (m, 2H, CH_{iPr}), 4,46 (m, 1 H, CH_{iPr}), 1,64 (d, ³J_{H,H} = 7,1 Hz, 3H, CH₃), 1,36 (d, ³J_{H,H} = 7,1 Hz, 3H, CH₃), 1,31 (d, ³J_{H,H} = 7,1 Hz, 3H, CH₃), 0,84 (d, ³J_{H,H} = 7,1 Hz, 3H, CH₃), 0,65 (d, ³J_{H,H} = 6,9 Hz, 3H, CH₃), 0,59 (d, ³J_{H,H} = 7,1 Hz, 3H, CH₃).

¹³C-NMR (CD₂Cl₂, 125 MHz): δ = 186,9, 184,5, 183,0 (NCN), 153,2, 152,6, 152,0, 150,5, 150,4, 148,4 (C_{q}), 141,5, 140,3, 140,0 (CH_{Ph}), 133,9, 133,88, 133,83, 133,77, 133,71, 133,6 (C_{q}), 127,1, 127,0, 126,6, 125,8, 124,1, 124,0, 123,3, 123,25, 123,0 (CH_{Ph}), 120,7, 120,5, 120,47 (C_{q}), 113,3, 113,27, 113,2, 113,12, 113,08, 112,7, 112,67, 112,4 , 112,0 (CH_{Ph}), 108,6, 108,2, 108,1 (Cq), 54,4, 52,6, 52,4 (CH_{iPr}), 21,5, 20,7, 20,5, 20,4, 20,3, 20,1 (CH₃).

### Beispiel 10: Herstellung von mer-Tris-[1-(4'-cyanophenyl)-3-methyl-4-tert-butylimidazol-2-yliden-C²,C^{2'}]-iridium(III)

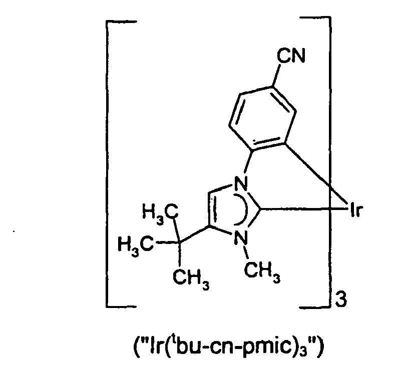

### a) Herstellung von 1-(4-Cyanophenyl)-4-(1,1-dimethylethyl)imidazol

4-(1,1-Dimethylethyl)imidazol (hergestellt gemäß Chem. Ber. 1997, 130, 1201-1212) (40,6 g, 327 mmol) und 4-Fluorbenzonitril wurden in N,N-Dimethylformamid (700 ml) gelöst und die Lösung anschließend unter Eiskühlung mit Natriumhydrid (60%ig in Mineralöl; 16,4 g, 409 mmol) versetzt. Die Reaktionslösung wurde darauf 16 Stunden bei Raumtemperatur gerührt und anschließend unter Rühren 4 Stunden auf 100 °C erhitzt. Nach dem Abkühlen wurde das Reaktionsgemisch auf Eiswasser gegeben und 3 mal gegen Methylenchlorid extrahiert. Das Lösungsmittel wurde entfernt, der Rückstand erneut in etwas Methylenchlorid gelöst und mit Petrolether gefällt. Der Rückstand wurde abfiltriert und im Vakuum getrocknet. Es wurden 48,5 g 1-(4-Cyanophenyl)-4-(1,1-dimethylethyl)imidazol erhalten.

¹H-NMR (400 MHz, CDCl₃): δ = 1,34 (s, 9 H), 7,03 (s, 1 H), 7,51 (d, J = 8,5 Hz, 2 H), 7,79 (d, J = 8,5 z, 2 H), 7,88 (s, 1 H).

### b) Herstellung von 1-(4-Cyanophenyl)-3-methyl-4-(1,1-dimethylethyl)imidazolium-iodid

48,5 g 1-(4-Cyanophenyl)-4-(1,1-dimethylethyl)imidazol wurden in Tetrahydrofuran (300 ml) gelöst und mit Methyliodid (152,6 g, 1,08 mol) versetzt. Man ließ die Lösung für zwei Tage bei Raumtemperatur reagieren. Anschließend wurde der gebildete Niederschlag abfiltriert, mit Ethanol gewaschen und im Vakuum getrocknet. Es wurden 59,9 g 1-(4-Cyanophenyl)-3-methyl-4-(1,1-dimethylethyl)imidazoliumiodid erhalten.

¹H-NMR (400 MHz, DMSO): δ = 1,42 (s, 9 H), 4,04 (s, 3 H), 8,03 (d, J = 8,8 Hz, 2 H), 8,18 (d, J = 2,2 Hz, 1 H), 8,21 (d, J = 8,8 Hz, 2 H), 9,84 (d, J = 2,2 Hz, 1 H).

### c) Herstellung von mer-Tris-[1-(4'-cyanophenyl)-3-methyl-4-tert-butylimidazol-2-yliden-C²,C^{2'}]-iridium(III)

Die Herstellung des Carbenkomplexes erfolgte durch Umsetzung des in Schritt b) erhaltenen Imidazolium-Salzes mit [(µ-Cl)(η⁴-1,5-cod)Ir]₂ gemäß der oben genannten allgemeinen Methode. Man erhielt das Produkt als gelbes Pulver nach säulenchromatographischer Aufreinigung in einer Ausbeute von 57% der Theorie.

¹H-NMR: (CD₂Cl₂, 500 MHz): δ = 7,18 -7,00 (m, 9H), 6,82 (m, 2H), 6,54 (m, 1 H) (je CH_{Ph} bzw. NCHCN), 3,11 (s, 3H, NCH₃), 3,08 (s, 3H, NCH₃), 3,03 (s, 3H, NCH₃), 1,30 (s, 9 H, CH_{3, tBu}), 1,29 (s, 9 H, CH_{3, tBu}), 1,25 (s, 9 H, CH_{3, tBu}).

¹³C-NMR (CD₂Cl₂, 125 MHz): δ = 175,2, 174,7, 172,8 (NCN), 150,9, 150,2, 149,6, 149,5, 149,4, 147,9, 141,8, 141,7, 141,1 (Cq), 140,8, 140,7, 139,0, 125,0, 124,8, 124,6 (CH_{Ph} bzw. NCHCN), 120,0, 119,92, 119,86 (Cq bzw. CN), 110,41, 110,39, 110,0, 109,7, 109,6, 109,2 (CH_{Ph} bzw. NCHCN), 107,2, 106,8, 106,4 (Cq bzw. CN), 36,4, 36,3, 34,4 (NCH₃), 30,5, 30,42, 30,39 (Cq, _{tBu}), 28,4 (CH_{3, tBu}).

### Beispiel 1 1:Herstellung von mer-Tris-[1-phenyl-3-(2'-propyl)-benzimidazol-2-yliden-C²,C^{2'}]-iridium(III)

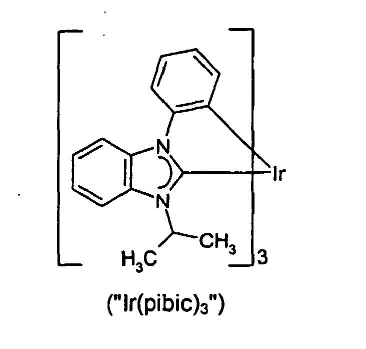

### a) Herstellung von N-Phenyl-N'-(2-propyl)-phenylendiamin

In einem Vierhalskolben mit Magnetfisch, Kühler wurde unter Stickstoff 1 Äquivalent. 3,00 g (16,4 mmol) 2-Aminodiphenylamin in Diethylether (ca. 1 mol/l) vorgelegt. Die rötliche Lösung wurde mit einem Eisbad gekühlt und man tropfte dann bei 10 °C 180 ml konzentrierte Salzsäure pro Mol 2-Aminodiphenylamin zu. Dabei fiel ein weißer Niederschlag aus. Der Ansatz wurde über eine Nutsche mit Filter abgesaugt. Den Rückstand wusch man mit Diethylether und trocknet ihn bei 50 °C über Nacht im Vakuum. Das erhaltene Hydrochlorid wurde ohne weitere Aufreinigung eingesetzt. In einem 50 ml Kolben mit Magnetfisch wurden 4,19 g (19,2 mmol) 2-Aminodiphenylamin Hydrochlorid in 25 ml Methanol gelöst. Zu dieser, mit Eisbad gekühlten, rötlichen Lösung gab man 1,66 g (28,7 mmol) Aceton und 2,17 g (57,5 mmol) Natriumborhydrid. Dabei schäumte die Lösung heftig und wurde zur grünlichen Suspension. Diese ließ man über das Wochenende bei Raumtemperatur rühren. Der Ansatz wurde auf Wasser gegeben und gegen Methylenchlorid extrahiert. Die organische Phase wurde mit Natriumsulfat getrocknet und im Vakuum vom Lösungsmittel befreit. Das Produkt wurde säulenchromatographisch aufgereinigt (Petrolether:Essigsäureethylester).

¹H-NMR (400 MHz, CDCl₃): δ = 1,18 (d, 6H, J = 6,4 Hz), 3,64 (sept., 1H, J = 6,5 Hz), 3,96 (s, breit, 1 H), 5,01 (s, breit, 1 H), 6,65 (dt, 1H, J = 7,5 Hz, J = 1,0 Hz), 6,69-6,74 (m, 3H), 6,81 (t, 1 H, J = 7,4 Hz), 7,10 (t, 2H, J = 7,9 Hz), 7,19 (t, 2H, J = 7,4 Hz).

### b) Herstellung von 1-Phenyl-3-(2-propyl)-benzimidazolium-tetrafluoroborat

N-Phenyl-N'-(2-propyl)-phenylendiamin (1,82 g, 8,0 mmol) wurde in Triethylorthoformiat (16,6 g, 112 mmol) gelöst und mit Ammoniumtetrafluoroborat (0,84 g, 8,0 mmol) versetzt und 8 Stunden unter Rückfluss erhitzt. Nach Abkühlen auf Raumtemperatur wurde der erhaltene Rückstand abfiltriert, mit Triethylorthoformiat gewaschen und im Vakuum getrocknet. Man erhielt 1,95 g 1-Phenyl-3-(2-propyl)-benzimidazolium-tetrafluoroborat.

1 H-NMR (CDCl₃, 400 MHz): δ = 1,86 (d, 6H, J = 6,8 Hz), 5,14 (sept, 1 H, J = 6,6 Hz), 7,63-7,77 (m, 8H), 7,84 (d, 1H, J = 9,4 Hz), 9,63 (s, 1 H).

### c) Herstellung von mer-Tris-[1-phenyl-3-(2'-propyl)-benzimidazol-2-yliden-C²,C^{2'}]-iridium(III)

Die Herstellung des Carbenkomplexes erfolgte durch Umsetzung des in Schritt b) erhaltenen Imidazolium-Salzes mit [(µ-Cl)(η⁴-1,5-cod)Ir]₂ gemäß der oben genannten allgemeinen Methode. Man erhielt das Produkt als weisses Pulver nach säulenchromatographischer Aufreinigung in einer Ausbeute von 83% der Theorie.

¹H-NMR: (CD₂Cl₂, 500 MHz): δ = 8,16 (m, 3H, CH_{Ph}), 7,86 (d, ³J_{H,H} = 7,9 Hz, 1 H, CH_{Ph}), 7,79 (d, ³J_{H,H} = 8,0 Hz, 2H, CH_{Ph}), 7,45 (m, 3H, CH_{Ph}), 7,28 (m, 3H, CH_{Ph}), 7,18 (m, 3H, CH_{Ph}), 6,95 (m, 4H, CH_{Ph}), 6,67 (m, 1H, CH_{Ph}), 6,60 (m, 4H, CH_{Ph}), 4,81 (m, 1H, CH_{iPr}), 4,75 (m, 1H, CH_{iPr}), 4,67 (m, 1H, CH_{iPr}), 1,60 (d, ³J_{H,H} = 7,0 Hz, 3H, CH₃), 1,30 (d, ³J_{H,H} = 7,0 Hz, 3H, CH₃), 1,22 (d, ³J_{H,H} = 7,2 Hz, 3H, CH₃), 0,82 (d, ³J_{H,H} = 7,0 Hz, 3H, CH₃), 0,61 (d, ³J_{H,H} = 7,0 Hz, 3H, CH₃), 0,55 (d, ³J_{H,H} = 7,3 Hz, 3H, CH₃).

¹³C-NMR (CD₂Cl₂, 125 MHz): δ = 189,1, 185,8, 184,7 (NCN), 151,7, 150,7, 149,8, 149,1, 148,5, 148,4 (C_{q}), 139,1, 137,5, 137,1 (CH_{Ph}), 134,0, 133,87, 133,86, 133,79, 133,77, 133,32 (C_{q}), 124,8, 124,5, 124,2, 122,64, 122,59, 122,58, 121,59, 121,56, 121,4, 120,9, 120,5, 120,3, 112,9, 112,7, 112,4, 112,3, 112,1 (doppelte Intensität), 111,8, 111,7, 111,4 (CH_{Ph}), 53,5, 51,7, 51,6 (CH_{iPr}), 21,0, 20,5, 20,2, 20,1, 20,0, 19,9 (CH₃).

### Beispiel 12: Herstellung des Iridium-Carbenkomplexes

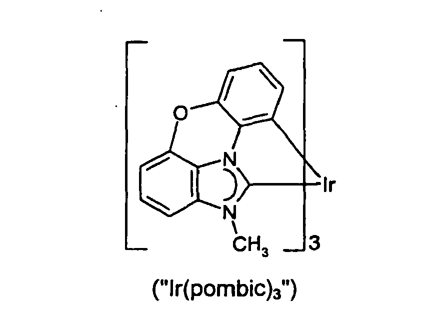

a) Herstellung von 2-[(2,6-Dinitrophenyl)amino]-phenol (gemäß F. Ullmann, G. Engi, N. Wosnessenky, E. Kuhn und E. Herre, Liebigs Ann. 365 (1909) 79, 110)

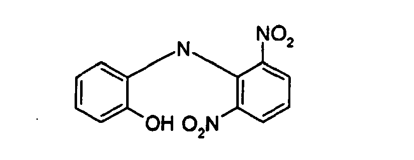

Zu einer Lösung von 25,0 g (121 mmol) 98 %igem 2,6-Dinitrochlorbenzol in 185 ml wasserfreiem Ethanol wurden unter Rühren und Stickstoff 17,30 g (157 mmol) 99 %i-ges 2-Aminophenol und 17,15 g (209 mmol) wasserfreies Natriumacetat gegeben. Die Reaktionslösung wurde 2 Stunden lang unter Rückfluss zum Sieden erhitzt und anschließend auf Raumtemperatur gekühlt. Die rotvioletten Kristallnadeln wurden über ein Schwarzbandfilter abgetrennt, mit Wasser bis zu einem farblosen Ablauf gewaschen und bei 50 °C im Vakuum getrocknet. Es wurden 27,90 g (84 % d. Th.) schwarz glänzende Nadeln erhalten, die bei 189 -192 °C (Lit.: 191 °C) schmolzen.

b) Herstellung von 4-Nitrophenoxazin (gemäß F. Ullmann, G. Engi, N. Wosnessenky, E. Kuhn und E. Herre, Liebigs Ann. 365 (1909) 79, 110)

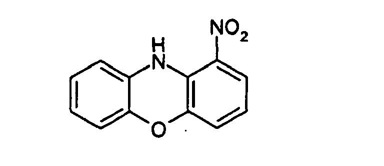

27,70 g (101 mmol) 2-[(2,6-Dinitrophenyl)amino]-phenol wurden in 666 ml 1 %iger Na-OH 30 Minuten lang unter Rückfluss und Rühren erhitzt. Nach dem Abkühlen auf Raumtemperatur wurde der Feststoff abgesaugt, mit heißem Wasser neutral gewaschen und bei 80 °C im Vakuum getrocknet. Es wurden 21,2 g (92 % d. Th.) schwarze Kristalle erhalten, die bei 168 - 171 °C (Lit.: 166 °C) schmolzen.

c) Herstellung von 1-Ammoniumphenoxazinchlorid (gemäß F. Kehrmann und L. Löwy, Ber. dtsch. chem. Ges. 44 (1911) 3006 - 3011)

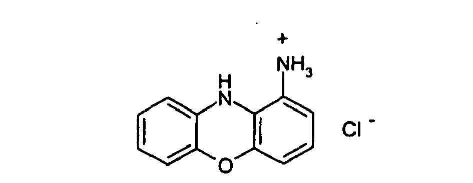

21,20 g (92,9 mmol) 1-Nitrophenoxazin wurden in 177 ml wasserfreiem Ethanol suspendiert und mit einer Lösung von 83,84 g (372 mmol) Zinn(II)-chlorid x 2 H₂O in 101 ml konz. HCl versetzt. Die Reaktionsmischung wurde 1 Stunde lang unter Rückfluss zum Sieden erhitzt. Nach dem Abkühlen der Reaktionsmischung auf Raumtemperatur wurde der Niederschlag abgesaugt, viermal mit insgesamt 430 ml 10 % HCl, dann mit kaltem Wasser gewaschen und bei 70 °C im Vakuum getrocknet. Es wurden 18,45 g graue Nadeln erhalten.

d) Herstellung von 2,10b-Diaza-6-oxa-aceanthrylen (Imidazo[4,5,1-k,l]phenoxazin; in Anlehnung an H. Shirai und T. Hayazaki, Yakugaku Zasshi 90 (1970) 588 - 593 und A. N. Gritsenko, Z. I. Ermakova, V. S. Troitskaya und S. V. Zhuravlev., Chem. Heterocycl. Compd. 1971, 715 - 717)

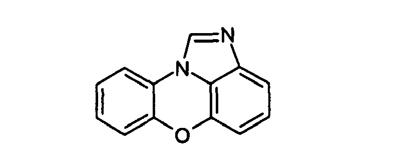

18,45g (78,6 mmol) 1-Ammoniumphenoxazinchlorid wurden in 85 ml 85 %ige Ameisensäure suspendiert. Nach der Zugabe von 5,38 g (78,6 mmol) Natriumformiat wurde die Reaktionsmischung 3,5 Stunden lang unter Rückfluss zum Sieden erhitzt. Nach dem Abkühlen auf Raumtemperatur wurde die Reaktionsmischung in 700 g 10 % Na-OH gefällt und noch 30 Minuten nachgerührt. Der Feststoff wurde über einen Schwarzbandfilter abgesaugt, mit Wasser gewaschen und bei 70°C im Vakuum getrocknet. Das Rohprodukt (16,35 g) wurde in 160 ml Methanol 2 Stunden lang gerührt, anschließend abgesaugt, mit Methanol gewaschen und bei 70 °C getrocknet. Es wurden 13,09 g (80 % d. Th.) graue Nadeln erhalten, die bei 177 - 181 °C (Lit.: 177 - 178°C) schmolzen.

e) Herstellung von 10b-Aza-2-azonia-2-methyl-6-oxa-aceanthrylen-iodid (2-Methylimidazo[4,5,1-k,l]phenoxazoniumiodid; in Anlehnung an H. Shirai und T. Hayazaki, Yakugaku Zasshi 90 (1970) 588 - 593)

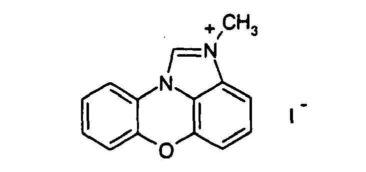

Eine Lösung von 5,48 g (26,3 mmol) 2,10b-Diaza-6-oxa-aceanthrylen und 18,42 g (130 mmol) Methyliodid in 75 ml Methylenchlorid wurden 26 Stunden unter Rückfluss zum Sieden erhitzt. Nach dem Abkühlen der Reaktionsmischung auf Raumtemperatur wurde der Feststoff abgesaugt, mit Methylenchlorid gewaschen und bei 75°C im Vakuum getrocknet. Es wurden 8,35 g (91 % d.Th.) analysenreine graue Mikrokristalle erhalten, die bei 284 - 291 °C (Lit.: 295 - 297°C) schmolzen.

### f) Herstellung von 10b-Aza-2-azonia-2-methyl-6-oxa-aceanthrylen-tetrafluoroborat (2-Methylimidazo[4,5,1-k,l]phenoxazoniumtetrafluoroborat)

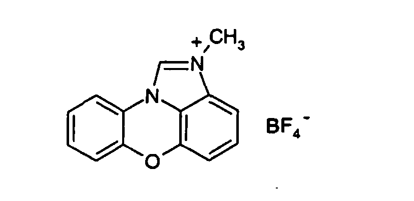

Zu einer im Eisbad auf 0 - 3°C gekühlten Lösung aus 10,41 g (50,0 mmol) 2,10b-Diaza-6-oxa-aceanthrylen in 620 ml wasserfreiem Methylenchlorid wurden 7,55 g (50,0 mmol) 98 %iges Trimethyloxoniumtetrafluoroborat gegeben. Man ließ die Reaktionsmischung auf Raumtemperatur erwärmen und über Nacht nachrühren. Es wurden 0,755 g (5,0 mmol) 98 %iges Trimethyloxoniumtetrafluoroborat nachgegeben. Nach 4 stündigem Rühren bei Raumtemperatur wurde der Niederschlag abgesaugt, mit Methylenchlorid gewaschen und bei 40°C im Vakuum getrocknet (Rohausbeute: 11,35 g). Der Feststoff wurde aus 1000 ml Methanol unter Stickstoff umkristallisiert. Es wurden 8,90 g analysenreine dunkelgraue Mikrokristalle mit einem Schmp. von 230 - 238°C erhalten. Das Filtrat wurde zur Trockne eingeengt. Der Feststoff (3,39 g) wurde aus 132 ml Methanol umkristallisiert. Es wurden noch 1,42 g dunkelgraue Mikrokristalle erhalten, insgesamt also 10,32 g (67 % d.Th.).

¹H-NMR (500 MHz, DMSO): δ = 4,10 (s, 3 H), 7,18 (d, 1H), 7,37-7,61 (m, 5H), 7,93 (d, 1H), 10,25 (s, 1 H).

### g) Herstellung von Ir(pombic)₃

Die Herstellung des Carbenkomplexes erfolgte durch Umsetzung des in Schritt f) erhaltenen lmidazolium-Salzes mit [(µ-Cl)(η⁴-1,5-cod)Ir]₂ gemäß der oben genannten allgemeinen Methode in Xylol. Man erhielt das mer-Isomere als gelbliches Pulver nach säulenchromatographischer Aufreinigung in einer Ausbeute von 21% der Theorie.

¹H-NMR: (CD₂Cl₂, 500 MHz): δ = 6,99 (m, 3H, CH_{Ph}), 6,78 (m, 3H, CH_{Ph}), 6,63 (m, 8H, CH_{Ph}), 6,52 (m, 3H, CH_{Ph}), 6,41 (m, 1H, CH_{Ph}), 3,47 (s, 3H, CH₃), 3,45 (s, 3H, CH₃), 3,33 (s, 3H, CH₃).

¹³C-NMR (CD₂Cl₂, 125 MHz): δ = 170,18, 168,16, 166,87 (NCN), 145,08, 144,61, 144,42, 144,34, 144,01, 143,49, 143,45, 143,44, 142,31, 136,29 (C_{q}), 136,25 (CH_{Ph}), 136,18, 135,98 (C_{q}), 135,79, 133,76 (CH_{Ph}), 131,92, 131,24, 130,51 (C_{q}), 126,61, 126,48, 126,43, 125,51, 125,34, 125,28 (CH_{Ph}), 124.03, 124,01, 123,92 (C_{q}), 109,86, 109,79, 109,47, 106,46, 106,32, 106,27, 105,50, 105,49, 105,46 (CH_{Ph}), 33,98, 33,64, 33,55 (CH₃).

### Beispiel 13: Herstellung des Iridium-Carbenkomplexes

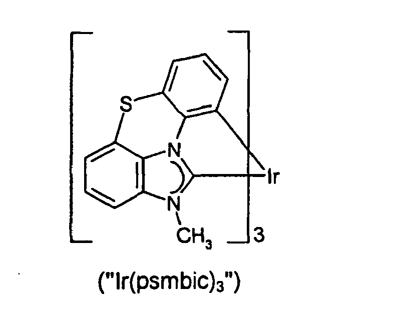

a) Herstellung von 1-Nitrophenothiazin (bis auf das verwendete Lösungsmittel gemäß H. L. Sharma et al., Tetrahedron Lett. 1657 - 1662, 1967)

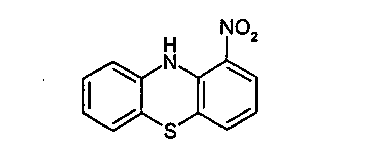

Zu einer Lösung von 20,7 g (0,10 mol) 98 %igem 2,6-Dinitrochlorbenzol in 300 ml wasserfreiem Dimethylformamid wurden unter Stickstoff 19,2 g (0,15 mol) 98 %igem 2-Mercaptoanilin und 41,0 g (0,50 mol) wasserfreies Natriumacetat gegeben. Die Reaktionslösung wurde 12 Stunden lang unter Rückfluss zum Sieden erhitzt und anschließend auf Raumtemperatur gekühlt. Der gebildete Niederschlag wurde abgesaugt, mit Wasser, 10 % HCl und 50 % eiskaltem Ethanol gewaschen und bei 40°C im Vakuum getrocknet. Es wurden 4,09 g Feststoff erhalten. Die Mutterlauge wurde zur Trockene eingeengt. Der Rückstand wurde mit Wasser gewaschen und im Vakuum getrocknet (19,50 g). Laut Dünnschichtchromatographie enthielten beide Feststoffe das gewünschte Produkt in hoher Reinheit, so dass beide Feststoffe vereinigt wurden. Rohausbeute: 23,6 g (97 % d. Th.)

b) Herstellung von 1-Ammoniumphenothiazinchlorid (analog zur Herstellung für 1-Aminophenoxazin in F. Kehrmann und L. Löwy, Ber. dtsch. chem. Ges. 44 (1911) 3006 - 3011)

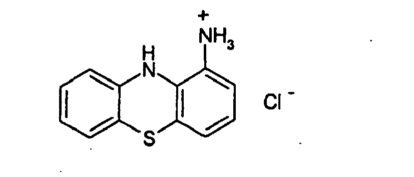

23,6 g (96,6 mmol) 1-Nitrophenothiazin wurden in 200 ml absolutem Ethanol suspendiert und mit einer Lösung von 87,2 g (387 mmol) Zinn(II)-chlorid x 2 H₂O in 100 ml konz. HCl versetzt. Die Reaktionsmischung wurde unter Rückfluss zum Sieden solange erhitzt, bis der Feststoff der Nitroverbindung verschwunden war und sich statt dessen ein heller Niederschlag abgeschieden hatte. Nach dem Abkühlen der Reaktionsmischung wurde der Niederschlag abgesaugt, mit Wasser gewaschen und im Vakuum getrocknet. Rohausbeute: 18,3 g (76 % d. Th.)

### c) Herstellung von 6-Thia-2,10b-diaza-aceanthrylen (Imidazo[4,5,1-k,l]phenothiazin; in Anlehnung an A. N. Gritsenko et al., Chem. Heterocycl. Compd. 1971, 715-717.)

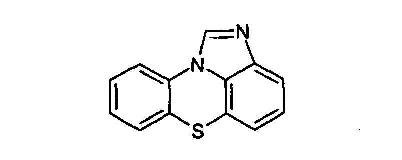

18,3 g (73,0 mmol) 1-Ammoniumphenothiazinchlorid wurden 80 ml 85 %ige Ameisensäure suspendiert. Nach der Zugabe von 5,81 g (85 mmol) Natriumformiat wurde die Reaktionsmischung 4 Stunden lang unter Rückfluss zum Sieden erhitzt. Nach dem Abkühlen auf Raumtemperatur wurde der Niederschlag abgesaugt, mit Wasser gewaschen und im Vakuum getrocknet. Rohausbeute: 14,1 g (86 % d. Th.)

### d) Herstellung von 2-Methyl-6-thia-10b-aza-2-azonia-aceanthrylen-tetrafluoroborat

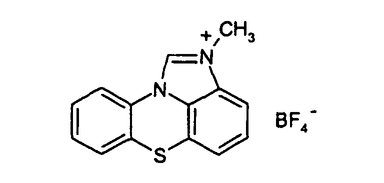

Die Methylierung von 6-Thia-2,10b-diaza-aceanthrylen mit Methyliodid wurde von Z. I. Ermakova et al., Chem. Heterocycl. Compd. 1974, 324 - 326 beschrieben.

Zu einer im Eisbad auf 3°C gekühlten Lösung aus 12,43 g (55,0 mmol) 6-Thia-2,10b-diaza-aceanthrylen in 800 ml wasserfreiem Methylenchlorid wurden 8,41 g (55,0 mmol) 98 %iges Trimethyloxoniumtetrafluoroborat gegeben. Man ließ die Reaktionsmischung auf Raumtemperatur erwärmen und über Nacht nachrühren. Der Niederschlag wurde abgesaugt, mit Methylenchlorid gewaschen und bei 40 °C im Vakuum getrocknet (Rohausbeute: 12,37 g). Der Feststoff wurde zweimal aus 200 bzw. 175 ml Essigsäure umkristallisiert. Es wurden 7,24 g (40 % d. Th.) hellbeigefarbene Mikrokristalle mit einem Schmp. von 223 - 224°C erhalten.

### e) Herstellung von Ir(psmbic)₃

Die Herstellung des Carbenkomplexes erfolgte durch Umsetzung des in Schritt d) erhaltenen lmidazolium-Salzes mit [(µ-Cl)(η⁴-1,5-cod)Ir]₂ gemäß der oben genannten allgemeinen Methode. Man erhielt das mer-Isomere als gelbliches Pulver nach säulenchromatographischer Aufreinigung in einer Ausbeute von 29% der Theorie.

¹H-NMR: (CD₂Cl₂, 500 MHz): δ = 6,99 (m, 3H, CH_{Ph}), 6,78-6,52 (m, 14H, CH_{Ph}), 6,42 (m, 1H, CH_{Ph}), 3,36 (s, 3H, CH₃), 3,29 (s, 3H, CH₃), 3,25 (s, 3H, CH₃).

¹³C-NMR: (CD₂Cl₂, 125 MHz): δ = 177,7, 175,3, 174,6 (NCN), 147,4, 145,7, 144,1 (C_{q}), 139,0 (C_{q}), 138,5 (CH), 138,3 (C_{q}), 138,2 (CH), 137,5 (C_{q}), 136,3 (CH), 134,5, 134,4, 133,9, 129,5, 129,4, 129,3 (C_{q}), 125,0, 124,9, 124,8 (CH), 120,3, 120,29, 120,1 (C_{q}), 119,2, 118,9, 118,7 (CH), 117,1, 116,7, 116,4 (C_{q}), 116,4, 116,38, 116,31, 107,05, 107,03, 106,99 (CH), 33,8, 33,6, 33,0 (CH₃).

### Beispiel 14: Herstellung von [1-(4'-cyanophenyl)-3-methylimidazol-2-yliden-C²,C^{2'}]-platin(II)-acetylacetonat

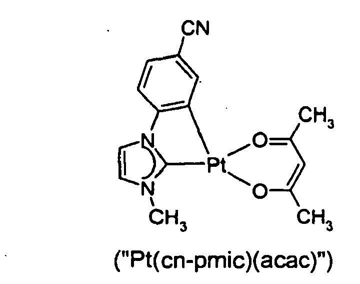

### a) Herstellung von 1-(2-Brom-4-cyanophenyl)-imidazol

3-Brom-4-fluorbenzonitril (10,0 g, 50 mmol, 1 Äquivalent) und Imidazol (5,1 g, 75 mmol, 1,5 Äquivalent) werden in Dimethylformamid (100 ml) gelöst und unter Stickstoff bei Raumtemperatur vorsichtig mit Natriumhydrid (60% in Mineralöl, 3,0 g, 75 mmol, 1,5 Äquivalent) versetzt. Die Mischung wird 4 h bei 100°C gerührt. Nach Abkühlung auf Raumtemperatur wird Wasser (10 ml) zugegeben und zur Trockne eingeengt. Der Rückstand wird mit Wasser und Petrolether gewaschen und säulenchromatographisch (Kieselgel, Methyl-tert-butylether-Essigsäureethylester-Gradient) gereinigt. Ausbeute: 5,4 g (22 mmol, 44%).

¹H-NMR (CD₂Cl₂, 400 MHz): δ = 7,15 (m_{c}, 1 H), 7,52 (m_{c}, 1 H), 7,74 (d, J 8,0, 1 H), 7,99 (m_{c}, 1 H), 8,06 (dd, J 8,0, 2,0, 1H), 8,48 (d, J 2,0, 1 H).

### b) Herstellung von 1-(2-Brom-4-cyanophenyl)-3-methylimidazolium-iodid

1-(2-Brom-4-cyanophenyl)-imidazol (5,4 g, 22 mmol, 1 Äquivalent) und Methyliodid (15,4 g, 109,0 mmol, 5 Äquivalent) werden in Tetrahydrofuran (50 ml) gelöst und 16 Stunden bei Raumtemperatur gerührt. Der gebildete Niederschlag wird abfiltriert und mit Ethanol gewaschen. Ausbeute: 6,7 g (17 mmol, 78%).

¹H-NMR (d₆-DMSO/CD₂Cl₂ 1:1, 400 MHz): δ = 4,17 (s, 3H), 7,77 (t, J 2,0, 1H), 7,90 (t, J 2,0, 1 H), 7,96 (dd, J 8,0, 2,0, 1 H), 8,16 (d, J 8,0, 1H), 8,20 (d, J 2,0, 1H), 9,96 (s, 1H).

### c) Herstellung von Pt(cn-pmic)(acac)

Eine Suspension von einem Äquivalent 1-(2-Brom-4-cyanophenyl)-3-methylimidazolium-iodid in Dioxan wird unter Argon langsam mit einem Äquivalent Kalium-bis(trimethylsilyl)amid (0,5 molar in Toluol) versetzt und 30 Minuten bei Raumtemperatur gerührt. Die Mischung wird mit einem Äquivalent 1,5-Cycloocta-dien-platin(II)-dichlorid versetzt und 16 Stunden unter Rückfluß gerührt. Nach Abkühlung auf Raumtemperatur wird die Mischung zur Trockne eingeengt. Der Rückstand wird in Dimethylformamid aufgenommen und mit 4 Äquivalenten 2,4-Pentandion und 4 Äquivalenten Kalium-tert-butylat versetzt. Die Mischung wird 16 Stunden bei Raumtemperatur und 6 h bei 100°C gerührt. Nach Abkühlung auf Raumtemperatur wird zur Trockne eingeengt und der Rückstand mit Wasser gewaschen. Man erhielt das Produkt als gelbliches Pulver nach säulenchromato-graphischer Aufreinigung in einer Ausbeute von 53% der Theorie.

¹H-NMR (d₆-DMSO, 400 MHz): δ = 1,97 (s, 3H), 2,04 (s, 3H), 4,01 (s, 3H), 5,64 (s, 1H), 7,45 (d, J 2,0, 1 H), 7,48 (s, 1 H), 7,51 (d, J 1,5, 1 H), 7,78 (d, J 1,5, 1 H), 8,06 (d, J 2,0, 1 H).

CI-MS (MeCN/H₂O 8:2): m/z = 476 (M+H⁺, korrektes Isotopenmuster).

### Beispiel 15: Herstellung von Tris-[1-(4'-cyanophenyl)-3-methylimidazol-2-yliden-C²,C^{2'}]-rhodium(III)

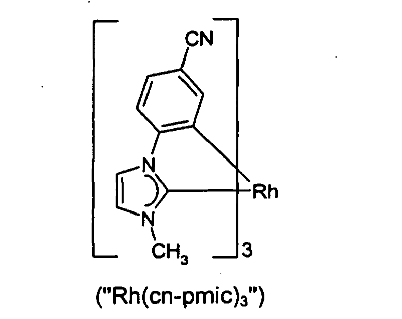

6,31 g (20,3 mmol) des Imidazoliumiodids (hergestellt gemäß Beispiel 1 b)) werden in 100 ml Toluol vorgelegt. Bei Raumtemperatur werden innerhalb von 30 Minuten 40,6 ml Kalium-bis(trimethylsilyl)amid (0,5 M in Toluol, 20,3 mmol) zugesetzt und der Ansatz eine Stunde gerührt. 1,00 g (2,0 mmol) [(µ-Cl)Rh(η⁴-1,5-cod)]₂ werden in 50 ml Toluol gelöst und bei Raumtemperatur innerhalb von 30 Minuten tropfenweise mit der Salzmischung versetzt. Die Reaktionsmischung wird eine Stunde bei Raumtemperatur, zwei Stunden bei 70°C und dann über Nacht unter Rückfluß gerührt. Der Ansatz wird bis zur Trockne eingeengt. Man extrahiert den Rückstand mit Methylenchlorid und reinigt den Extrakt säulenchromatographisch. Es werden 0,26 g eines schwachgelben Pulvers erhalten (10 %).

¹H-NMR: (CD₂Cl₂, 500 MHz): δ = 7,56 (d, J = 1,9 Hz, 1H), 7,55 (d, J = 2,0 Hz, 1H), 7,49 (d, J = 1,9 Hz, 1H), 7,27-7,11 (m, 6H), 6,97, 6,93 (je s, 1H), 6,89 (d, J = 1,8 Hz, 1H), 6,86 (d, J = 1,7 Hz, 2H), 6,71 (s, 1 H), 3,03 (s, 6H, CH₃), 2,96 (s, 3H, CH₃). ¹³C-NMR (CD₂Cl₂, 125 MHz): δ = 190,3 (d, ¹J_{C,Rh} = 38,4 Hz, NCN), 189,5 (d, ¹J_{C,Rh} = 38,1 Hz, NCN) , 188,2 (d, ¹J_{C,Rh} = 38,3 Hz, NCN), 166,7 (d, ¹J_{C,Rh} = 27,5 Hz, C_{q}), 166,0 (d, ¹J_{C,Rh} = 24,5 Hz, C_{q}), 164,5 (d, ¹J_{C,Rh} = 24,4 Hz, C_{q}), 150,5, 150,0, 149,3 (Cq), 142,4, 142,2, 140,4, 126,5, 126,4, 126,3, 123,0, 122,8, 122,5, 114,72, 114,68, 114,6, 110,9, 110,7, 110,4 (CH_{Ph}, NCHCHN), 120,9 (doppelte Intensität, C_{q}), 120,8 (C_{q}), 107,6 (d, J = 1,8 Hz, C_{q}), 107,2 (d, J = 1,9 Hz, C_{q}), 107,2 (d, J = 1,6 Hz, C_{q}), 37,3, 37,2, 36,1 (CH₃).

### Beispiel 16: Herstellung von fac-Tris-[1-(4'-cyanophenyl)-3-methylimidazol-2-yliden-C²,C^{2'}]-iridium(III)

Das in Beispiel 1 erhaltene fac/mer-Isomerengemisch lässt sich säulenchromatographisch über Kieselgel mit Essigsäureethylester/Cyclohexan 9:1 oder durch fraktionierte Fällung aus Acetonitril in die fac- und mer-Isomeren trennen. Man beobachtet hierbei üblicherweise ein fac/mer-Isomerenverhältnis von ca. 1:19.

Eine Lösung des reinen mer-Tris-[1-(4'-cyanophenyl)-3-methylimidazolyliden-C²,C^{2'}]-iridium(III) (20 mg, 27 µmol) in Aceton (9,75 ml) wird bei Raumtemperatur mit 0,1 M Salzsäure (0,25 ml) versetzt. Die Mischung wird 4 Stunden unter Rückfluß gerührt. Anschließend werden die flüchtigen Komponenten am Rotationsverdampfer entfernt und man erhält ein Isomerengemisch mit einem fac/mer-Isomerenverhältnis von ca. 3:1, das wie wie zuvor beschrieben getrennt werden kann.

### Analytik fac-Isomer:

¹H-NMR (d₆-DMSO/CD₂Cl₂ 4:1, 500 MHz): δ = 3,06 (s, 9H), 6,66 (d, J 2,0, 3H), 7,11 (d, J 2,0, 3H), 7,28 (dd, J 8,0, 2,0, 3H), 7,49 (d, J 8,0, 3H), 7,87 (d, J 2,0, 3H).

¹³C-NMR (d₆-DMSO/CD₂Cl₂ 4:1, 500 MHz): δ = 36,2, 107,0, 111,1, 115,5, 120,7, 122,4, 125,9, 139,7, 149,2, 151,5, 174,6.

ESI-MS (MeCN/H₂O 8:2): m/z = 737,1751 (M⁺, korrektes Isotopenmuster, ber.: 737,1755), 755 (M+NH₄⁺, korrektes Isotopenmuster).

### Beispiel 17: Herstellung eines OLED

Das als Anode verwendete ITO-Substrat wird zuerst mit kommerziellen Reinigungsmitteln für die LCD-Produktion (Deconex® 20NS und Neutralisationsmittel 25ORGAN-ACID®) und anschließend in einem Aceton/Isopropanol-Gemisch im Ultraschallbad gesäubert. Zur Beseitigung möglicher organischer Rückstände wird das Substrat in einem Ozonofen weitere 25 Minuten einem kontinuierlichen Ozonfluss ausgesetzt. Diese Behandlung verbessert auch die Lochinjektion des ITOs.

Danach werden die nachfolgend genannten organischen Materialien mit einer Rate von ca. 2 nm/Minuten bei etwa 10-7 mbar auf das gereinigte Substrat aufgedampft. Als Lochleiter und Exciton-Blocker wird zuerst die Verbindung V1 in einer Schichtdicke von 30 nm auf das Substrat aufgebracht.

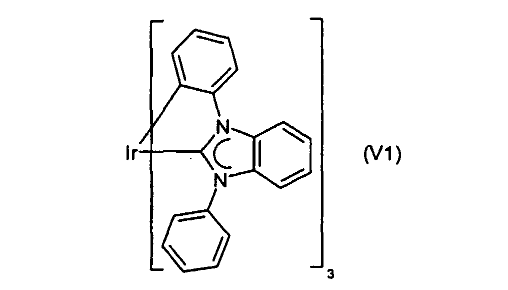

Anschließend wird eine Mischung aus 30 Gew.-% der Verbindung Ir(cn-pmbic)₃ aus Beispiel 3 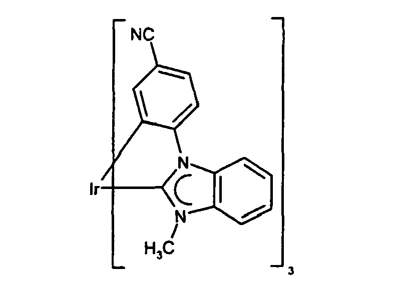 und 70 Gew.-% der Verbindung V3 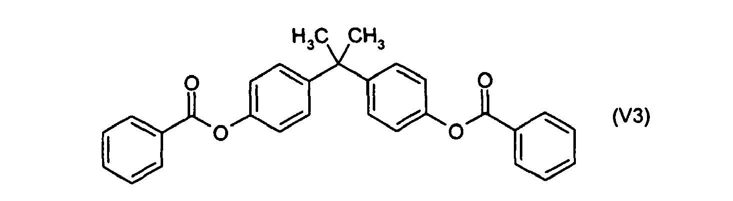 (die Herstellung von V3 erfolgt nach dem Fachmann allgemein bekannten Methoden der Estersynthese; vgl. hierzu auch die ältere deutsche Patentanmeldung 10 2005 014284.2) in einer Dicke von 20 nm aufgedampft, wobei Ir(cn-pmbic)₃ als Emitter und V3 als Matrixmaterial fungiert Danach wird eine Lochblockerschicht aus V2 in einer Dicke von 4 nm aufgedampft.

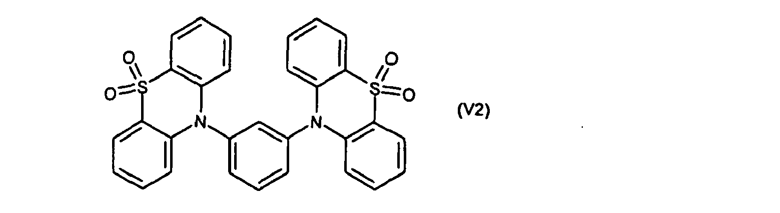

Danach wird eine Elektronenleiterschicht aus TPBI [2,2',2"-(1,3,5-Benzoltriyl)-tris-(1-phenylbenzimidazol)] in einer Dicke von 30 nm, eine 1 nm dicke Lithiumfluorid-Schicht und abschliessend eine 110 nm dicke Al-Elektrode aufgedampft.

Zur Charakterisierung des OLEDs werden Elektrolumineszenz-Spektren bei verschiedenen Strömen bzw. Spannungen aufgenommen. Weiterhin wird die Strom-Spannungs-Kennlinie in Kombination mit der abgestrahlten Lichtleistung gemessen. Die Lichtleistung kann durch Kalibration mit einem Luminanzmeter in photometrische Größen umgerechnet werden.

Für das beschriebene OLED ergeben sich die folgenden elektrooptischen Daten:

| | |
|---|---|
| Emissionsmaximum | 460 nm |
| CIE(x, y) | 0,150; 0,126 |
| Photometrischer Wirkungsgrad | 11,2 cd/A (bei 4V) |
| Leistungseffizienz | 9,0 lm/W |
| Externe Quantenausbeute | 10,5 % |
| Maximale Leuchtdichte | 900 cd/m² |

**Photolumineszenz ("PL") der Iridium-Carbenkomplexe**

| Komplex | PL in Toluol | | | | PL in Polymethacrylat("PMMA")-Film | | | | PL in Pulver | |
|---|---|---|---|---|---|---|---|---|---|---|
| | λₑₘ* [nm] | QA** [%] | CIE x | CIE y | λₑₘ* [nm] | QA** [%] | CIE x | CIE y | CIE x | CIE y |
| Ir(pibic)₃ | 398 | 1 | 0,161 | 0,080 | - | - | - | - | 0,160 | 0,059 |
| Ir(cn-pibic)₃ | 382-454 | 7 | 0,151 | 0,095 | 454 | 70 | 0,150 | 0,096 | - | - |
| Ir(psmbic)₃ | 472 | <1 | 0,251 | 0,270 | 472 | 4 | 0,160 | 0,199 | 0,266 | 0,248 |
| Ir(cl-pmic)₃ | 407 | 4 | 0,164 | 0,062 | 393, 460 | 2 | 0,180 | 0,149 | 0,195 | 0,212 |
| Ir(^{t}bu-cn-pmic)₃ | 431-455 | 26 | 0,149 | 0,099 | 458 | 55 | 0,149 | 0,105 | - | - |
| fac-Ir(cn-pmic)₃ | 470 | 8 | 0,174 | 0,234 | 452 | 73 | 0,150 | 0,092 | 0,277 | 0,437 |
| Ir(me₂-cn-pmic)₃ | - | - | - | - | 464 | 67 | 0,149 | 0,141 | 0,279 | 0,382 |
| Ir(cn-pmbic)₃ | - | - | - | - | 454 | 78 | 0,150 | 0,095 | 0,220 | 0,262 |
| Ir(pymic)₃ | 403 | 7 | 0,165 | 0,073 | 478 | - | 0,182 | 0,271 | 0,564 | 0,410 |
| Ir(btmbic)₃ | - | - | - | - | 493, 527, 557 | - | 0,318 | 0,547 | - | - |
| Ir(pombic)₃ | 408, 433, 458 | - | 0,195 | 0,138 | 407, 433, 457 | 10 | 0,156 | 0,082 | 0,440 | 0,441 |

| | | | | | | | | | | |
|---|---|---|---|---|---|---|---|---|---|---|
| * Wellenlänge(n) λₑₘ des Emissionsmaximums bzw. der Emissionsmaxima ** Quantenausbeute. | | | | | | | | | | |

Die PL-Messungen in Toluol wurden mit einer Emitterkonzentration von 2 mg/l in Quarzküvetten (10x10 mm) durchgeführt. Die Anregungswellenlänge betrug 325 nm (HeCd-Laser) und die Detektion der Emission erfolgte im 90 Grad Winkel mittels Faseroptik in einem Diodenarrayspektrometer.

Die PL-Messungen in PMMA wurden mit einer Emitterdotierung von 2 % durchgeführt. Diese wurden hergestellt wie folgt: 2 mg/l Emitter wurden in einer 10 %igen PMMA-Lösung in Dichlormethan (Mw 120kD) gelöst und auf einen Objektträger mit 60 µm Rakel aufgerakelt. Die Anregungswellenlänge betrug 325 nm (HeCd-Laser), die Anregung erfolgte senkrecht zum Objektträger und die Detektion der Emission im 45 Grad Winkel mittels Faseroptik im Diodenarrayspektrometer.

Für das beschriebene OLED ergeben sich die folgenden elektrooptischen Daten:

| | |
|---|---|
| Emissionsmaximum | 476 nm |
| CIE(x, y) | 0,21; 0,30 |
| Photometrischer Wirkungsgrad | 10,0 cd/A |
| Leistungseffizienz | 11,6 Im/W |
| Externe Quantenausbeute | 5,0 % |
| Photometrischer Wirkungsgrad bei einer Leuchtdichte von 100 cd/m² | 4,0 cd/A |
| Maximale Leuchtdichte | 3500 cd/m² |

### c)

Das ITO-Substrat wird wie unter a) beschrieben vorbehandelt.

Anschließend wird PEDT:PSS (Poly(3,4-ethylendioxythiophen)-Poly(styrolsulfonat)) (Baytron^{®} P VP Al 4083) aus wässriger Lösung auf das Substrat in einer Dicke von 46 nm aufgeschleudert und die Emitterschicht aus in Chlorbenzol gelöstem PMMA (16,5 mg PMMA auf 1 ml Chlorbenzol) und der Emittersubstanz 1 c) in einer Dicke von ca. 48 nm aufgebracht. Die Konzentration des Emitters entspricht dabei einer 30 Gew.-%igen Dotierung von PMMA. Danach wird eine Lochblocker- und Elektronenleiterschicht aus BCP in einer Dicke von 52,5 nm, eine 0,75 nm dicke Lithiumfluorid-Schicht und abschließend eine 110 nm dicke Al-Elektrode aufgedampft.

Zur Charakterisierung des OLEDs werden Elektrolumineszenz-Spektren bei verschiedenen Strömen bzw. Spannungen aufgenommen. Weiterhin wird die Strom-Spannungs-Kennlinie in Kombination mit der abgestrahlten Lichtleistung gemessen. Die Lichtleistung kann durch Kalibration mit einem Luminanzmeter in photometrische Größen umgerechnet werden.

Für das beschriebene OLED ergeben sich die folgenden elektrooptischen Daten:

| | |
|---|---|
| Emissionsmaximum | 460 nm |
| Photometrischer Wirkungsgrad | 4,3 cd/A |
| Leistungseffzienz | 1,1 lm/W |
| Externe Quantenausbeute | 3,5 % |
| Photometrischer Wirkungsgrad bei einer Leuchtdichte von 100 cd/m² | 1,2 cd/A |
| Maximale Leuchtdichte | 150 cd/m² |

## Patentansprüche

1. Verwendung von neutralen Übergangsmetall-Carbenkomplexen der allgemeinen Formel I 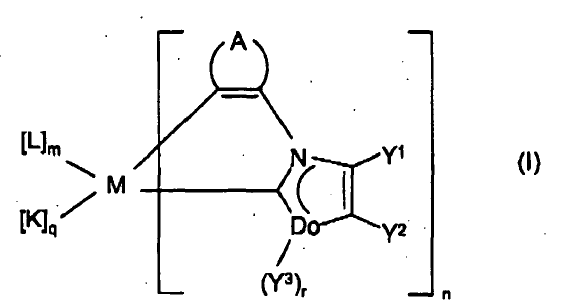 in organischen Licht-emittierenden Dioden, wobei die Variablen die folgenden Bedeutungen aufweisen:
M Metallatom ausgewählt aus der Gruppe bestehend aus Co, Rh, Ir, Nb, Pd, Pt, Fe, Ru, Os, Cr, Mo, W, Mn, Re, Cu, Ag und Au in jeder für das entsprechende Metallatom möglichen Oxidationsstufe;
L mono- oder dianionischer Ligand, der mono- oder bidentat sein kann;
K neutraler mono- oder bidentater Ligand ausgewählt aus der Gruppe bestehend aus Phosphinen; Phosphonaten und Derivaten davon, Arsenaten und Derivaten davon; Phosphiten; CC; Pyridinen; Nitrilen, Monoolefinen und konjugierten Dienen, die einen π-Komplex mit M bilden;
n Zahl der Carbenliganden, wobei n mindestens 1 ist und die Carbenliganden in dem Komplex der Formel I bei n >1 gleich oder verschieden sein können;
m Zahl der Liganden L, wobei m 0 oder ≥ 1 sein kann und die Liganden L bei m > 1 gleich oder verschieden sein können;
q Zahl der Liganden K, wobei q 0 oder ≥ 1 sein kann und die Liganden K bei q > 1 gleich oder verschieden sein können,
wobei die Summe n + m + q von der Oxidationsstufe und Koordinationszahl des eingesetzten Metallatoms und von der Zähnigkeit sowie der Ladung der Liganden abhängig ist, mit der Bedingung, dass n mindestens 1 ist;
Do Donoratom ausgewählt aus der Gruppe bestehend aus N, O und S;
r gleich 1, wenn Do N ist, und 0, wenn Do O oder S ist;
Y¹, Y² jeweils unabhängig voneinander Wasserstoff, Alkyl, Aryl, Heteroaryl oder Alkenyl;
oder
Y¹ und Y² bilden zusammen mit den Kohlenstoffatomen, an welche sie gebunden sind, einen sechsgliedrigen aromatischen Ring, welcher ein oder zwei Stickstoffatome enthalten kann, und gegebenenfalls mit einem weiteren, gegebenenfalls anellierten und gegebenenfalls Heteroatome enthaltenden Ring anelliert ist;
Y³ Wasserstoff oder Alkyl;
oder
Y³ und Y² bilden zusammen mit dem Donoratom Do und dem Kohlenstoffatom, an welches Y² gebunden ist, einen fünf- oder sechsgliedrigen Ring, welcher außen dem Donoratom Do noch ein weiteres Heteroatom ausgewählt aus der Gruppe bestehend aus N, O und S enthalten kann;
A eine Brücke mit drei oder vier Atomen, wovon ein oder zwei Atome Heteroatome sein können und die restlichen Atome Kohienstoffatome sind, so dass die Gruppe 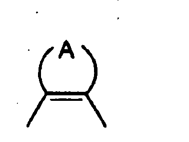 einen fünf- oder sechsgliedrigen heteroaromatischen Ring oder Benzolring bildet, der gegebenenfalls mit Substituenten ausgewählt aus der Gruppe bestehend aus Alkyl, Alkyloxy, Alkylthio, Aryl, Aryloxy, Arylthio, Halogen, CN, CHO, Alkylcarbonyl, Arylcarbonyl, Carboxyl, Alkyloxycarbonyl, Aryloxycarbonyl, Hydroxysulfonyl, Alkyloxysulfonyl, Aryloxysulfonyl, NO₂ und NO substituiert und gegebenenfalls mit einem weiteren, gegebenenfalls anellierten und gegebenenfalls Heteroatome enthaltenden Ring anelliert ist,
wobei gegebenenfalls Y¹ zusammen mit einer Gruppe ausgewählt aus chemischer Einfachbindung, C(Y⁴)₂, C(O), O, S, S(O), SO₂ und NY⁵ eine zweigliedrige Brücke B zu demjenigen Kohlenstoff- oder Heteroatom der Brücke A ausbildet, welches α-ständig zum Kohlenstoffatom steht, das an das N-Atom der Carbeneinheit des Carbenliganden gebunden ist;
Y⁴, Y⁵ jeweils unabhängig voneinander Wasserstoff, Alkyl, Aryl oder Heteroaryl, wobei die beiden Y⁴ in der Brücke C(Y⁴)₂ unabhängig voneinander variiert werden können.

2. Verwendung von Komplexen der Formel I nach Anspruch 1, **dadurch gekennzeichnet, dass**
M ausgewählt ist aus der Gruppe bestehend aus Rh, Ir, Pd, Pt, Ru und Os in jeder für das entsprechende Metallatom möglichen Oxidationsstufe;
und die übrigen Variablen die in Anspruch 1 aufgeführte Bedeutung besitzen.

3. Verwendung von Komplexen der Formel I nach Anspruch 1 oder 2, **dadurch gekennzeichnet, dass**
n mindestens 2 ist und die Carbenliganden gleich oder verschieden sein können;
m 0 oder ≥ 1 ist und die Liganden L bei m > 1 gleich oder verschieden sein können;
q 0 oder ≥ 1 ist und die Liganden K bei q > 1 gleich oder verschieden sein können;
wobei die von n, m und q verschiedenen Variablen die in Anspruch 1 oder 2 aufgeführte Bedeutung besitzen.

4. Verwendung von Komplexen der Formel I nach Anspruch 1 oder 2, **dadurch gekennzeichnet, dass**
n mindestens 2 ist und die Carbenliganden gleich oder verschieden sein können;
m, q jeweils 0 sind;
wobei die von n, m und q verschiedenen Variablen die in Anspruch 1 oder 2 aufgeführte Bedeutung besitzen.

5. Verwendung von Komplexen der Formel I nach Anspruch 1 oder 2, **dadurch gekennzeichnet, dass**
n mindestens 2 ist und die Carbenliganden gleich sind;
m, q jeweils 0 sind;
wobei die von n, m und q verschiedenen Variablen die in Anspruch 1 oder 2 aufgeführte Bedeutung besitzen.

6. OLED enthaltend mindestens einen Übergangsmetall-Carbenkomplex der Formel I gemäß einem oder mehreren der Ansprüche 1 bis 5.

7. Licht-emittierende Schicht enthaltend mindestens einen Übergangsmetall-Carbenkomplex der Formel I gemäß einem oder mehreren der Ansprüche 1 bis 5.

8. OLED enthaltend eine Licht-emittierende Schicht nach Anspruch 7.

9. Vorrichtung ausgewählt aus der Gruppe bestehend aus stationären Bildschirmen wie Bildschirmen von Computern, Femsehem, Bildschirmen in Druckern, Küchengeräten sowie Reklametafeln, Beleuchtungen, Hinweistafeln und mobilen Bildschirmen wie Bildschirmen in Handys, Laptops, Fahrzeugen sowie Zielanzeigen an Bussen und Bahnen enthaltend ein OLED gemäß Anspruch 6 oder 8.

## Claims

1. The use of uncharged transition metal-carbene complexes of the general formula I 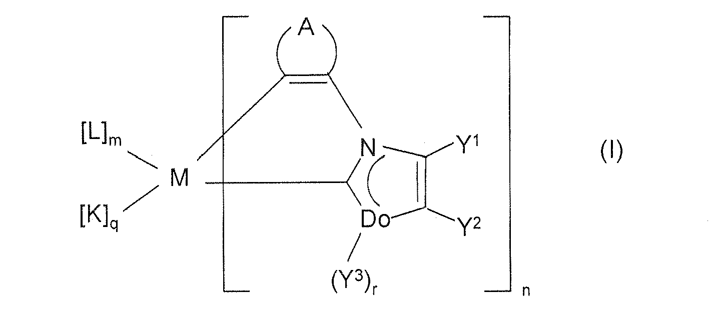 in organic light-emitting diodes, where the variables are each defined as follows:
M is a metal atom selected from the group consisting of Co, Rh, Ir, Nb, Pd, Pt, Fe, Ru, Os, Cr, Mo, W, Mn, Re, Cu, Ag and Au in any oxidation state possible for the particular metal atom;
L is a mono- or dianionic ligand which may be mono- or bidentate;
K is an uncharged mono- or bidentate ligand selected from the group consisting of phosphines; phosphonates and derivatives thereof, arsenates and derivatives thereof; phosphites; CO; pyridines; nitriles, monoolefins and conjugated dienes which form a π-complexe with M;
n is the number of carbene ligands, where n is at least 1 and the carbene ligands in the complex of the formula I, when n > 1, may be the same or different;
m is the number of ligands L, where m may be 0 or ≥ 1 and the ligands L, when m > 1, may be the same or different;
q is the number of ligands K, where q may be 0 or ≥ 1 and the ligands K, when q > 1, may be the same or different,
where the sum of n + m + q depends upon the oxidation state and coordination number of the metal atom used and upon the denticity and the charge of the ligands, with the condition that n is at least 1;
Do is a donor atom selected from the group consisting of N, O and S;
r is 1 when Do is N and 0 when Do is O or S;
Y¹, Y² are each independently hydrogen, alkyl, aryl, heteroaryl or alkenyl;
or
Y¹ and Y², together with the carbon atoms to which they are bonded, form a six-membered aromatic ring which may comprise one or two nitrogen atoms, and is optionally fused to a further ring which is optionally fused and optionally comprises heteroatoms;
Y³ is hydrogen or alkyl;
or
Y³ and Y², together with the donor atom Do and the carbon atom to which Y² is bonded, form a five- or six-membered ring which, apart from the donor atom Do, may also comprise a further heteroatom selected from the group consisting of N, O and S;
A is a bridge having three or four atoms, of which one or two atoms may be heteroatoms and the remaining atoms are carbon atoms, so that the group 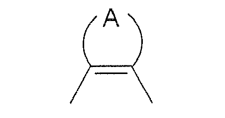 forms a five- or six-membered heteroaromatic ring or benzene ring, each of which is optionally substituted by substituents selected from the group consisting of alkyl, alkyloxy, alkylthio, aryl, aryloxy, arylthio, halogen, CN, CHO, alkylcarbonyl, arylcarbonyl, carboxyl, alkyloxycarbonyl, aryloxycarbonyl, hydroxysulfonyl, alkyloxysulfonyl, aryloxysulfonyl, NO₂ and NO, and optionally fused with a further ring which is optionally fused and optionally comprises heteroatoms,
where Y¹, together with a group selected from chemical single bond, C(Y⁴)₂, C(O), O, S, S(O), SO₂ and NY⁵, may optionally form a two-membered bridge B to that carbon atom or heteroatom of the bridge A which is in the α-position to the carbon atom which is bonded to the nitrogen atom of the carbene unit of the carbene ligand;
Y⁴, Y⁵ are each independently hydrogen, alkyl, aryl or heteroaryl, and the two Y⁴ groups in the C(Y⁴)₂ bridge may be varied independently of one another.

2. The use of complexes of the formula I according to claim 1, wherein
M is selected from the group consisting of Rh, Ir, Pd, Pt, Ru and Os in any oxidation state possible for the particular metal atom;
and the remaining variables are each as defined in claim 1.

3. The use of complexes of the formula I according to claim 1 or 2, wherein
n is at least 2 and the carbene ligands may be the same or different;
m is 0 or ≥ 1 and the ligands L, when m > 1, may be the same or different;
q is 0 or ≥ 1 and the ligands K, when q > 1, may be the same or different;
where the variables other than n, m and q are each as defined in claim 1 or 2.

4. The use of complexes of the formula I according to claim 1 or 2, wherein
n is at least 2 and the carbene ligands may be the same or different;
m, q are each 0;
where the variables other than n, m and q are each as defined in claim 1 or 2.

5. The use of complexes of the formula I according to claim 1 or 2, wherein
n is at least 2 and the carbene ligands are the same;
m, q are each 0;
where the variables other than n, m and q are each as defined in claim 1 or 2.

6. An OLED comprising at least one transition metal-carbene complex of the formula I according to one or more of claims 1 to 5.

7. A light-emitting layer comprising at least one transition metal-carbene complex of the formula I according to one or more of claims 1 to 5.

8. An OLED comprising a light-emitting layer according to claim 7.

9. A device selected from the group consisting of stationary visual display units such as visual display units of computers, televisions, visual display units in printers, kitchen appliances and advertising panels, illuminations, information panels and mobile visual display units such as visual display units in mobile telephones, laptops, vehicles and destination displays in buses and trains, comprising an OLED according to claim 6 or 8.

## Revendications

1. Utilisation de complexes carbéniques de métaux de transition de formule générale I 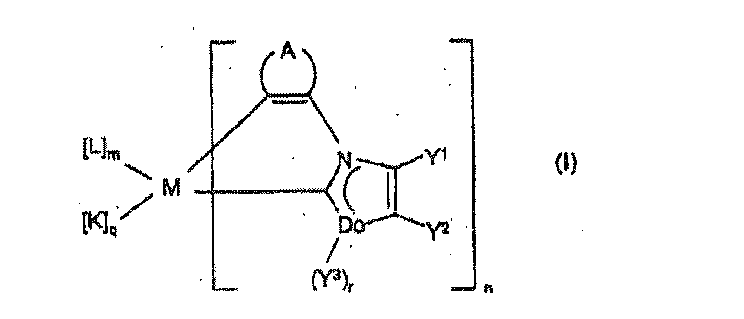 dans des diodes électroluminescentes organiques, les variables ayant les significations suivantes :
M un atome de métal choisi dans le groupe constitué par Co, Rh, Ir, Nb, Pd, Pt, Fe, Ru, Os, Cr, Mo, W, Mn, Re, Cu, Ag et Au, à chaque degré d'oxydation possible pour l'atome de métal correspondant ;
L un ligand mono- ou dianionique, qui peut être mono- ou bidentate ;
K un ligand neutre mono- ou bidentate choisi dans le groupe constitué par les phosphines ; les phosphonates et leurs dérivés, les arsenates et leurs dérivés ; les phosphites ; CO ; les pyridines ; les nitriles, les monooléfines et les diènes conjugués, qui forment un complexe π avec M ;
n le nombre de ligands carbéniques, n valant au moins 1 et les ligands carbéniques dans le complexe de formule I pouvant être identiques ou différents lorsque n > 1 ;
m le nombre de ligands L, m pouvant valoir 0 ou ≥ 1 et les ligands L pouvant être identiques ou différents lorsque m > 1 ;
q le nombre de ligands K, q pouvant valoir 0 ou ≥ 1 et les ligands K pouvant être identiques ou différents lorsque q > 1 ;
la somme n + m + q dépendant du degré d'oxydation et de l'indice de coordination de l'atome de métal utilisé et de la denticité et de la charge des ligands, à condition que n vaille au moins 1 ;
Do un atome donneur choisi dans le groupe constitué par N, 0 et S ;
r vaut 1 lorsque Do représente N et 0 lorsque Do représente O ou S ;
Y¹, Y² à chaque fois indépendamment l'un de l'autre, hydrogène, alkyle, aryle, hétéroaryle ou alcényle ;
ou
Y¹ et Y² forment ensemble avec les atomes de carbone auxquels ils sont reliés un cycle aromatique à six éléments, qui peut contenir un ou deux atomes d'azote et qui est éventuellement condensé avec un cycle supplémentaire, éventuellement condensé et contenant éventuellement des hétéroatomes ;
Y³ hydrogène ou alkyle ;
ou
Y³ et Y² forment ensemble avec l'atome donneur Do et l'atome de carbone auquel Y² est relié un cycle à cinq ou six éléments qui peut contenir, outre l'atome donneur Do, un hétéroatome supplémentaire choisi dans le groupe constitué par N, O et S ;
A un pont contenant trois ou quatre atomes, parmi lesquels un ou deux atomes peuvent être des hétéroatomes et les atomes restants sont des atomes de carbone, de manière à ce que le groupe 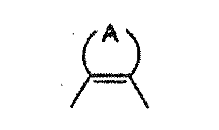 forme un cycle hétéroaromatique à cinq ou six éléments ou un cycle benzène qui est éventuellement substitué avec des substituants choisis dans le groupe constitué par alkyle, alkyloxy, alkylthio, aryle, aryloxy, arylthio, halogène, CN, CHO, alkylcarbonyle, arylcarbonyle, carboxyle, alkyloxycarbonyle, aryloxycarbonyle, hydroxysulfonyle, alkyloxysulfonyle, aryloxysulfonyle, NO₂ et NO, et éventuellement condensé avec un cycle supplémentaire, éventuellement condensé et contenant éventuellement des hétéroatomes,
Y¹ formant éventuellement avec un groupe choisi parmi une liaison chimique simple, C(Y⁴)₂, C(O), O, S, S(O), SO₂ et NY⁵ un pont B à deux éléments vers un atome de carbone ou un hétéroatome du pont A qui est en position α par rapport à l'atome de carbone qui est relié à l'atome N de l'unité carbénique du ligand carbénique ;
Y⁴, Y⁵ à chaque fois indépendamment l'un de l'autre, hydrogène, alkyle, aryle ou hétéroaryle, les deux Y⁴ du le pont C(Y⁴)₂ pouvant être variés indépendamment l'un de l'autre.

2. Utilisation de complexes de formule I selon la revendication 1, **caractérisée en ce que**
M est choisi dans le groupe constitué par Rh, Ir, Pd, Pt, Ru et Os, à chaque degré d'oxydation possible pour l'atome de métal correspondant ;
et les autres variables ont la signification donnée dans la revendication 1.

3. Utilisation de complexes de formule I selon la revendication 1 ou 2, **caractérisée en ce que**
n vaut au moins 2 et les ligands carbéniques peuvent être identiques ou différents ;
m vaut 0 ou ≥ 1 et les ligands L peuvent être identiques ou différents lorsque m > 1 ;
q vaut 0 ou ≥ 1 et les ligands K peuvent être identiques ou différents lorsque q > 1 ;
les variables différentes de n, m et q ayant la signification donnée dans la revendication 1 ou 2.

4. Utilisation de complexes de formule I selon la revendication 1 ou 2, **caractérisée en ce que**
n vaut au moins 2 et les ligands carbéniques peuvent être identiques ou différents ;
m, q valent à chaque fois 0 ;
les variables différentes de n, m et q ayant la signification donnée dans la revendication 1 ou 2.

5. Utilisation de complexes de formule I selon la revendication 1 ou 2, **caractérisée en ce que**
n vaut au moins 2 et les ligands carbéniques sont identiques ;
m, q valent à chaque fois 0 ;
les variables différentes de n, m et q ayant la signification donnée dans la revendication 1 ou 2.

6. OLED contenant au moins un complexe carbénique de métal de transition de formule I selon une ou plusieurs des revendications 1 à 5.

7. Couche électroluminescente contenant au moins un complexe carbénique de métal de transition de formule I selon une ou plusieurs des revendications 1 à 5.

8. OLED contenant une couche électroluminescente selon la revendication 7.

9. Dispositif choisi dans le groupe constitué par les écrans stationnaires tels que les écrans d'ordinateurs, de télévision, les écrans d'imprimantes, les équipements de cuisine, ainsi que les panneaux publicitaires, les éclairages, les tableaux indicateurs et les écrans mobiles tels que les écrans de téléphones portables, d'ordinateurs portables, de véhicules, ainsi que les indicateurs de destination dans les bus et les trains, contenant une OLED selon la revendication 6 ou 8.
